# EUROPEAN PATENT APPLICATION

(11) **EP 4 598 295 A1**
(43) Date of publication of application: **06.08.2025**
(21) Application number: 24215062.1
(22) Date of filing: 25.11.2024
(51) Int. Cl.: H10B 12/00, H10D 1/68

(54) **SEMICONDUCTOR MEMORY DEVICE**

(30) Priority: 30.01.2024 KR 20240014353
(71) Applicant: Samsung Electronics Co., Ltd., Suwon-si, Gyeonggi-do 16677 (KR)
(72) Inventor: PARK, Keonhee, 16677 Suwon-si, Gyeonggi-do (KR)
(74) Representative: Kuhnen & Wacker Patent- und Rechtsanwaltsbüro PartG mbB

(57) **Abstract**

A semiconductor memory device includes a memory cell array (M1) including memory cells on a main surface (102M) of a substrate (102), wherein each of the memory cells includes a word line extending in a first direction, first and second bit lines (BL) parallel to each other and extending in a second direction perpendicular to the first direction, first and second transistors (TR) sharing the word line (WL), and a capacitor (CAP) including an inner electrode (CE1) connected to the first transistor, an outer electrode (CE2) connected to the second transistor, and a dielectric film (DE) between the inner electrode (CE1) and the outer electrode (CE2), and wherein each of the first and second transistors includes an active region (110) that includes a channel region (CH), a first contact region (CT1) extending from the channel region (CH) toward the capacitor (CAP), and a second contact region (CT2) connected to one of the first and second bit lines (BL).

## Description

### BACKGROUND

The inventive concept relates to a semiconductor memory device, and more particularly, to a semiconductor memory device including a plurality of memory cells that are 3-dimensionally arranged.

Due to the advancement of electronics technology, semiconductor devices have been rapidly down-scaled in recent years. Therefore, memory cells are required to be miniaturized, and thus, existing memory cells have limits in undergoing higher integration and securing the reliability thereof. Therefore, it is necessary to develop a semiconductor memory device having a structure that facilitates miniaturization and high integration of memory cells.

### SUMMARY

The inventive concept provides a semiconductor memory device having a structure that facilitates miniaturization and high integration of memory cells.

According to an aspect of the inventive concept, there is provided a semiconductor memory device including a memory cell array having a 3-dimensional structure and including a plurality of memory cells that are repeatedly arranged on a main surface of a substrate and in a horizontal direction parallel to the main surface of the substrate and a vertical direction perpendicular to the main surface of the substrate, wherein each of the plurality of memory cells includes a word line extending lengthwise in a first direction corresponding to one of the horizontal direction and the vertical direction, a first bit line and a second bit line, which are parallel to each other and extend lengthwise in a second direction corresponding to the other one of the horizontal direction and the vertical direction, a first transistor and a second transistor, which share the word line, and a capacitor including an inner electrode connected to the first transistor, an outer electrode connected to the second transistor, and a dielectric film between the inner electrode and the outer electrode, and wherein each of the first transistor and the second transistor includes an active region, the active region including a channel region facing the word line, a first contact region extending from one side of the channel region toward the capacitor, and a second contact region connected from another side of the channel region to a corresponding one of the first bit line and the second bit line.

According to another aspect of the inventive concept, there is provided a semiconductor memory device including a memory cell array having a 3-dimensional structure and including a plurality of memory cells that are repeatedly arranged on a main surface of a substrate and in a horizontal direction parallel to the main surface of the substrate and a vertical direction perpendicular to the main surface of the substrate, wherein the memory cell array includes a plurality of word lines parallel to each other and extending lengthwise in a first direction corresponding to one of the horizontal direction and the vertical direction, a plurality of bit lines parallel to each other and extending lengthwise in a second direction corresponding to the other one of the horizontal direction and the vertical direction, a plurality of capacitors apart from the plurality of bit lines with the plurality of word lines therebetween, and a plurality of active regions each including a channel region facing one word line selected from the plurality of word lines, a first contact region connected between the channel region and one capacitor selected from the plurality of capacitors, and a second contact region connected between the channel region and one bit line selected from the plurality of bit lines, each of the plurality of memory cells includes two bit lines selected from the plurality of bit lines, one word line selected from the plurality of word lines, two active regions selected from the plurality of active regions, and one capacitor selected from the plurality of capacitors, and the one capacitor of each of the plurality of memory cells includes an inner electrode connected to a first active region selected from the two active regions, an outer electrode connected to a second active region selected from the two active regions, and a dielectric film between the inner electrode and the outer electrode.

According to another aspect of the inventive concept, there is provided a semiconductor memory device including a pair of memory cell groups each including a plurality of memory cells repeatedly arranged in a vertical direction that is perpendicular to a main surface of a substrate, the pair of memory cell groups being adjacent to each other in a first horizontal direction that is parallel to the main surface of the substrate, wherein the pair of memory cell groups respectively have mirror-symmetric shapes to each other about an imaginary straight line extending in a second horizontal direction that is orthogonal to the first horizontal direction and parallel to the main surface of the substrate, each of the plurality of memory cells includes a word line extending lengthwise in the second horizontal direction, a first bit line and a second bit line, which are parallel to each other and extend lengthwise in the vertical direction, a first transistor and a second transistor, which share the word line, and a capacitor including an inner electrode connected to the first transistor, an outer electrode connected to the second transistor, and a dielectric film between the inner electrode and the outer electrode, each of the first transistor and the second transistor includes an active region, the active region including a channel region facing the word line, a first contact region extending from one side of the channel region toward the capacitor, and a second contact region connected from another side of the channel region to a corresponding one of the first bit line and the second bit line, and each of the plurality of memory cells includes a U-shaped portion including the capacitor and the active region of each of the first transistor and the second transistor.

### BRIEF DESCRIPTION OF THE DRAWINGS

Embodiments will be more clearly understood from the following detailed description taken in conjunction with the accompanying drawings in which:
FIG. 1A is a perspective view of a portion of a semiconductor memory device according to some example embodiments, FIG. 1B is a plan view of a portion of one memory cell in a memory cell array of the semiconductor memory device shown in FIG. 1A, and FIG. 1C is a circuit diagram of one memory cell in the memory cell array of the semiconductor memory device shown in FIG. 1A;
FIG. 2A is a perspective view of a portion of a semiconductor memory device according to some example embodiments, and FIG. 2B is a plan view of a portion of one memory cell in a memory cell array of the semiconductor memory device shown in FIG. 2A;
FIG. 3A is a perspective view of a portion of a semiconductor memory device according to some example embodiments, FIG. 3B is a transverse cross-sectional view of the semiconductor memory device shown in FIG. 3A, and FIG. 3C is a cross-sectional view of the semiconductor memory device, taken along a line X2-X2' of FIGS. 3A and 3B;
FIGS. 4 and 5 are each a perspective view of a portion of a semiconductor memory device according to some example embodiments;
FIG. 6A is a perspective view of a portion of a semiconductor memory device according to some example embodiments, and FIG. 6B is a plan view of a portion of one memory cell in a memory cell array of the semiconductor memory device shown in FIG. 6A;
FIGS. 7A and 7B are each a perspective view of a portion of a semiconductor memory device according to some example embodiments;
FIG. 8A is a perspective view of a portion of a semiconductor memory device according to some example embodiments, and FIG. 8B is a plan view of a portion of one memory cell in a memory cell array of the semiconductor memory device shown in FIG. 8A;
FIGS. 9A and 9B are each a cross-sectional view illustrating a semiconductor memory device according to some example embodiments; and

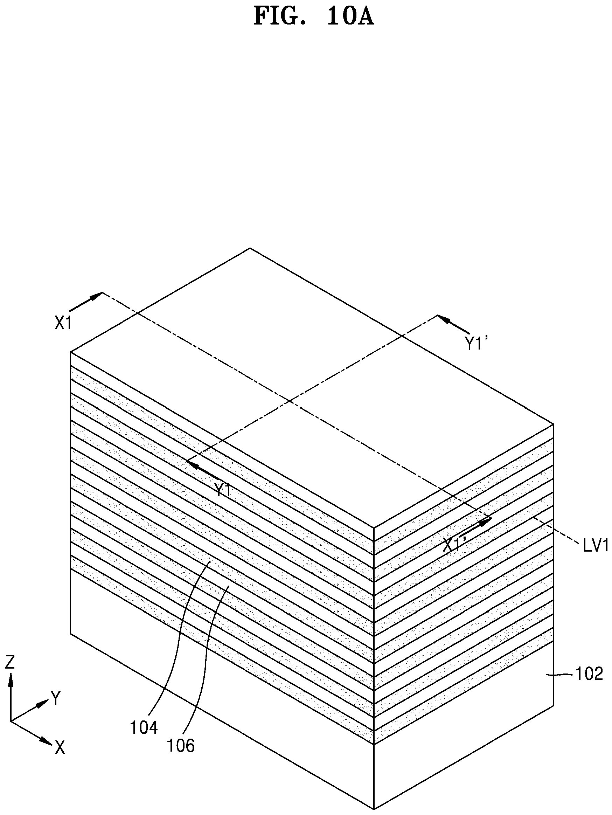

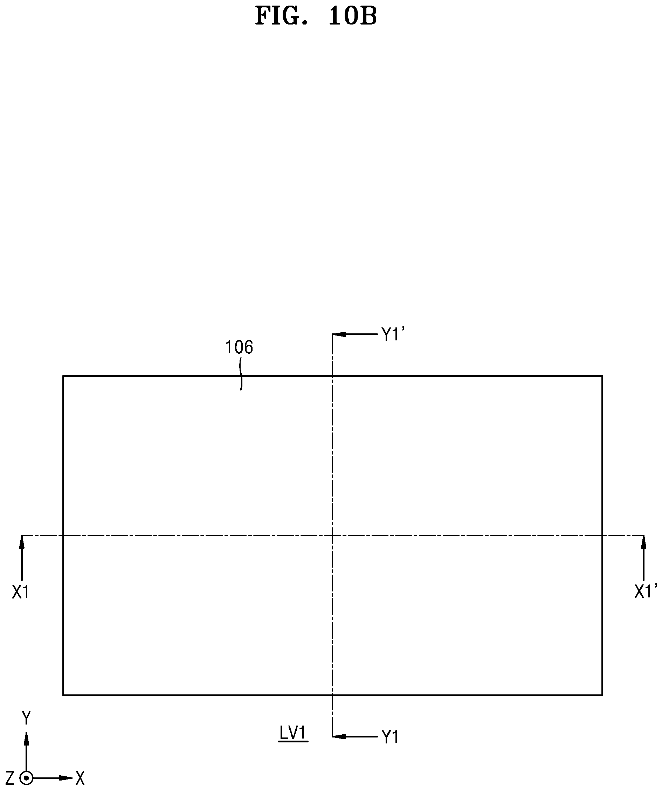

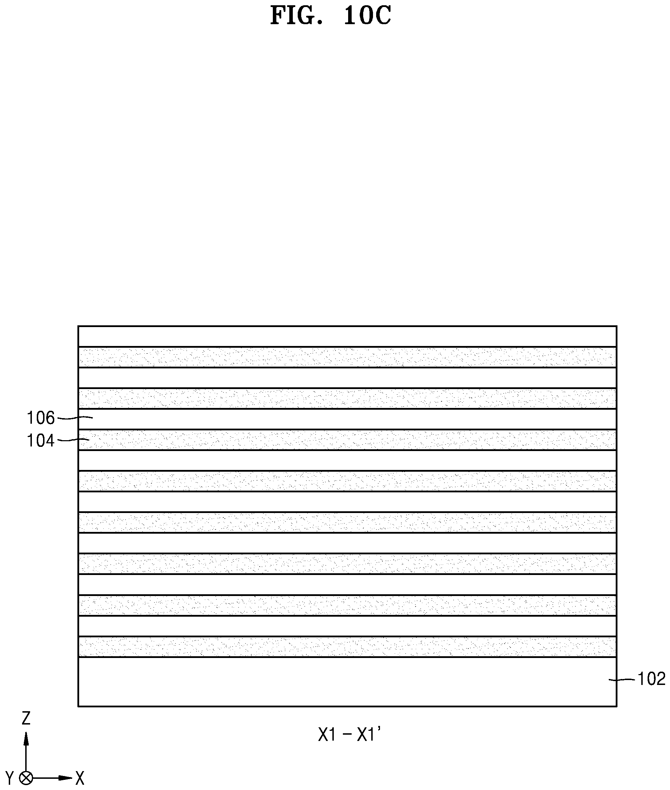

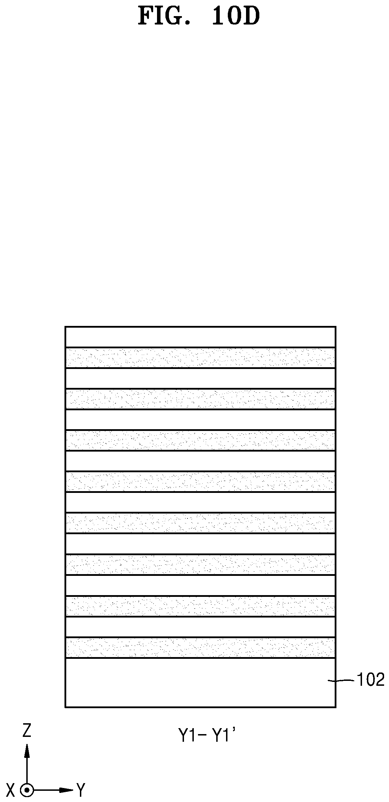

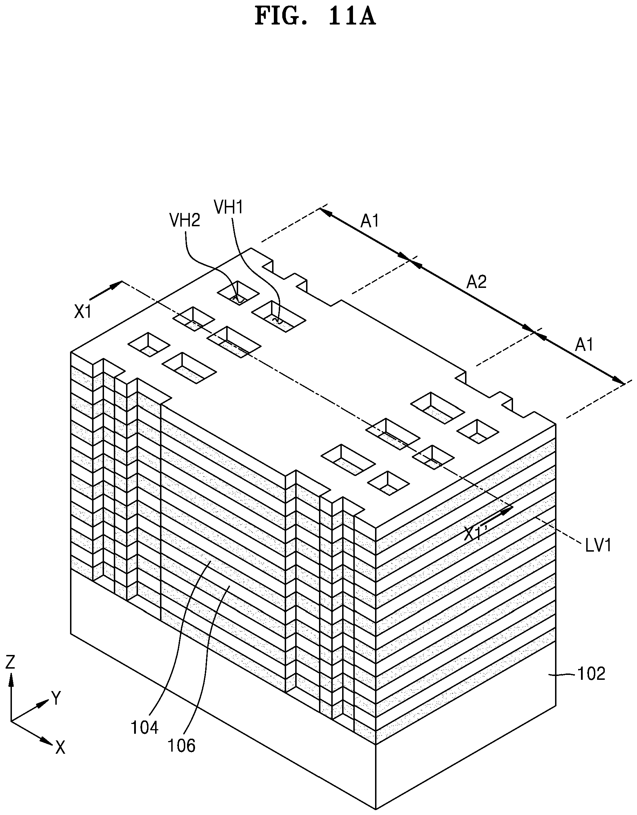

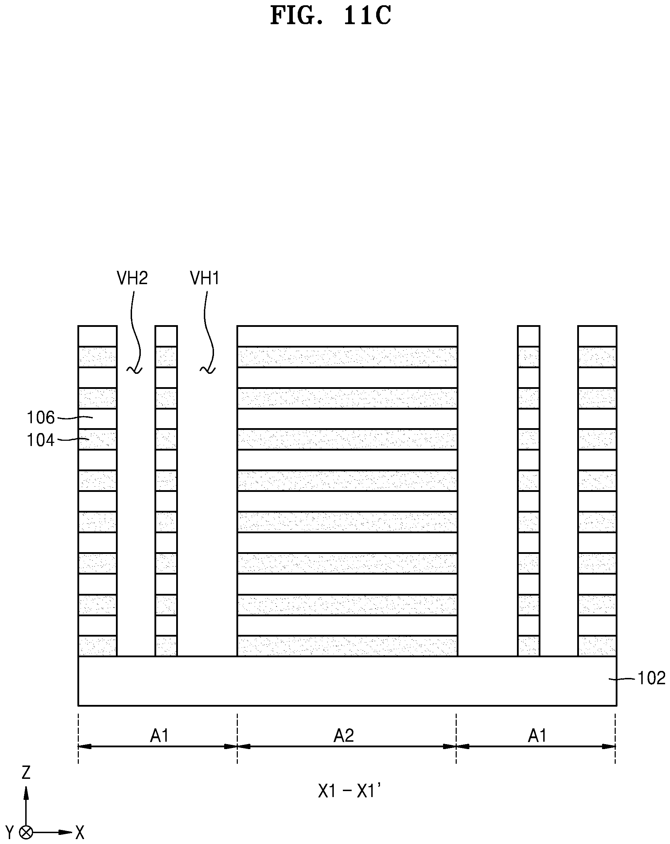

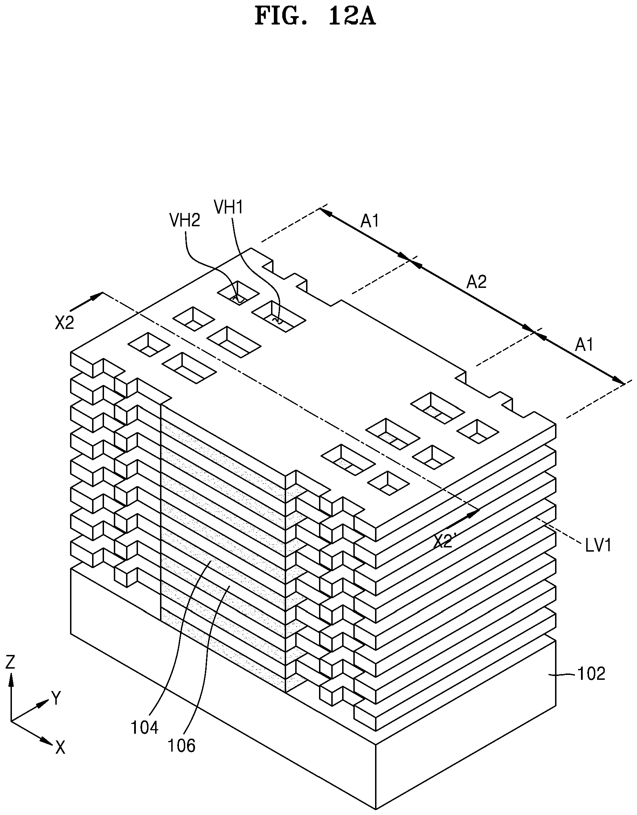

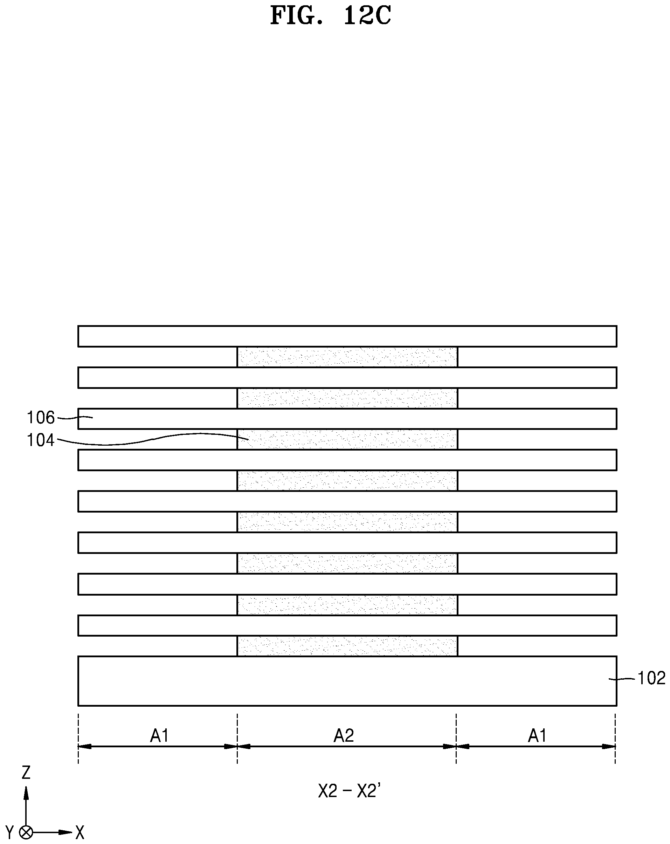

FIGS. 10A to 44C are diagrams illustrating a method of fabricating a semiconductor memory device, according to some example embodiments, and in particular, FIG. 10A, FIG. 11A, FIG. 12A, FIG. 13A, FIG. 14A, FIG. 15A, FIG. 16A, FIG. 17A, FIG. 18A, FIG. 19A, FIG. 20A, FIG. 21A, FIG. 22A, FIG. 23A, FIG. 24A, FIG. 25A, FIG. 26A, FIG. 27A, FIG. 28A, FIG. 29A, FIG. 30A, FIG. 31A, FIG. 32A, FIG. 33A, FIG. 34A, FIG. 35A, FIG. 36A, FIG. 37A, FIG. 38A, FIG. 39A, FIG. 40A, FIG. 41A, FIG. 42A, FIG. 43A, and FIG. 44A are perspective views respectively illustrating a sequence of processes of the method of fabricating the semiconductor memory device, FIG. 10B, FIG. 11B, FIG. 12B, FIG. 14B, FIG. 15B, FIG. 17B, FIG. 18B, FIG. 19B, FIG. 20B, FIG. 21B, FIG. 22B, FIG. 23B, FIG. 24B, FIG. 25B, FIG. 26B, FIG. 27B, FIG. 28B, FIG. 29B, FIG. 30B, FIG. 31B, FIG. 32B, FIG. 33B, FIG. 34B, FIG. 35B, FIG. 36B, FIG. 37B, FIG. 38B, FIG. 40B, FIG. 41B, FIG. 42B, FIG. 43B, and FIG. 44B are transverse cross-sectional views illustrating planar structures at first vertical levels of FIG. 10A, FIG. 11A, FIG. 12A, FIG. 14A, FIG. 15A, FIG. 17A, FIG. 18A, FIG. 19A, FIG. 20A, FIG. 21A, FIG. 22A, FIG. 23A, FIG. 24A, FIG. 25A, FIG. 26A, FIG. 27A, FIG. 28A, FIG. 29A, FIG. 30A, FIG. 31A, FIG. 32A, FIG. 33A, FIG. 34A, FIG. 35A, FIG. 36A, FIG. 37A, FIG. 38A, FIG. 40A, FIG. 41A, FIG. 42A, FIG. 43A, and FIG. 44A, respectively, FIGS. 10C and 11C are cross-sectional views taken along lines X1-X1' of FIGS. 10A and 11A, respectively, FIG. 12C, FIG. 13B, FIG. 16B, FIG. 17C, FIG. 18C, FIG. 19C, FIG. 20C, FIG. 22C, FIG. 23C, FIG. 25C, FIG. 26C, FIG. 29C, FIG. 30C, FIG. 33C, FIG. 36C, FIG. 37C, FIG. 39B, FIG. 42C, FIG. 43C, and FIG. 44C are cross-sectional views taken along lines X2-X2' of FIG. 12A, FIG. 13A, FIG. 16A, FIG. 17A, FIG. 18A, FIG. 19A, FIG. 20A, FIG. 22A, FIG. 23A, FIG. 25A, FIG. 26A, FIG. 29A, FIG. 30A, FIG. 33A, FIG. 36A, FIG. 37A, FIG. 39A, FIG. 42A, FIG. 43A, and FIG. 44A, respectively, and FIG. 10D is a cross-sectional view taken along a line Y1-Y1' of FIGS. 10A and 10B.

### DETAILED DESCRIPTION OF THE EMBODIMENTS

Hereinafter, embodiments of the inventive concept will be described in detail with reference to the accompanying drawings. Like components are denoted by like reference numerals throughout the specification, and repeated descriptions thereof are omitted.

It will be understood that when an element is referred to as being "connected" or "coupled" to or "on" another element, it can be directly connected or coupled to or on the other element or intervening elements may be present. In contrast, when an element is referred to as being "directly connected" or "directly coupled" to another element, or as "contacting" or "in contact with" another element (or using any form of the word "contact"), there are no intervening elements present at the point of contact.

Terms such as "same," "equal," "planar," or "coplanar," as used herein when referring to orientation, layout, location, shapes, sizes, amounts, or other measures do not necessarily mean an exactly identical orientation, layout, location, shape, size, amount, or other measure, but are intended to encompass nearly identical orientation, layout, location, shapes, sizes, amounts, or other measures within acceptable variations that may occur, for example, due to manufacturing processes. The term "substantially" may be used herein to emphasize this meaning, unless the context or other statements indicate otherwise. For example, items described as "substantially the same," "substantially equal," or "substantially planar," may be exactly the same, equal, or planar, or may be the same, equal, or planar within acceptable variations that may occur, for example, due to manufacturing processes.

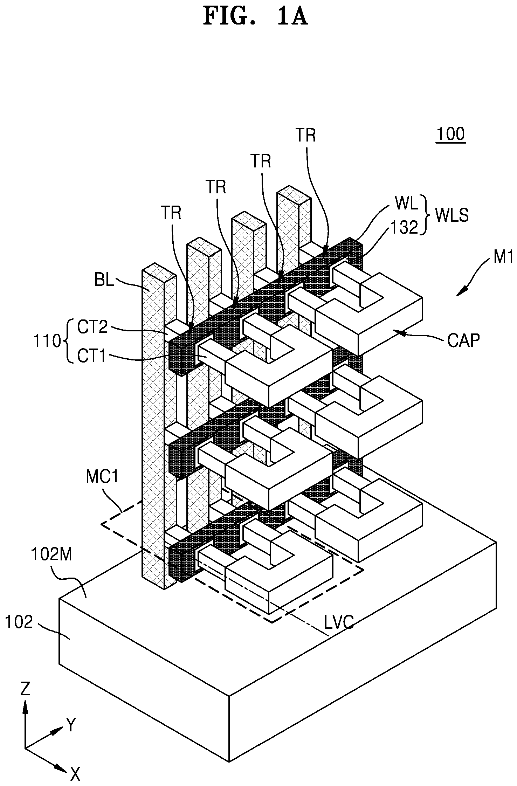

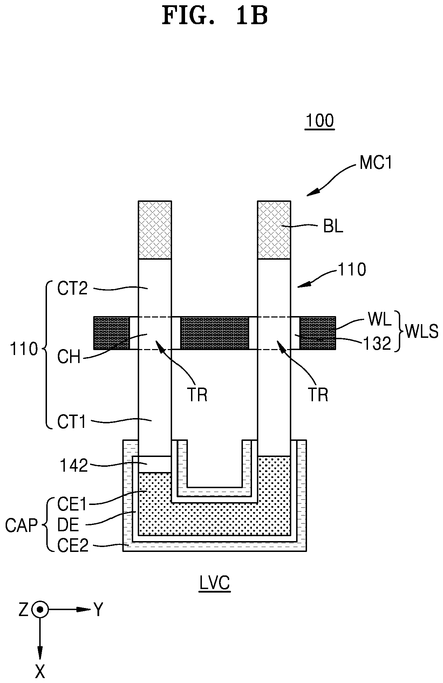

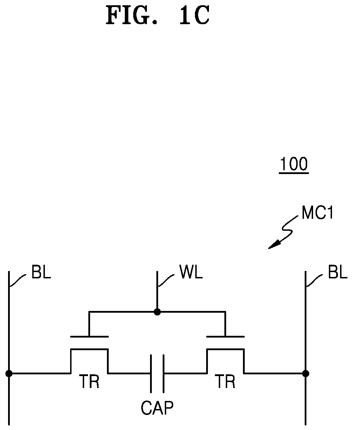

FIG. 1A is a perspective view of a portion of a semiconductor memory device 100 according to some example embodiments. FIG. 1B is a plan view of a portion of one memory cell MC1 in a memory cell array M1 of the semiconductor memory device 100 shown in FIG. 1A. FIG. 1B illustrates a planar structure of the semiconductor memory device 100 at a channel vertical level LVC of FIG. 1A. FIG. 1C is a circuit diagram of the one memory cell MC1 of the memory cell array M1 shown in FIG. 1A.

Referring to FIGS. 1A, 1B, and 1C, the semiconductor memory device 100 may include a memory cell array M1 having a 3-dimensional structure and arranged on a substrate 102. The memory cell array M1 may include a plurality of memory cells MC1 repeatedly arranged, on a main surface 102M of the substrate 102, in a first horizontal direction (an X direction) and a second horizontal direction (a Y direction), which are parallel to the main surface 102M of the substrate 102 and orthogonal to each other, and in a vertical direction (a Z direction) that is perpendicular to the main surface 102M of the substrate 102.

The substrate 102 may include a semiconductor element, such as Si or Ge, or a compound semiconductor, such as SiC, GaAs, InAs, and InP. The substrate 102 may include a semiconductor substrate and structures including at least one insulating film or at least one conductive region on the semiconductor substrate. The conductive region may include, for example, an impurity-doped well or an impurity-doped structure. In some embodiments, the substrate 102 may have various device isolation structures, such as a shallow trench isolation (STI) structure.

Although FIG. 1A illustrates a plurality of memory cells MC1 repeatedly arranged in the second horizontal direction (the Y direction) and the vertical direction (the Z direction) from among the plurality of memory cells MC1 of the memory cell array M1, the plurality of memory cells MC1 may be repeatedly arranged in the first horizontal direction (the X direction) in a similar manner to the example of FIG. 1A, and a pair of memory cells MC1 adjacent to each other in the first horizontal direction (the X direction) from among the plurality of memory cells MC1 may respectively have mirror-symmetric shapes to each other about an imaginary straight line extending in the second horizontal direction (the Y direction).

The memory cell array M1 may include a plurality of word lines WL, a plurality of bit lines BL, and a plurality of capacitors CAP spaced apart from the plurality of bit lines BL with the plurality of word lines WL therebetween. The plurality of word lines WL may be parallel to each other and may each extend lengthwise in the second horizontal direction (the Y direction). The plurality of bit lines BL may be parallel to each other and may extend lengthwise in the vertical direction (the Z direction).

The memory cell array M1 may include a plurality of active regions 110. Each of the plurality of active regions 110 may include a channel region CH facing one word line WL selected from the plurality of word lines WL, a first contact region CT1 connected between the channel region CH and one capacitor CAP selected from the plurality of capacitors CAP, and a second contact region CT2 connected between the channel region CH and one bit line BL selected from the plurality of bit lines BL.

Each of the plurality of memory cells MC1 of the memory cell array M1 may include two bit lines BL selected from the plurality of bit lines BL, one word line WL selected from the plurality of word lines WL, two active regions 110 selected from the plurality of active regions 110, and one capacitor CAP selected from the plurality of capacitors CAP. Each of the plurality of capacitors CAP may include an inner electrode CE1, an outer electrode CE2 surrounding the inner electrode CE1, and a dielectric film DE between the inner electrode CE1 and the outer electrode CE2. The dielectric film DE may contact an outer surface of the inner electrode CE1 and an inner surface of the outer electrode CE2.

In each of the plurality of memory cells MC1, the inner electrode CE1 of the capacitor CAP may be connected to one active region 110 (which may be referred to as a first active region, hereinafter) selected from two active regions 110 that are included in the memory cell MC1, and the outer electrode CE2 of the capacitor CAP may be connected to the other active region 110 (which may be referred to as a second active region, hereinafter) selected from the two active regions 110 that are included in the memory cell MC1.

The channel region CH of each of the plurality of active regions 110 may face a word line WL adjacent thereto. As shown in FIGS. 1A and 1B, the channel region CH of each of the plurality of active regions 110 may pass through the adjacent word line WL in the first horizontal direction (the X direction) such that the channel region CH is surrounded by the adjacent word line WL. A gate dielectric film 132 may be arranged between the channel region CH of each of the plurality of active regions 110 and the word line WL. Herein, one word line WL and a plurality of gate dielectric films 132 surrounded by the one word line WL may be referred to as a word line structure WLS.

In some embodiments, the plurality of word lines WL and the plurality of bit lines BL may each include a metal, a conductive metal nitride, a metal silicide, doped polysilicon, or a combination thereof. For example, each of the plurality of word lines WL and the plurality of bit lines BL may be formed of or include, but is not limited to, Ti, TiN, Ta, TaN, Mo, Ru, W, WN, Co, Al, Ni, TiSi, TiSiN, WSi, WSiN, TaSi, TaSiN, RuTiN, CoSi, NiSi, doped polysilicon, or a combination thereof. In some embodiments, the gate dielectric film 132 may include a paraelectric material. For example, the gate dielectric film 132 may include silicon oxide, silicon nitride, silicon oxynitride, or a combination thereof. In some embodiments, the gate dielectric film 132 may include a high-k material. The high-k material may have a dielectric constant of about 10 to about 25. For example, the high-k material may include, but is not limited to, hafnium oxide, aluminum oxide, zirconium oxide, or a combination thereof. In some embodiments, the gate dielectric film 132 may include a combination of a paraelectric material and a high-k material.

A plurality of transistors TR may be formed along one word line WL extending lengthwise in the second horizontal direction (the Y direction), and a plurality of transistors TR arranged in a line in the second horizontal direction (the Y direction) may share one word line WL. Therefore, two transistors TR constituting one memory cell MC1, among the plurality of transistors TR, may have structures sharing one word line WL. In one memory cell MC1, the inner electrode CE1 of the capacitor CAP may be connected to one transistor TR (which may be referred to as a first transistor, hereinafter) selected from two transistors TR constituting the one memory cell MC1, and the outer electrode CE2 of the capacitor CAP may be connected to the other transistor TR (which may be referred to as a second transistor, hereinafter) selected from the two transistors TR constituting the one memory cell MC1.

In each of the plurality of active regions 110, the first contact region CT1 may extend from one side of the channel region CH toward the capacitor CAP adjacent to the channel region CH. The first contact region CT1 of one active region 110 (that is, the first active region) selected from two active regions 110 of one memory cell MC1 may be in contact with the inner electrode CE1 of the capacitor CAP that is included in the one memory cell MC1, and the first contact region CT1 of the other active region 110 (that is, the second active region) selected from the two active regions 110 of the one memory cell MC1 may be in contact with the outer electrode CE2 of the capacitor CAP that is included in the one memory cell MC1. In some embodiments, the channel region CH of each of the plurality of active regions 110 may include silicon (Si), for example, single-crystal silicon, polycrystalline silicon, or amorphous silicon. In some embodiments, the channel region CH may include at least one selected from Ge, SiGe, SiC, GaAs, InAs, and InP. In some embodiments, the channel region CH may include an oxide semiconductor material. The oxide semiconductor material constituting the channel region CH may include, but is not limited to, at least one selected from InGaZnO (IGZO), Sn-IGZO, InWO (IWO), InZnO (IZO), ZnSnO (ZTO), ZnO, ZnON, yttrium-doped zinc oxide (YZO), InGaSiO, InO, SnO, TiO, ZnON, MgZnO, InZnO, ZrInZnO, HflnZnO, SnInZnO, AlSnInZnO, SiInZnO, AlZnSnO, GaZnSnO, and ZrZnSnO. In some embodiments, the channel region CH may further include at least one dopant selected from aluminum (Al), boron (B), arsenic (As), fluorine (F), and hydrogen (H), in addition to at least one oxide semiconductor material selected from the oxide semiconductor materials set forth above as examples. The first contact region CT1 and the second contact region CT2 of each of the plurality of active regions 110 may each include doped silicon (Si). For example, each of the first contact region CT1 and the second contact region CT2 may include, but is not limited to, silicon (Si) doped with an n-type dopant.

In one memory cell MC1, the inner electrode CE1 of the capacitor CAP may be in contact with the first contact region CT1 of the active region 110 of the one transistor TR (that is, the first transistor) out of the two transistors TR constituting the one memory cell MC1 and may be spaced apart from the first contact region CT1 of the other transistor TR (that is, the second transistor), and the outer electrode CE2 of the capacitor CAP may be spaced apart from the first contact region CT1 of the active region 110 of the one transistor TR (that is, the first transistor) and may be in contact with the first contact region CT1 of the other transistor TR (that is, the second transistor).

In each of the plurality of active regions 110, the second contact region CT2 may extend from another side of the channel region CH toward the bit line BL adjacent to the channel region CH and may be connected to the bit line BL adjacent to the channel region CH. In each of the plurality of active regions 110, the second contact region CT2 of each of two active regions 110, which are included in one memory cell MC1, may be in contact with a corresponding one bit line BL out of two bit lines BL that are included in the one memory cell MC1. That is, the second contact region CT2 of one active region 110 (which may be referred to as a first active region, hereinafter) selected from two active regions 110 of one memory cell MC1 may be in contact with one bit line BL (which may be referred to as a first bit line, hereinafter) selected from two bit lines BL of the one memory cell MC1, and the second contact region CT2 of the other active region 110 (which may be referred to as a second active region, hereinafter) selected from the two active regions 110 of the one memory cell MC1 may be in contact with the other bit line BL (which may be referred to as a second bit line, hereinafter) selected from the two bit lines BL of the one memory cell MC1. As shown in FIGS. 1A and 1B, each of two bit lines BL of one memory cell MC1 may be in contact with an end portion of the second contact region CT2 of one active region 110 selected from two active regions 110 of the one memory cell MC1.

As shown in FIG. 1B, in each of the plurality of memory cells MC1, an insulating block 142 may be arranged between the first contact region CT1 of an active region 110 (that is, the second active region) connected to the outer electrode CE2 of the capacitor CAP, out of two active regions 110 of the memory cell MC1, and the inner electrode CE1 of the capacitor CAP. The insulating block 142 may have a surface contacting the first contact region CT1 of the active region 110 (that is, the second active region) connected to the outer electrode CE2 of the capacitor CAP, a surface contacting the inner electrode CE1 of the capacitor CAP, and a surface covered by the dielectric film DE. In each of the plurality of memory cells MC1, the outer electrode CE2 of the capacitor CAP may surround the insulating block 142 with the dielectric film DE therebetween. For example, the dielectric film DE may contact an outer side surface of the insulating block 142 and an inner side surface of the outer electrode CE2.

The inner electrode CE1 of the capacitor CAP, which is included in each of the plurality of memory cells MC1, may be in contact with the first contact region CT1 of one active region 110 (that is, the first active region) out of two active regions 110 of the memory cell MC1 and may be spaced apart from the first contact region CT1 of the other active region 110 (that is, the second active region) out of the two active regions 110 with the insulating block 142 therebetween.

As shown in FIGS. 1A and 1B, each of the plurality of memory cells MC1 may include a U-shaped portion, which includes the capacitor CAP and the respective active regions 110 of two transistors TR, when viewed in a plane parallel to the main surface 102M of the substrate 102. As shown in FIG. 1B, at least some of the inner electrode CE1, the outer electrode CE2, and the dielectric film DE of the capacitor CAP may have a U-like or ⊂-like planar shape.

In the plurality of capacitors CAP, each of the inner electrode CE1 and the outer electrode CE2 may include a metal film, a conductive metal oxide film, a conductive metal nitride film, a conductive metal oxynitride film, or a combination thereof. In some embodiments, each of the inner electrode CE1 and the outer electrode CE2 may include Ti, Ti nitride, Ti oxide, Ti oxynitride, Nb, Nb nitride, Nb oxide, Nb oxynitride, Co, Co nitride, Co oxide, Co oxynitride, Sn, Sn nitride, Sn oxide, Sn oxynitride, or a combination thereof. For example, each of the inner electrode CE1 and the outer electrode CE2 may include TiN, NbN, CoN, SnO₂, or a combination thereof. In some embodiments, each of the inner electrode CE1 and the outer electrode CE2 may include TaN, TiAlN, TaAlN, V, VN, Mo, MoN, W, WN, Ru, RuO₂, SrRuO₃, Ir, IrO₂, Pt, PtO, SrRuO₃ (SRO), (Ba,Sr)RuO₃ (BSRO), CaRuO₃ (CRO), (La,Sr)CoO₃ (LSCO), or a combination thereof. However, a constituent material of each of the inner electrode CE1 and the outer electrode CE2 is not limited to the examples set forth above.

The dielectric film DE may include a silicon oxide film, a high-k film, or a combination thereof. In some embodiments, the dielectric film DE may include a metal oxide including at least one metal selected from Hf, Zr, Al, Nb, Ce, La, Ta, and Ti. In some embodiments, the dielectric film DE may have a single-layer structure including a single high-k film. In some embodiments, the dielectric film DE may have a multilayered structure including a plurality of high-k films sequentially stacked on the inner electrode CE1. The high-k film may be selected from, but is not limited to, a HfO₂ film, a ZrO₂ film, an Al₂O₃ film, a La₂O₃ film, a Ta₂O₃ film, a Nb₂O₅ film, a CeO₂ film, a TiO₂ film, and a GeO₂ film. In some embodiments, the dielectric film DE may include an oxide of at least one metal selected from Ti, Nb, Ta, Sn, and Mo, or an oxynitride of at least one metal selected from Ti, Nb, Ta, Sn, and Mo. For example, the dielectric film DE may include Ti oxide, Ti oxynitride, Nb oxide, Nb oxynitride, Ta oxide, Ta oxynitride, Sn oxide, Sn oxynitride, Mo oxide, Mo oxynitride, or a combination thereof. In some embodiments, the dielectric film DE may include a ferroelectric film including an oxide of at least one selected from Hf, Si, Al, Zr, Y, La, Gd, and Sr. The ferroelectric film may include a hafnium-based oxide, for example, hafnium oxide (HfO), hafnium zirconium oxide (HZO), hafnium titanium oxide, or hafnium silicon oxide. The ferroelectric film may further include a dopant, as needed. The dopant may include, but is not limited to, at least one element selected from Si, Al, Zr, Y, La, Gd, Sc, Sr, Mg, and Ba.

The semiconductor memory device 100 described with reference to FIGS. 1A, 1B, and 1C includes the memory cell array M1 having a 3-dimensional structure and including the plurality of memory cells MC1 that are repeatedly arranged in the horizontal direction (the X direction and/or the Y direction) and the vertical direction (the Z direction), and each of the plurality of memory cells MC1 includes two transistors TR and one capacitor CAP. In each of the plurality of memory cells MC1, the capacitor CAP includes the inner electrode CE1 connected to one transistor TR (that is, the first transistor) out of two transistors TR of the memory cell MC1, the outer electrode CE2 connected to the other transistor TR (that is, the second transistor) out of the two transistors TR of the memory cell MC1, and the dielectric film DE between the inner electrode CE1 and the outer electrode CE2. Unlike a general capacitor structure, the capacitor CAP does not include a separate plate electrode for applying voltage directly to the outer electrode CE2 of the capacitor CAP. Therefore, because noise in the plate electrode, which is prone to be generated in a general capacitor structure, may be fundamentally removed, the capacitance of the capacitor CAP may be increased, and thus, the sensing margin of the semiconductor memory device 100 may improve.

In addition, in each of the plurality of memory cells MC1 of the semiconductor memory device 100, two transistors TR share one word line WL, and each of the plurality of memory cells MC1 includes a U-shaped portion, which includes one capacitor CAP and the respective active regions 110 of two transistors TR. Therefore, the area occupied by the capacitor CAP and the word line WL in the memory cell array M1 may be minimized, and the occupied area of each of the plurality of memory cells MC1 may be constant in the horizontal direction (the X direction and/or the Y direction) and/or the vertical direction (the Z direction). Therefore, the plurality of memory cells MC1 may be effectively arranged in the memory cell array M1 such that the area occupied by the plurality of memory cells MC1 is minimized, and the performance of the semiconductor memory device 100 may improve even without inefficiently increasing the area occupied by the plurality of memory cells MC1.

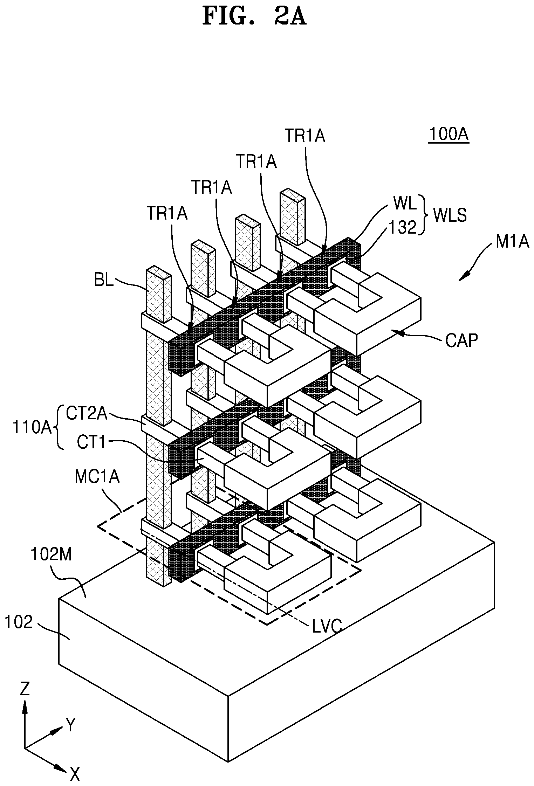

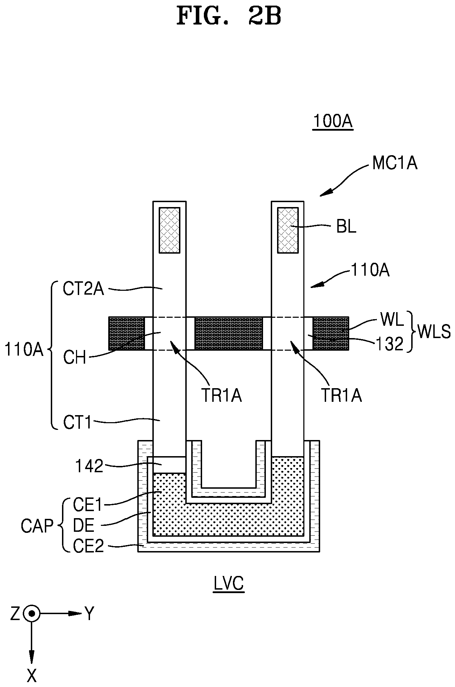

FIG. 2A is a perspective view of a portion of a semiconductor memory device 100A according to some example embodiments. FIG. 2B is a plan view of a portion of one memory cell MC1A in a memory cell array M1A of the semiconductor memory device 100A shown in FIG. 2A. FIG. 2B illustrates a planar structure of the memory cell MC1A at a channel vertical level LVC of FIG. 2A. In FIGS. 2A and 2B, the same reference numerals as in FIGS. 1A, 1B, and 1C respectively denote the same members, and here, repeated descriptions thereof are omitted.

Referring to FIGS. 2A and 2B, the semiconductor memory device 100A has substantially the same configuration as the semiconductor memory device 100 described with reference to FIGS. 1A, 1B, and 1C. However, the semiconductor memory device 100A includes the memory cell array M1A having a 3-dimensional structure and arranged on the substrate 102. The memory cell array M1A may include a plurality of memory cells MC1A repeatedly arranged, on the main surface 102M of the substrate 102, in the first horizontal direction (the X direction) and the second horizontal direction (the Y direction), which are parallel to the main surface 102M of the substrate 102 and orthogonal to each other, and in the vertical direction (the Z direction) that is perpendicular to the main surface 102M of the substrate 102.

The memory cell array M1A has substantially the same configuration as the memory cell array M1 described with reference to FIGS. 1A, 1B, and 1C. However, the memory cell array M1A includes a plurality of active regions 110A. Each of the plurality of active regions 110A may include the channel region CH, the first contact region CT1 connected to the inner electrode CE1 of the capacitor CAP, and a second contact region CT2A connected between the channel region CH and one bit line BL selected from the plurality of bit lines BL. In each of the plurality of active regions 110A, the channel region CH, the first contact region CT1, and the second contact region CT2A may have substantially the same configurations as the channel region CH, the first contact region CT1, and the second contact region CT2 described with reference to FIGS. 1A, 1B, and 1C, respectively. However, in each of the plurality of active regions 110A, the second contact region CT2A may surround one bit line BL selected from the plurality of bit lines BL.

A plurality of transistors TR1A may be formed along one word line WL extending lengthwise in the second horizontal direction (the Y direction), and the plurality of transistors TR1A arranged in a line in the second horizontal direction (the Y direction) may share one word line WL. Therefore, two transistors TR1A constituting one memory cell MC1A, among the plurality of transistors TR1A, may have structures sharing one word line WL.

Each of two bit lines BL, which are included in one memory cell MC1A may pass through the second contact region CT2A of the active region 110A in the vertical direction (the Z direction) such that each of the two bit lines BL is surrounded by the second contact region CT2A of the active region 110A constituting one transistor TR1A selected from two transistors TR1A of the one memory cell MC1A.

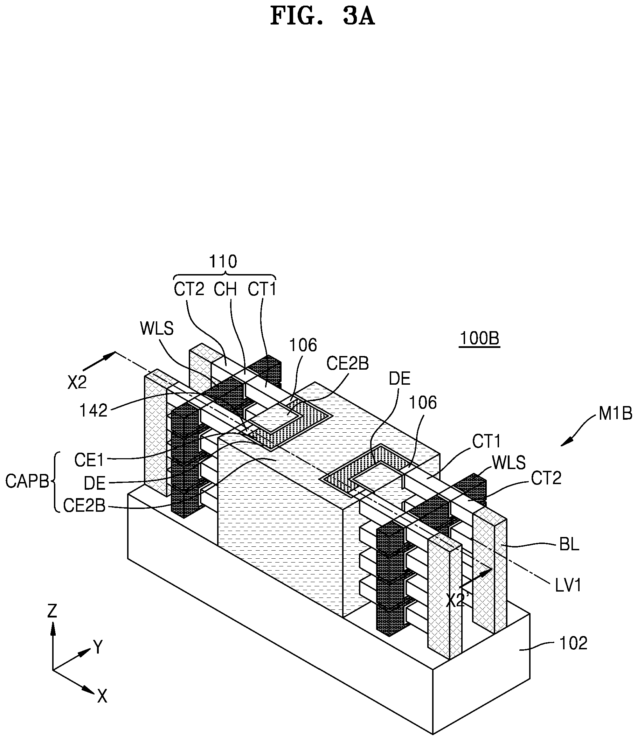

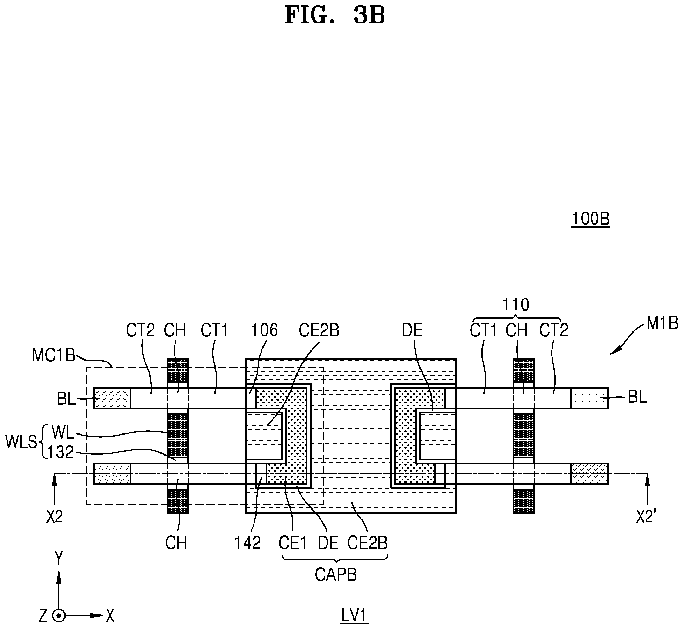

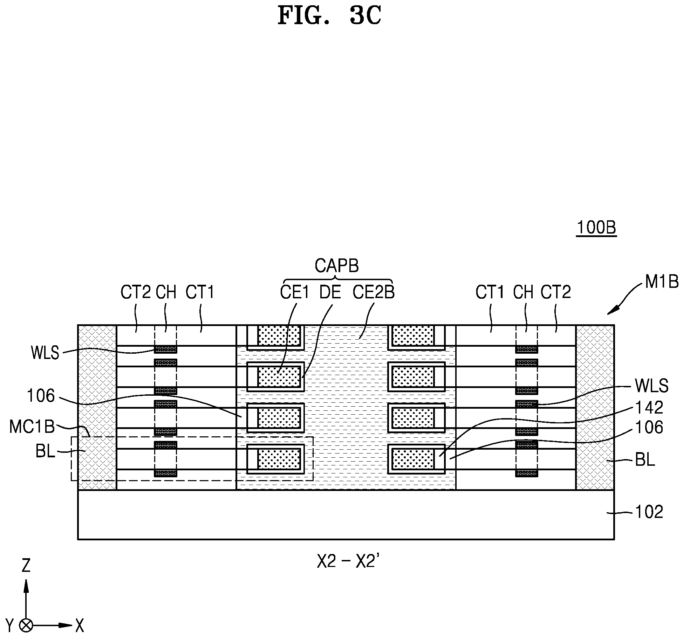

FIG. 3A is a perspective view of a portion of a semiconductor memory device 100B according to some example embodiments. FIG. 3B is a transverse cross-sectional view of a portion of the semiconductor memory device 100B shown in FIG. 3A. FIG. 3B illustrates a planar structure of the semiconductor memory device 100B at a first vertical level LV1 of FIG. 3A. FIG. 3C is a cross-sectional view of the semiconductor memory device 100B, taken along a line X2-X2' of FIGS. 3A and 3B. In FIGS. 3A, 3B, and 3C, the same reference numerals as in FIGS. 1A, 1B, and 1C respectively denote the same members, and here, repeated descriptions thereof are omitted.

Referring to FIGS. 3A, 3B, and 3C, the semiconductor memory device 100B has substantially the same configuration as the semiconductor memory device 100 described with reference to FIGS. 1A, 1B, and 1C. However, the semiconductor memory device 100B includes a memory cell array M1B having a 3-dimensional structure and arranged on the substrate 102. The memory cell array M1B may include a plurality of memory cells MC1B repeatedly arranged in the first horizontal direction (the X direction) and the vertical direction (the Z direction). Although FIGS. 3A, 3B, and 3C illustrate the plurality of memory cells MC1B repeatedly arranged in the first horizontal direction (the X direction) and the vertical direction (the Z direction), among the plurality of memory cells MC1B that are included in the memory cell array M1B, the plurality of memory cells MC1B may be repeatedly arranged in the second horizontal direction (the Y direction) in a similar manner to the example of FIGS. 3A, 3B, and 3C. A pair of memory cells MC1B adjacent to each other in the first horizontal direction (the X direction), among the plurality of memory cells MC1B, may respectively have mirror-symmetric shapes to each other about an imaginary straight line extending in the second horizontal direction (the Y direction).

The memory cell array M1B has substantially the same configuration as the memory cell array M1 described with reference to FIGS. 1A, 1B, and 1C. However, the memory cell array M1B includes a plurality of capacitors CAPB instead of the plurality of capacitors CAP. Each of the plurality of capacitors CAPB may include the inner electrode CE1, an outer electrode CE2B surrounding the inner electrode CE1, and the dielectric film DE between the inner electrode CE1 and the outer electrode CE2B. In FIGS. 3A, 3B, and 3C, a semiconductor layer 106 is arranged between the first contact region CT1 and the inner electrode CE1 and between the first contact region CT1 and the insulating block 142. For example, a first end of the semiconductor layer 106 may contact the first contact region CT1, and a second end of the semiconductor layer 106 may contact either the inner electrode CE1 or the insulating block 142. The semiconductor layer 106 may be connected to the first contact region CT1 and may function as a portion of the first contact region CT1.

One memory cell group, which includes the plurality of memory cells MC1B repeatedly arranged in the vertical direction (the Z direction), and another memory cell group, which is adjacent to the one memory cell group in the first horizontal direction (the X direction) and includes the plurality of memory cells MC1B repeatedly arranged in the vertical direction (the Z direction), may respectively have mirror-symmetric shapes to each other about an imaginary straight line extending in the second horizontal direction (the Y direction). In addition, the respective capacitors CAPB of a pair of memory cells MC1B adjacent to each other in the first horizontal direction (the X direction), among the plurality of memory cells MC1B, may share one outer electrode CE2B. A constituent material of the outer electrode CE2B is substantially the same as that of the outer electrode CE2 described with reference to FIG. 1B.

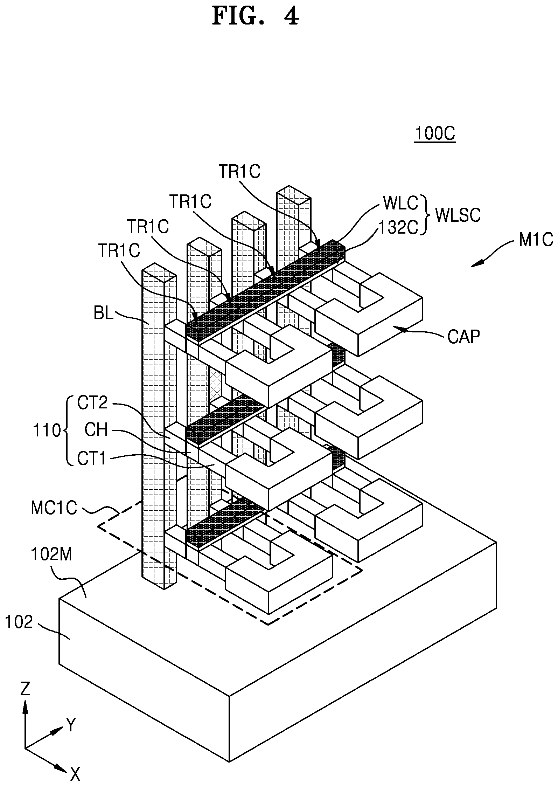

FIG. 4 is a perspective view of a portion of a semiconductor memory device 100C according to some example embodiments. In FIG. 4, the same reference numerals as in FIGS. 1A, 1B, and 1C respectively denote the same members, and here, repeated descriptions thereof are omitted.

Referring to FIG. 4, the semiconductor memory device 100C has substantially the same configuration as the semiconductor memory device 100 described with reference to FIGS. 1A, 1B, and 1C. However, the semiconductor memory device 100C includes a memory cell array M1C having a 3-dimensional structure and arranged on the substrate 102. The memory cell array M1C may include a plurality of memory cells MC1C repeatedly arranged, on the main surface 102M of the substrate 102, in the first horizontal direction (the X direction) and the second horizontal direction (the Y direction), which are parallel to the main surface 102M of the substrate 102 and orthogonal to each other, and in the vertical direction (the Z direction) that is perpendicular to the main surface 102M of the substrate 102.

The memory cell array M1C has substantially the same configuration as the memory cell array M1 described with reference to FIGS. 1A, 1B, and 1C. However, the memory cell array M1C includes a plurality of word lines WLC.

The plurality of word lines WLC may be parallel to each other and may extend lengthwise in the second horizontal direction (the Y direction). One word line WLC selected from the plurality of word lines WLC may cover one surface of each of the plurality of channel regions CH aligned in a line in the second horizontal direction (the Y direction). One word line WLC selected from the plurality of word lines WLC may overlap, in the vertical direction (the Z direction), the plurality of channel regions CH aligned in a line in the second horizontal direction (the Y direction).

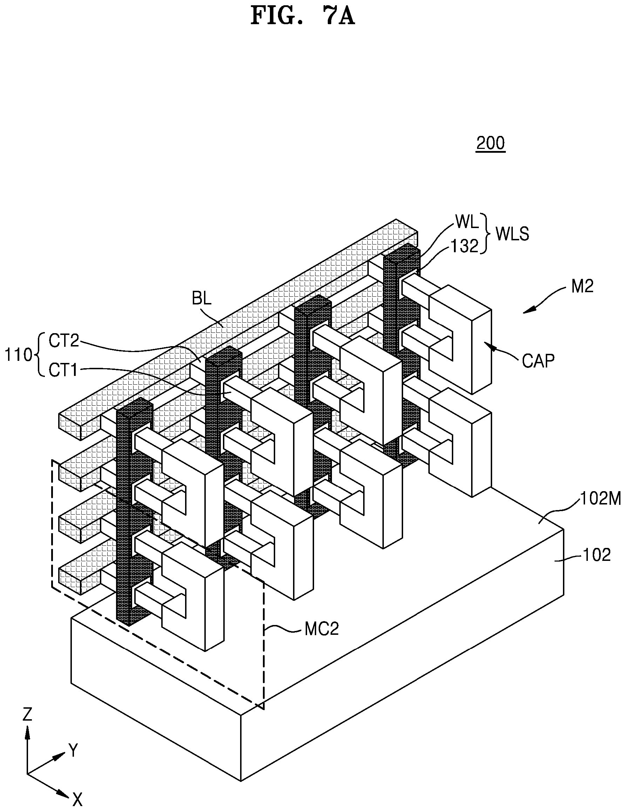

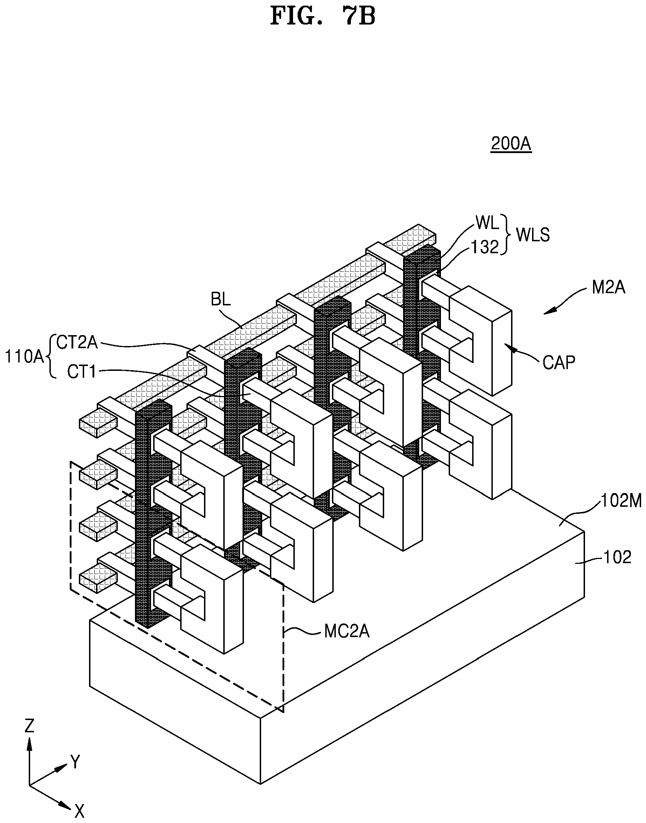

In some embodiments, the plurality of word lines WLC may be parallel to each other and may extend lengthwise in the vertical direction (the Z direction), unlike the example of FIG. 4. One word line WLC selected from the plurality of word lines WLC may cover one surface of each of the plurality of channel regions CH aligned in a line in the vertical direction (the Z direction), and in this case, the one word line WLC may overlap, in the horizontal direction, for example, the second horizontal direction (the Y direction), the plurality of channel regions CH aligned in a line in the vertical direction (the Z direction). As such, when one word line WLC is arranged to cover one surface of each of the plurality of channel regions CH aligned in a line in the vertical direction (the Z direction), the plurality of bit lines BL may be arranged to extend lengthwise in the second horizontal direction (the Y direction) as described below with reference to FIG. 7A or 7B.

A gate dielectric film 132C may be arranged between the word line WLC and the plurality of channel regions CH aligned in a line in the second horizontal direction (the Y direction). In some embodiments, the gate dielectric film 132C may contact a lower surface of the word line WLC and an upper surface of each of the plurality of channel regions CH. One word line WLC and one gate dielectric film 132C, which are in contact with each other, may be referred to as a word line structure WLSC. Among surfaces of the channel region CH of each of a plurality of transistors TR1C aligned in a line in the second horizontal direction (the Y direction), a surface opposite to a surface facing the word line WLC may not be covered by a word line WLC. That is, each of the plurality of transistors TR1C may have a single-gate structure. Constituent materials of the word line WLC and the gate dielectric film 132C are the same as those of the word line WL and the gate dielectric film 132 described with reference to FIG. 1B, respectively.

The plurality of transistors TR1C may be formed along one word line WLC extending lengthwise in the second horizontal direction (the Y direction), and the plurality of transistors TR1C arranged in a line in the second horizontal direction (the Y direction) may share one word line WLC. Two transistors TR1C constituting one memory cell MC1C, among the plurality of transistors TR1C, may have structures sharing one word line WLC.

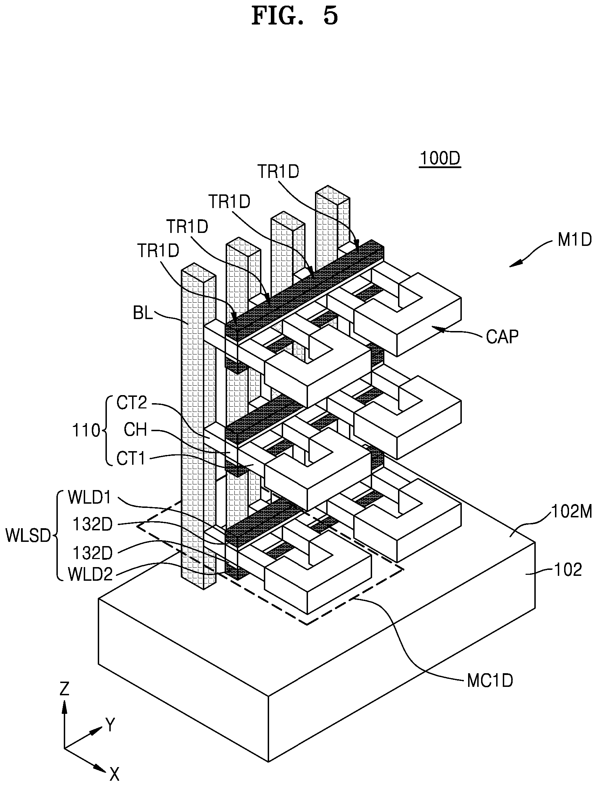

FIG. 5 is a perspective view of a portion of a semiconductor memory device 100D according to some example embodiments. In FIG. 5, the same reference numerals as in FIGS. 1A, 1B, and 1C respectively denote the same members, and here, repeated descriptions thereof are omitted.

Referring to FIG. 5, the semiconductor memory device 100D has substantially the same configuration as the semiconductor memory device 100 described with reference to FIGS. 1A, 1B, and 1C. However, the semiconductor memory device 100D includes a memory cell array M1D having a 3-dimensional structure and arranged on the substrate 102. The memory cell array M1D may include a plurality of memory cells MC1D repeatedly arranged, on the main surface 102M of the substrate 102, in the first horizontal direction (the X direction) and the second horizontal direction (the Y direction), which are parallel to the main surface 102M of the substrate 102 and orthogonal to each other, and in the vertical direction (the Z direction) that is perpendicular to the main surface 102M of the substrate 102.

The memory cell array M1D has substantially the same configuration as the memory cell array M1 described with reference to FIGS. 1A, 1B, and 1C. However, the memory cell array M1D includes a plurality of first word lines WLD1 and a plurality of second word lines WLD2.

The plurality of first word lines WLD1 and the plurality of second word lines WLD2 may be parallel to each other and may each extend lengthwise in the second horizontal direction (the Y direction). The upper surface of each of the plurality of channel regions CH aligned in a line in the second horizontal direction (the Y direction) may be covered by one first word line WLD 1 selected from the plurality of first word lines WLD1, and the lower surface of each of the plurality of channel regions CH aligned in a line in the second horizontal direction (the Y direction) may be covered by one second word line WLD2 selected from the plurality of second word lines WLD2. The plurality of first word lines WLD1 and the plurality of second word lines WLD2 may each overlap, in the vertical direction (the Z direction), the plurality of channel regions CH aligned in a line in the second horizontal direction (the Y direction).

In some embodiments, the plurality of first word lines WLD1 and the plurality of second word lines WLD2 may be parallel to each other and may extend lengthwise in the vertical direction (the Z direction), unlike the example of FIG. 5. Each of the plurality of first word lines WLD1 and the plurality of second word lines WLD2 may cover one surface of each of the plurality of channel regions CH aligned in a line in the vertical direction (the Z direction) and may overlap, in the horizontal direction, for example, the second horizontal direction (the Y direction), the plurality of channel regions CH aligned in a line in the vertical direction (the Z direction). As such, when each of the plurality of first word lines WLD1 and the plurality of second word lines WLD2 is arranged to cover one surface of each of the plurality of channel regions CH aligned in a line in the vertical direction (the Z direction), the plurality of bit lines BL may be arranged to extend lengthwise in the second horizontal direction (the Y direction) as described below with reference to FIG. 7A or 7B.

A gate dielectric film 132D may be arranged between the first word line WLD1 and the plurality of channel regions CH aligned in a line in the second horizontal direction (the Y direction) and between the second word line WLD2 and the plurality of channel regions CH aligned in a line in the second horizontal direction (the Y direction). In some embodiments, the gate dielectric film 132D may contact a lower surface of the first word line WLD1 and an upper surface of each of the plurality of channel regions CH, and may contact an upper surface of the second word line WLD2 and a lower surface of each of the plurality of channel regions CH. A pair of gate dielectric films 132D, which respectively cover the upper surface and the lower surface of each of the plurality of channel regions CH aligned in a line in the second horizontal direction (the Y direction), and the first word line WLD1 and the second word line WLD2, which are spaced apart from each other in the vertical direction (the Z direction) with the pair of gate dielectric films 132D therebetween, may be referred to as a word line structure WLSD. Constituent materials of the first word line WLD1, the second word line WLD2, and the gate dielectric film 132D are the same as those of the word line WL and the gate dielectric film 132 described with reference to FIG. 1B.

A plurality of transistors TR1D may be formed along the first word line WLD1 and the second word line WLD2, which extend lengthwise in the second horizontal direction (the Y direction), and the plurality of transistors TR1D arranged in a line in the second horizontal direction (the Y direction) may share one first word line WLD1 and one second word line WLD2. Each of the plurality of transistors TR1D aligned in a line in the second horizontal direction (the Y direction) may have a double-gate structure in which the upper surface and the lower surface of the channel region CH respectively face the first word line WLD1 and the second word line WLD2.

Two transistors TR1D constituting one memory cell MC1D, among the plurality of transistors TR1D, may have structures sharing one first word line WLD1 and one second word line WLD2. In one memory cell MC1D, the first word line WLD1 and the second word line WLD2 may be apart from each other in the vertical direction (the Z direction) with the channel region CH of each of the two transistors TR1D therebetween. In one memory cell MC1D, the first word line WLD1 and the second word line WLD2 may overlap the channel region CH of each of the two transistors TR1D.

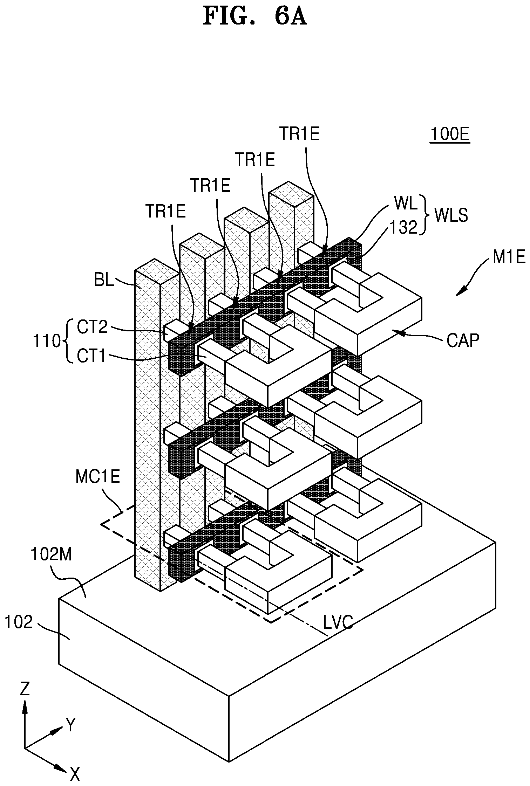

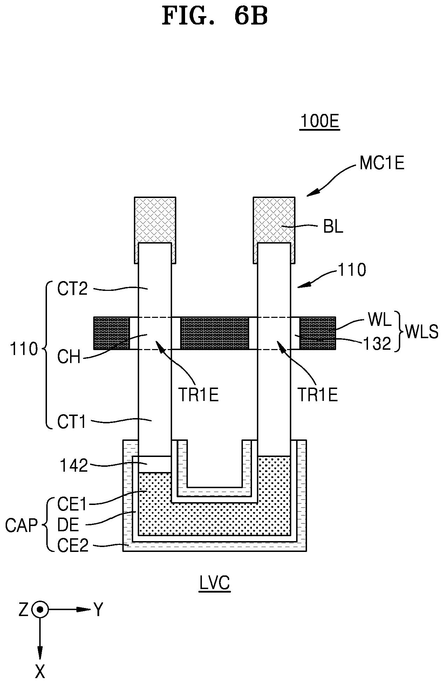

FIG. 6A is a perspective view of a portion of a semiconductor memory device 100E according to some example embodiments, and FIG. 6B is a plan view of a portion of one memory cell MC1E in a memory cell array M1E of the semiconductor memory device 100E shown in FIG. 6A. FIG. 6B illustrates a planar structure of the semiconductor memory device 100E at a channel vertical level LVC of FIG. 6A. In FIGS. 6A and 6B, the same reference numerals as in FIGS. 1A, 1B, and 1C respectively denote the same members, and here, repeated descriptions thereof are omitted.

Referring to FIGS. 6A and 6B, the semiconductor memory device 100E has substantially the same configuration as the semiconductor memory device 100 described with reference to FIGS. 1A, 1B, and 1C. However, the semiconductor memory device 100E includes a memory cell array M1E having a 3-dimensional structure and arranged on the substrate 102. The memory cell array M1E may include a plurality of memory cells MC1E repeatedly arranged, on the main surface 102M of the substrate 102, in the first horizontal direction (the X direction) and the second horizontal direction (the Y direction), which are parallel to the main surface 102M of the substrate 102 and orthogonal to each other, and in the vertical direction (the Z direction) that is perpendicular to the main surface 102M of the substrate 102.

The memory cell array M1E has substantially the same configuration as the memory cell array M1 described with reference to FIGS. 1A, 1B, and 1C. However, in the memory cell array M1E, an end portion of the second contact region CT2 of each of the plurality of active regions 110 may be surrounded by one bit line BL selected from the plurality of bit lines BL, the end portion being spaced apart from the channel region CH. One bit line BL may surround the second contact region CT2 of each of the plurality of active regions 110 that are aligned in a line in the vertical direction (the Z direction). For example, one bit line BL may contact an end surface and adjacent side surfaces of the second contact region CT2.

FIG. 7A is a perspective view of a portion of a semiconductor memory device 200 according to some example embodiments. In FIG. 7A, the same reference numerals as in FIGS. 1A, 1B, and 1C respectively denote the same members, and here, repeated descriptions thereof are omitted.

Referring to FIG. 7A, the semiconductor memory device 200 has substantially the same configuration as the semiconductor memory device 100 described with reference to FIGS. 1A, 1B, and 1C. However, the semiconductor memory device 200 includes a memory cell array M2 having a 3-dimensional structure and arranged on the substrate 102. The memory cell array M2 may include a plurality of memory cells MC2 repeatedly arranged, on the main surface 102M of the substrate 102, in the first horizontal direction (the X direction) and the second horizontal direction (the Y direction), which are parallel to the main surface 102M of the substrate 102 and orthogonal to each other, and in the vertical direction (the Z direction) that is perpendicular to the main surface 102M of the substrate 102. Although FIG. 7A illustrates a plurality of memory cells MC2 repeatedly arranged in the second horizontal direction (the Y direction) and the vertical direction (the Z direction) from among the plurality of memory cells MC2 of the memory cell array M2, the plurality of memory cells MC2 may be repeatedly arranged in the first horizontal direction (the X direction) in a similar manner to the example of FIG. 7A, and a pair of memory cells MC2 adjacent to each other in the first horizontal direction (the X direction) from among the plurality of memory cells MC2 may respectively have mirror-symmetric shapes to each other about an imaginary straight line extending in the second horizontal direction (the Y direction).

The memory cell array M2 has substantially the same configuration as the memory cell array M1 described with reference to FIGS. 1A, 1B, and 1C. However, in the memory cell array M2, the plurality of word lines WL may be parallel to each other and may each extend lengthwise in the vertical direction (the Z direction). The plurality of bit lines BL may be parallel to each other and may extend lengthwise in the second horizontal direction (the Y direction). In the memory cell array M2, the relative structures and placements of other components except for the plurality of word lines WL and the plurality of bit lines BL, with respect to the plurality of word lines WL and the plurality of bit lines BL, are the same as described with reference to FIGS. 1A, 1B, and 1C. That is, the memory cell array M2 may have the same structure as a structure obtained by rotating the structure of the memory cell array M1 described with reference to FIGS. 1A, 1B, and 1C by as much as 90 degrees in the viewpoint of a vertical plane (that is, the Y-Z plane in FIG. 1A).

Each of the plurality of memory cells MC2 may include a U-shaped portion including a capacitor CAP and two active regions 110, when viewed in a plane (that is, the X-Z plane in FIG. 7A) that is perpendicular to the main surface 102M of the substrate 102.

FIG. 7B is a perspective view of a portion of a semiconductor memory device 200A according to some example embodiments. In FIG. 7B, the same reference numerals as in FIGS. 1A, 1B, and 1C respectively denote the same members, and here, repeated descriptions thereof are omitted.

Referring to FIG. 7B, the semiconductor memory device 200A has substantially the same configuration as the semiconductor memory device 100A described with reference to FIGS. 2A and 2B. However, the semiconductor memory device 200A includes a memory cell array M2A having a 3-dimensional structure and arranged on the substrate 102. The memory cell array M2A may include a plurality of memory cells MC2A repeatedly arranged, on the main surface 102M of the substrate 102, in the first horizontal direction (the X direction) and the second horizontal direction (the Y direction), which are parallel to the main surface 102M of the substrate 102 and orthogonal to each other, and in the vertical direction (the Z direction) that is perpendicular to the main surface 102M of the substrate 102. Although FIG. 7B illustrates a plurality of memory cells MC2A repeatedly arranged in the second horizontal direction (the Y direction) and the vertical direction (the Z direction) from among the plurality of memory cells MC2A of the memory cell array M2A, the plurality of memory cells MC2A may be repeatedly arranged in the first horizontal direction (the X direction) in a similar manner to the example of FIG. 7B, and a pair of memory cells MC2A adjacent to each other in the first horizontal direction (the X direction) from among the plurality of memory cells MC2A may respectively have mirror-symmetric shapes to each other about an imaginary straight line extending in the second horizontal direction (the Y direction).

The memory cell array M2A has substantially the same configuration as the memory cell array M1A described with reference to FIGS. 2A and 2B. However, in the memory cell array M2A, the plurality of word lines WL may be parallel to each other and may each extend lengthwise in the vertical direction (the Z direction). The plurality of bit lines BL may be parallel to each other and may extend lengthwise in the second horizontal direction (the Y direction). In the memory cell array M2A, the relative structures and placements of other components except for the plurality of word lines WL and the plurality of bit lines BL, with respect to the plurality of word lines WL and the plurality of bit lines BL, are the same as described with reference to FIGS. 2A and 2B. That is, the memory cell array M2A may have the same structure as a structure obtained by rotating the structure of the memory cell array M1A described with reference to FIGS. 2A and 2B by as much as 90 degrees in the viewpoint of a vertical plane (that is, the Y-Z plane in FIG. 2A).

Each of the plurality of memory cells MC2A may include a U-shaped portion including a capacitor CAP and two active regions 110, when viewed in a plane (that is, the X-Z plane in FIG. 7B) that is perpendicular to the main surface 102M of the substrate 102.

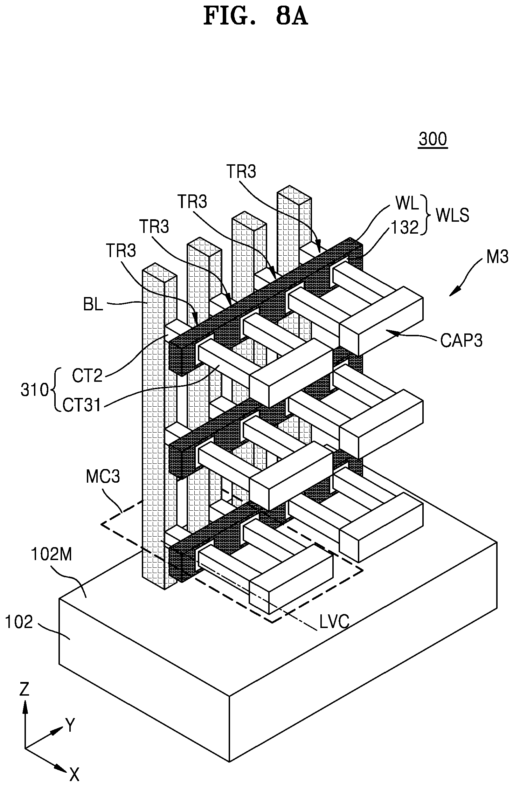

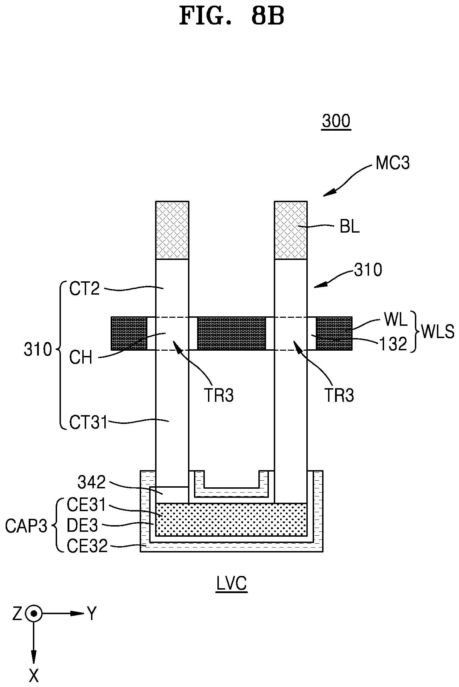

FIG. 8A is a perspective view of a portion of a semiconductor memory device 300 according to some example embodiments. FIG. 8B is a plan view of a portion of one memory cell MC3 in a memory cell array M3 of the semiconductor memory device 300 shown in FIG. 8A. FIG. 8B illustrates a planar structure of the semiconductor memory device 300 at a channel vertical level LVC of FIG. 8A. In FIGS. 8A and 8B, the same reference numerals as in FIGS. 1A, 1B, and 1C respectively denote the same members, and here, repeated descriptions thereof are omitted.

Referring to FIGS. 8A and 8B, the semiconductor memory device 300 has substantially the same configuration as the semiconductor memory device 100 described with reference to FIGS. 1A, 1B, and 1C. However, the semiconductor memory device 300 includes a memory cell array M3 having a 3-dimensional structure and arranged on the substrate 102. The memory cell array M3 may include a plurality of memory cells MC3 repeatedly arranged, on the main surface 102M of the substrate 102, in the first horizontal direction (the X direction) and the second horizontal direction (the Y direction), which are parallel to the main surface 102M of the substrate 102 and orthogonal to each other, and in the vertical direction (the Z direction) that is perpendicular to the main surface 102M of the substrate 102.

The memory cell array M3 includes a plurality of active regions 310 and a plurality of capacitors CAP3. Each of the plurality of memory cells MC3 may have substantially the same configuration as the memory cell MC1 described with reference to FIGS. 1A, 1B, and 1C. However, the capacitor CAP3 of each of the plurality of memory cells MC3 may include an inner electrode CE31, an outer electrode CE32 surrounding the inner electrode CE31, and a dielectric film DE3 between the inner electrode CE31 and the outer electrode CE32. Each of the plurality of active regions 310 may include a channel region CH facing one word line WL selected from the plurality of word lines WL, a first contact region CT31 connected between the channel region CH and one capacitor CAP3 selected from the plurality of capacitors CAP3, and a second contact region CT2 connected between the channel region CH and one bit line BL selected from the plurality of bit lines BL.

In each of the plurality of memory cells MC3, the inner electrode CE31 of the capacitor CAP3 may be connected to the first contact region CT31 of one active region 310 (which may be referred to as a first active region, hereinafter) selected from two active regions 310 that are included in the memory cell MC3, and the outer electrode CE32 of the capacitor CAP3 may be connected to the first contact region CT31 of the other active region 310 (which may be referred to as a second active region, hereinafter) selected from the two active regions 310 that are included in the memory cell MC3.

A plurality of transistors TR3 may be formed along one word line WL extending lengthwise in the second horizontal direction (the Y direction), and the plurality of transistors TR3 arranged in a line in the second horizontal direction (the Y direction) may share one word line WL. Therefore, two transistors TR3 constituting one memory cell MC3, among the plurality of transistors TR3, may have structures sharing one word line WL. In one memory cell MC3, the inner electrode CE31 of the capacitor CAP3 may be connected to one transistor TR3 (which may be referred to as a first transistor, hereinafter) selected from two transistors TR3 constituting the one memory cell MC3, and the outer electrode CE32 of the capacitor CAP3 may be connected to the other transistor TR3 (which may be referred to as a second transistor, hereinafter) selected from the two transistors TR3 constituting the one memory cell MC3 .

As shown in FIG. 8B, in each of the plurality of memory cells MC3, an insulating block 342 may be arranged between the first contact region CT31 of an active region 310 (that is, the second active region) connected to the outer electrode CE32 of the capacitor CAP3, out of two active regions 310 of the memory cell MC3, and the inner electrode CE31 of the capacitor CAP3.

The inner electrode CE31 of the capacitor CAP3 may have a straight planar shape extending lengthwise in the second horizontal direction (the Y direction). The dielectric film DE3 and the outer electrode CE32 of the capacitor CAP3 may have a U-like or ⊂-like planar shape. Each of the plurality of memory cells MC3 may include a U-shaped portion including a capacitor CAP3 and two active regions 310, when viewed in a plane (that is, the X-Y plane in FIG. 8A) that is parallel to the main surface 102M of the substrate 102.

More detailed configurations of the inner electrode CE31, the dielectric film DE3, and the outer electrode CE32 of the capacitor CAP3, the first contact region CT31 of the active region 310, and the insulating block 342 are substantially the same as those of the inner electrode CE1, the dielectric film DE, and the outer electrode CE2 of the capacitor CAP, the first contact region CT1 of the active region 110, and the insulating block 142, which are described with reference to FIGS. 1A and 1B, respectively.

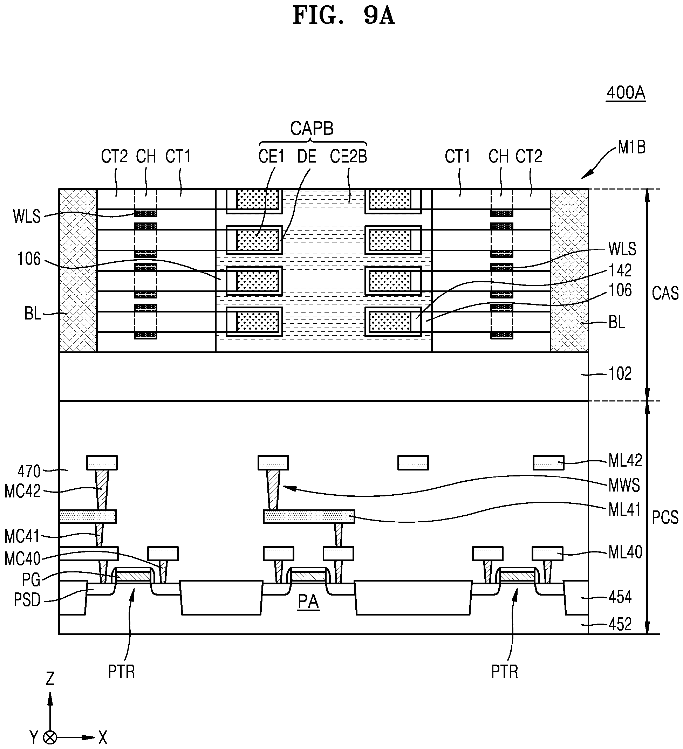

FIG. 9A is a cross-sectional view illustrating a semiconductor memory device 400A according to some example embodiments. In FIG. 9A, the same reference numerals as in FIGS. 3A, 3B, and 3C respectively denote the same members, and here, repeated descriptions thereof are omitted.

Referring to FIG. 9A, the semiconductor memory device 400A includes a cell array structure CAS, which includes a memory cell array M1B, and a peripheral circuit structure PCS overlapping the cell array structure CAS in the vertical direction (the Z direction). The memory cell array M1B of the cell array structure CAS may have substantially the same configuration as described with reference to FIGS. 3A, 3B, and 3C.

The peripheral circuit structure PCS may include a plurality of circuits on a peripheral circuit substrate 452, and a multilayered wiring structure MWS for connecting the plurality of circuits to each other or connecting the plurality of circuits to conductive components of the cell array structure CAS.

In the peripheral circuit substrate 452, a peripheral active region PA may be defined by a device isolation film 454. A plurality of peripheral transistors PTR may be formed on the peripheral active region PA of the peripheral circuit substrate 452. Each of the plurality of peripheral transistors PTR may include a peripheral gate PG and source/drain regions PSD formed in the peripheral active region PA on both sides of the peripheral gate PG. In some embodiments, the peripheral circuit structure PCS may further include unit elements, such as a resistor, a capacitor, and the like. An interlayer dielectric layer 470 may be arranged on the plurality of peripheral transistors PTR. The interlayer dielectric layer 470 may include a silicon oxide film, a silicon nitride film, a SiON film, a SiOCN film, or a combination thereof.

In the peripheral circuit structure PCS, the multilayered wiring structure MWS may include a plurality of peripheral circuit wiring layers ML40, ML41, and ML42 and a plurality of peripheral circuit contacts MC40, MC41, and MC42. Some of the plurality of peripheral circuit wiring layers ML40, ML41, and ML42 may be configured to be electrically connected to the plurality of peripheral transistors PTR. The plurality of peripheral circuit contacts MC40, MC41, and MC42 may be configured to connect some of the plurality of peripheral circuit wiring layers ML40, ML41, and ML42 to each other. The plurality of peripheral circuit wiring layers ML40, ML41, and ML42 and the plurality of peripheral circuit contacts MC40, MC41, and MC42 may be covered by the interlayer dielectric layer 470.

Each of the plurality of peripheral circuit wiring layers ML40, ML41, and ML42 and the plurality of peripheral circuit contacts MC40, MC41, and MC42 may include a metal, a conductive metal nitride, a metal silicide, or a combination thereof. For example, each of the plurality of peripheral circuit wiring layers ML40, ML41, and ML42 and the plurality of peripheral circuit contacts MC40, MC41, and MC42 may include a conductive material, such as tungsten, molybdenum, titanium, cobalt, tantalum, nickel, tungsten silicide, titanium silicide, cobalt silicide, tantalum silicide, or nickel silicide. Although FIG. 9A illustrates an example in which the plurality of peripheral circuit wiring layers ML40, ML41, and ML42 have a wiring structure including three layers in the vertical direction (the Z direction), the inventive concept is not limited to the example shown in FIG. 9A. For example, the plurality of peripheral circuit wiring layers ML40, ML41, and ML42 may have a wiring structure including multiple layers, such as two layers or four or more layers.

In some embodiments, each of the plurality of word lines WL (see FIG. 3B) and the plurality of bit lines BL, which are included in the memory cell array M1B of the cell array structure CAS, may be configured to be connected to one peripheral circuit wiring layer selected from the plurality of peripheral circuit wiring layers ML40, ML41, and ML42 of the peripheral circuit structure PCS.

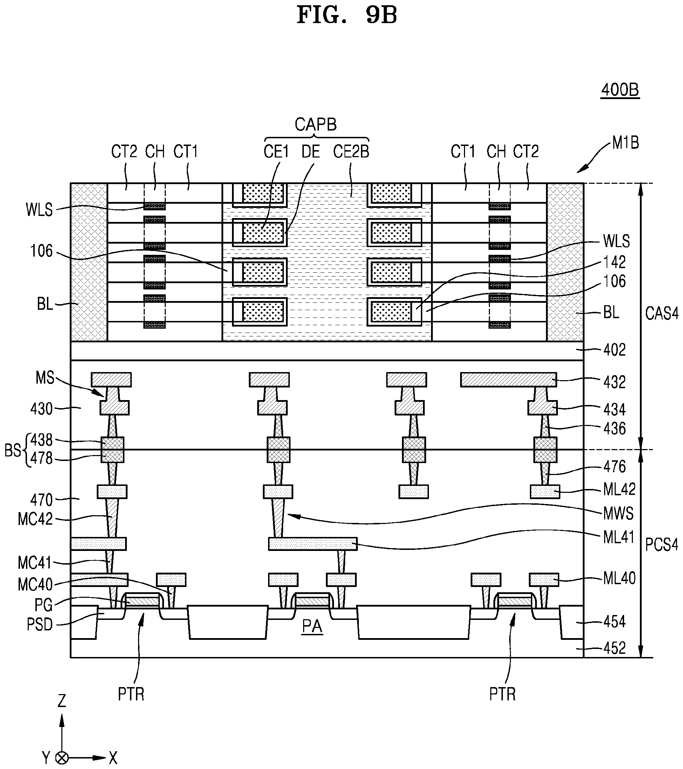

FIG. 9B is a cross-sectional view illustrating a semiconductor memory device 400B according to some example embodiments. In FIG. 9B, the same reference numerals as in FIGS. 3A, 3B, and 3C respectively denote the same members, and here, repeated descriptions thereof are omitted.

Referring to FIG. 9B, the semiconductor memory device 400B includes a cell array structure CAS4, which includes a memory cell array M1B, and a peripheral circuit structure PCS4 overlapping the cell array structure CAS4 in the vertical direction (the Z direction). The memory cell array M1B of the cell array structure CAS4 may have substantially the same configuration as described with reference to FIGS. 3A, 3B, and 3C.

In some embodiments, the semiconductor memory device 400B may have a chip-to-chip (C2C) structure. To form the C2C structure, the cell array structure CAS4 including the memory cell array M1B may be formed on a first wafer, followed by forming the peripheral circuit structure PCS4 on a second wafer that is different from the first wafer, and then, the cell array structure CAS4 and the peripheral circuit structure PCS4 may be connected to each other by a bonding method. The bonding method may refer to a method of bonding a first bonding metal pad 438 of the cell array structure CAS4 to a second bonding metal pad 478 of the peripheral circuit structure PCS4 such that the first bonding metal pad 438 and the second bonding metal pad 478 may be electrically connected to each other. The first bonding metal pad 438 and the second bonding metal pad 478 may constitute a bonding structure BS.

In some embodiments, when each of the first bonding metal pad 438 and the second bonding metal pad 478 of the bonding structure BS includes copper (Cu), the bonding method may be referred to as a Cu-Cu bonding method. In some embodiments, each of the first bonding metal pad 438 and the second bonding metal pad 478 of the bonding structure BS may include aluminum (Al) or tungsten (W).

The peripheral circuit structure PCS4 may have substantially the same configuration as the peripheral circuit structure PCS described with reference to FIG. 9A. Circuits of the peripheral circuit structure PCS4 may be connected to conductive regions of the cell array structure CAS4 via the multilayered wiring structure MWS and the bonding structure BS.

In the cell array structure CAS4, the lower surface of the memory cell array M1B, which faces the peripheral circuit structure PCS4, may be covered by a capping insulating film 402. The capping insulating film 402 may include a silicon oxide film, a silicon nitride film, or a combination thereof. A wiring structure MS may be arranged between the capping insulating film 402 and a plurality of bonding structures BS. The wiring structure MS may include a first wiring layer 432, a second wiring layer 434, and a third wiring layer 436. Each of the first wiring layer 432, the second wiring layer 434, and the third wiring layer 436 may include a metal or a conductive metal nitride. For example, each of the first wiring layer 432, the second wiring layer 434, and the third wiring layer 436 may include, but is not limited to, W, Al, Mo, Ru, Al, Co, Ti, TiN, Ta, TaN, WN, or a combination thereof.

In the cell array structure CAS4, each of the first wiring layer 432, the second wiring layer 434, and the third wiring layer 436 may be covered by an interlayer dielectric layer 430. The interlayer dielectric layer 430 may include a silicon oxide film, a silicon nitride film, or a combination thereof.

In the peripheral circuit structure PCS4, a plurality of second bonding metal pads 478 may be configured to be connected to the multilayered wiring structure MWS via an upper wiring layer 476 and to be connected to a plurality of circuits of the peripheral circuit structure PCS4 via the multilayered wiring structure MWS. Each of the plurality of word lines WL (see FIG. 3B) and the plurality of bit lines BL, which are included in the memory cell array M1B of the cell array structure CAS4, may be configured to be connected to one peripheral circuit wiring layer selected from the plurality of peripheral circuit wiring layers ML40, ML41, and ML42, which are included in the peripheral circuit structure PCS4, via the wiring structure MS and the bonding structure BS.

Similar to semiconductor memory devices 400A and 400B, semiconductor memory devices 100, 100A, 100B, 100C, 100D, 200, 200A, 300 may also include a peripheral circuit structure overlapping the memory cell array in the vertical direction.

Each of the semiconductor memory devices 100A, 100B, 100C, 100D, 200, 200A, 300, 400A, and 400B described with reference to FIGS. 2A to 9B includes a memory cell array having a 3-dimensional structure and including a plurality of memory cells repeatedly arranged in the horizontal direction and the vertical direction, similar to the semiconductor memory device 100 described with reference to FIGS. 1A, 1B, and 1C, and each of the plurality of memory cells includes two transistors and one capacitor. In each of the plurality of memory cells, because the one capacitor does not include a separate plate electrode unlike a general capacitor structure, noise in the plate electrode, which is prone to be generated in a general capacitor structure, may be fundamentally removed, whereby the capacitance of a capacitor may be increased, and thus, the sensing margin of a semiconductor memory device may improve. In addition, the two transistors of each of the plurality of memory cells, which are included in each of the semiconductor memory devices 100A, 100B, 100C, 100D, 200, 200A, 300, 400A, and 400B, may share one word line. Furthermore, the area occupied by the capacitor and the word line in the memory cell array, which is included in each of the semiconductor memory devices 100A, 100B, 100C, 100D, 200, 200A, 300, 400A, and 400B, may be minimized, and the area occupied by each of the plurality of memory cells may be constant in the horizontal direction and/or the vertical direction. Therefore, the plurality of memory cells may be effectively arranged in the memory cell array of each of the semiconductor memory devices 100A, 100B, 100C, 100D, 200, 200A, 300, 400A, and 400B such that the area occupied by the plurality of memory cells is minimized, and the performance of each of the semiconductor memory devices 100A, 100B, 100C, 100D, 200, 200A, 300, 400A, and 400B may improve even without inefficiently increasing the area occupied by the plurality of memory cells.

Next, a method of fabricating a semiconductor memory device, according to some embodiments, is described in detail by taking a specific example.

FIGS. 10A to 44C are diagrams illustrating a method of fabricating a semiconductor memory device, according to some example embodiments. More specifically, FIG. 10A, FIG. 11A, FIG. 12A, FIG. 13A, FIG. 14A, FIG. 15A, FIG. 16A, FIG. 17A, FIG. 18A, FIG. 19A, FIG. 20A, FIG. 21A, FIG. 22A, FIG. 23A, FIG. 24A, FIG. 25A, FIG. 26A, FIG. 27A, FIG. 28A, FIG. 29A, FIG. 30A, FIG. 31A, FIG. 32A, FIG. 33A, FIG. 34A, FIG. 35A, FIG. 36A, FIG. 37A, FIG. 38A, FIG. 39A, FIG. 40A, FIG. 41A, FIG. 42A, FIG. 43A, and FIG. 44A are perspective views respectively illustrating a sequence of processes of the method of fabricating a semiconductor memory device, according to some embodiments. FIG. 10B, FIG. 11B, FIG. 12B, FIG. 14B, FIG. 15B, FIG. 17B, FIG. 18B, FIG. 19B, FIG. 20B, FIG. 21B, FIG. 22B, FIG. 23B, FIG. 24B, FIG. 25B, FIG. 26B, FIG. 27B, FIG. 28B, FIG. 29B, FIG. 30B, FIG. 31B, FIG. 32B, FIG. 33B, FIG. 34B, FIG. 35B, FIG. 36B, FIG. 37B, FIG. 38B, FIG. 40B, FIG. 41B, FIG. 42B, FIG. 43B, and FIG. 44B are transverse cross-sectional views illustrating planar structures at first vertical levels LV1 of FIG. 10A, FIG. 11A, FIG. 12A, FIG. 14A, FIG. 15A, FIG. 17A, FIG. 18A, FIG. 19A, FIG. 20A, FIG. 21A, FIG. 22A, FIG. 23A, FIG. 24A, FIG. 25A, FIG. 26A, FIG. 27A, FIG. 28A, FIG. 29A, FIG. 30A, FIG. 31A, FIG. 32A, FIG. 33A, FIG. 34A, FIG. 35A, FIG. 36A, FIG. 37A, FIG. 38A, FIG. 40A, FIG. 41A, FIG. 42A, FIG. 43A, and FIG. 44A, respectively. FIGS. 10C and 11C are cross-sectional views taken along lines X1-X1' of FIGS. 10A and 11A, respectively. FIG. 12C, FIG. 13B, FIG. 16B, FIG. 17C, FIG. 18C, FIG. 19C, FIG. 20C, FIG. 22C, FIG. 23C, FIG. 25C, FIG. 26C, FIG. 29C, FIG. 30C, FIG. 33C, FIG. 36C, FIG. 37C, FIG. 39B, FIG. 42C, FIG. 43C, and FIG. 44C are cross-sectional views taken along lines X2-X2' of FIG. 12A, FIG. 13A, FIG. 16A, FIG. 17A, FIG. 18A, FIG. 19A, FIG. 20A, FIG. 22A, FIG. 23A, FIG. 25A, FIG. 26A, FIG. 29A, FIG. 30A, FIG. 33A, FIG. 36A, FIG. 37A, FIG. 39A, FIG. 42A, FIG. 43A, and FIG. 44A, respectively. FIG. 10D is a cross-sectional view taken along a line Y1-Y1' of FIGS. 10A and 10B. An example of a method of fabricating the semiconductor memory device 100B shown in FIGS. 3A, 3B, and 3C is described with reference to FIGS. 10A to 44C. In FIGS. 10A to 44C, the same reference numerals as in FIGS. 1A to 3C respectively denote the same members, and here, repeated descriptions thereof are omitted.

Referring to FIGS. 10A, 10B, 10C, and 10D, a plurality of sacrificial layers 104 and a plurality of semiconductor layers 106 may be alternately stacked one-by-one a plurality of times on the substrate 102. The number of pairs of sacrificial layers 104 and semiconductor layers 106 stacked on the substrate 102 corresponds to the number of layers of memory cells implemented on the substrate 102 and may be variously selected as needed. In some embodiments, each of the plurality of sacrificial layers 104 may include a SiGe layer and each of the plurality of semiconductor layers 106 may include a Si layer, but the inventive concept is not limited thereto.

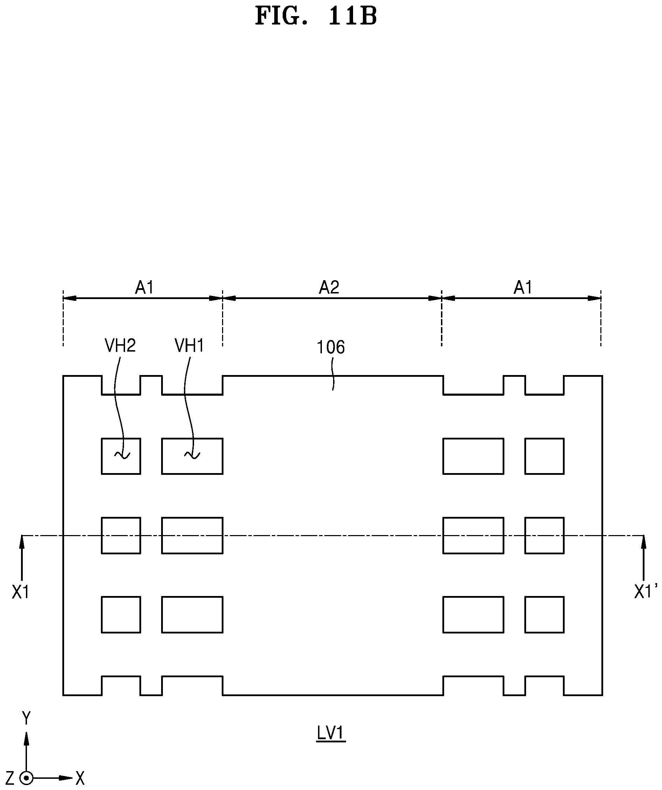

Referring to FIGS. 11A, 11B, and 11C, the resulting product of FIGS. 10A, 10B, 10C, and 10D may be divided into a pair of first areas A1 and a second area A2 between the pair of first areas A1, and some regions in the pair of first areas A1 may be etched, thereby forming a plurality of first vertical holes VH1 and a plurality of second vertical holes VH2, each passing through the plurality of sacrificial layers 104 and the plurality of semiconductor layers 106 in the vertical direction (the Z direction). The plurality of first vertical holes VH1 may be formed adjacent to the second area A2 and may be aligned in a line in the second horizontal direction (the Y direction), and the plurality of second vertical holes VH2 may be formed to be spaced apart from the second area A2 in the first horizontal direction (the X direction) with the plurality of first vertical holes VH1 therebetween, and may be aligned in a line in the second horizontal direction (the Y direction).

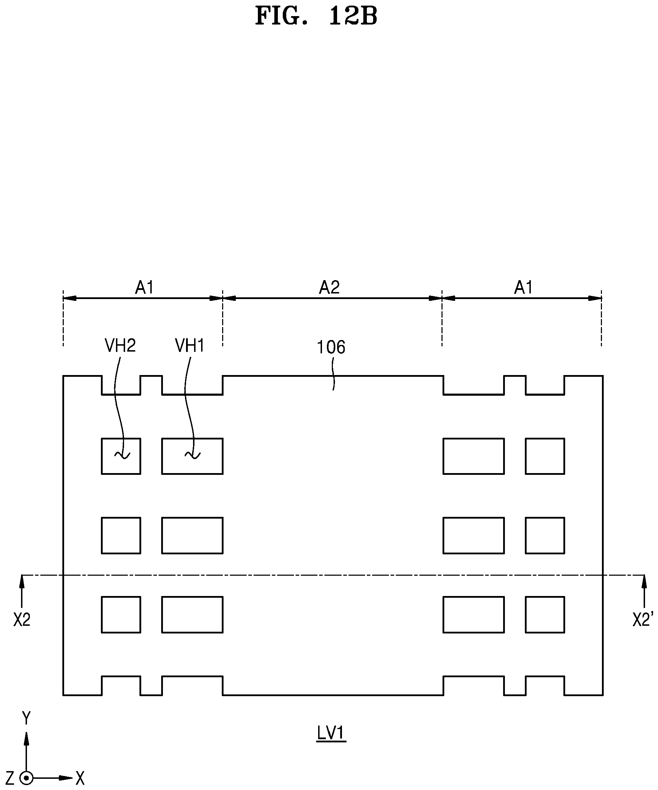

Referring to FIGS. 12A, 12B, and 12C, portions of the plurality of sacrificial layers 104, which are located in the first area A1, may be removed from the resulting product of FIGS. 11A, 11B, and 11C. To remove the portions of the plurality of sacrificial layers 104 as such, a wet-etching process may be used.

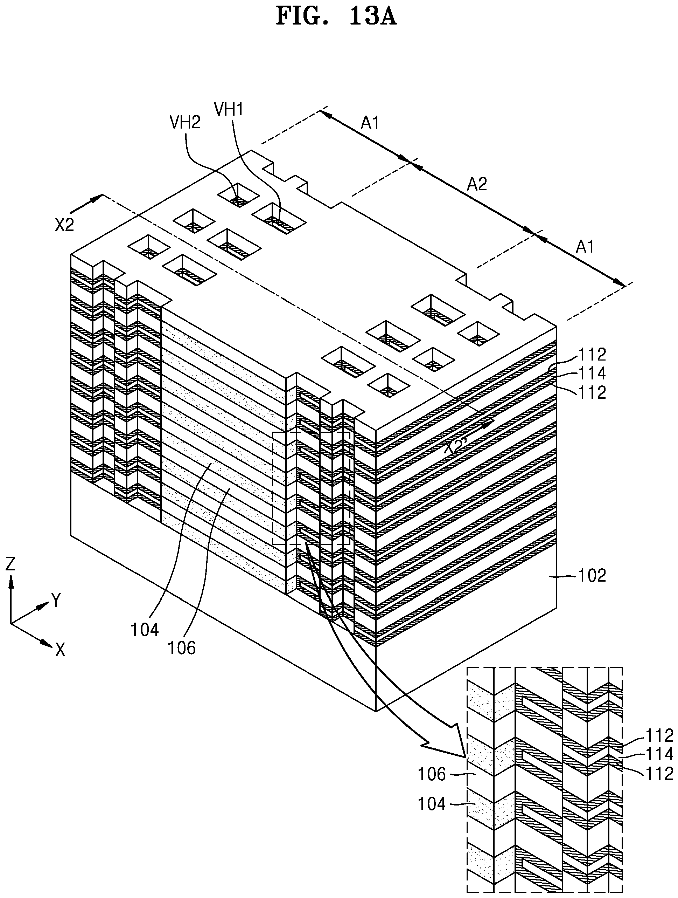

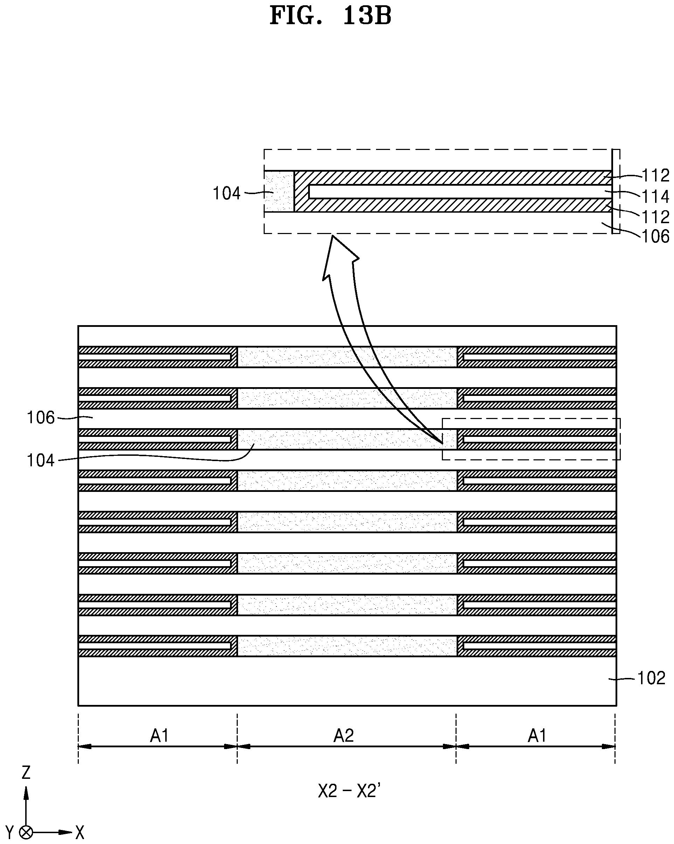

Referring to FIGS. 13A and 13B, in the resulting product of FIGS. 12A, 12B, and 12C, an outer insulating film 112, which conformally covers surfaces exposed in a space between the plurality of semiconductor layers 106 (e.g., adjacent semiconductor layers 106) in the first area A1, and an inner insulating film 114, which fills a space defined by the outer insulating film 112 in the space between the plurality of semiconductor layers 106 (e.g., adjacent semiconductor layers 106), may be formed. To form the outer insulating film 112 and the inner insulating film 114, an atomic layer deposition (ALD) process may be used.

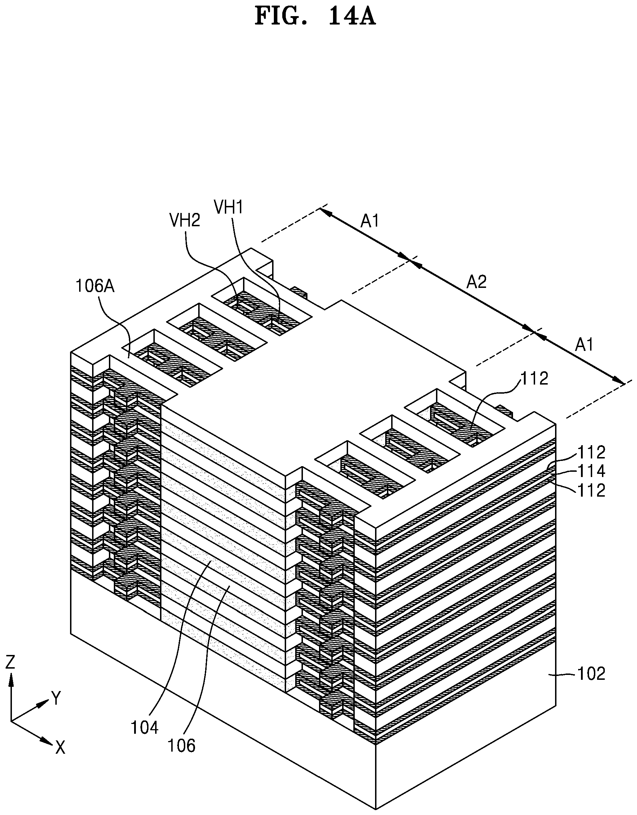

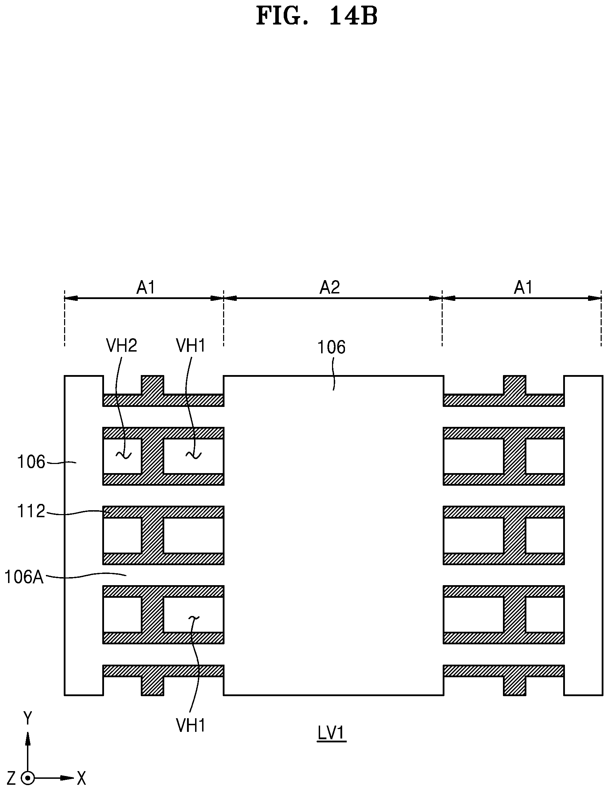

Referring to FIGS. 14A and 14B, in the resulting product of FIGS. 13A and 13B, a thinning process may be performed to reduce the width, in the second horizontal direction (the Y direction), of a portion of each of the plurality of semiconductor layers 106 in the pair of first regions A1, thereby forming a plurality of semiconductor local regions 106A in the portion of each of the plurality of semiconductor layers 106. In some embodiments, to form the plurality of semiconductor local regions 106A, the portion of each of the plurality of semiconductor layers 106 in the pair of first regions A1 may be selectively wet-etched, but the inventive concept is not limited thereto.

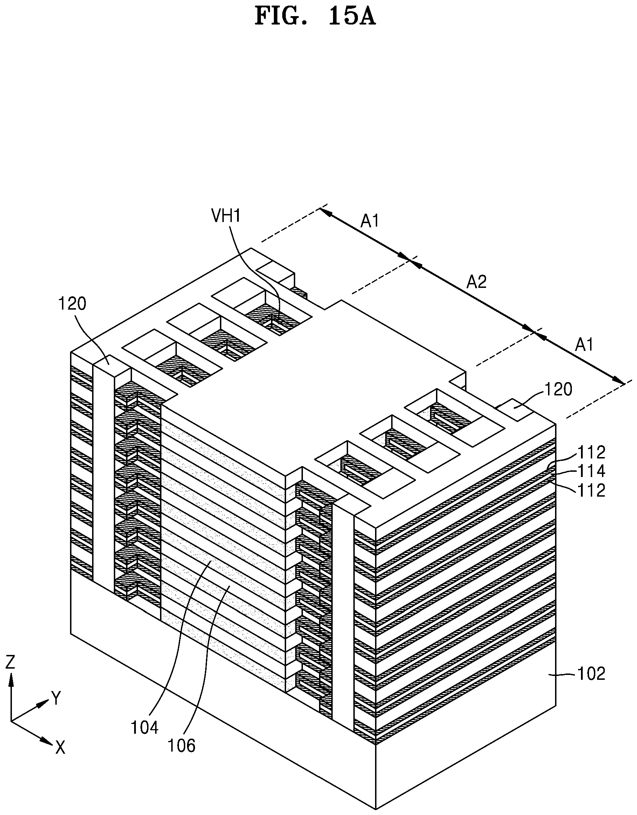

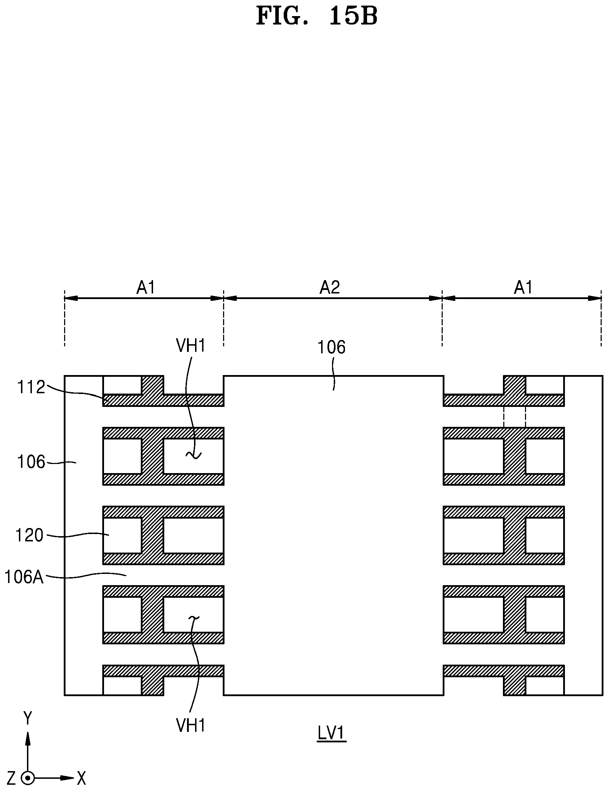

Referring to FIGS. 15A and 15B, in the resulting product of FIGS. 14A and 14B, a plurality of first insulating patterns 120 may be formed to respectively fill the plurality of second vertical holes VH2. After the plurality of first insulating patterns 120 are formed, sidewalls of the plurality of semiconductor layers 106 and respective sidewalls of the outer insulating film 112 and the inner insulating films 114 may be exposed in each of the plurality of first vertical holes VH1 located between each first insulating pattern 120 and the second area A2. In some embodiments, each of the plurality of first insulating patterns 120 may include an oxide film.

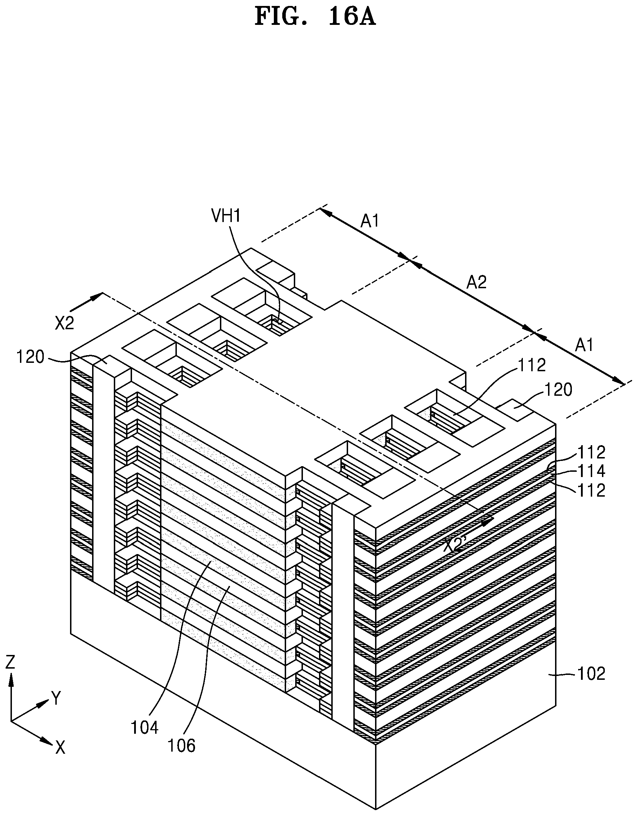

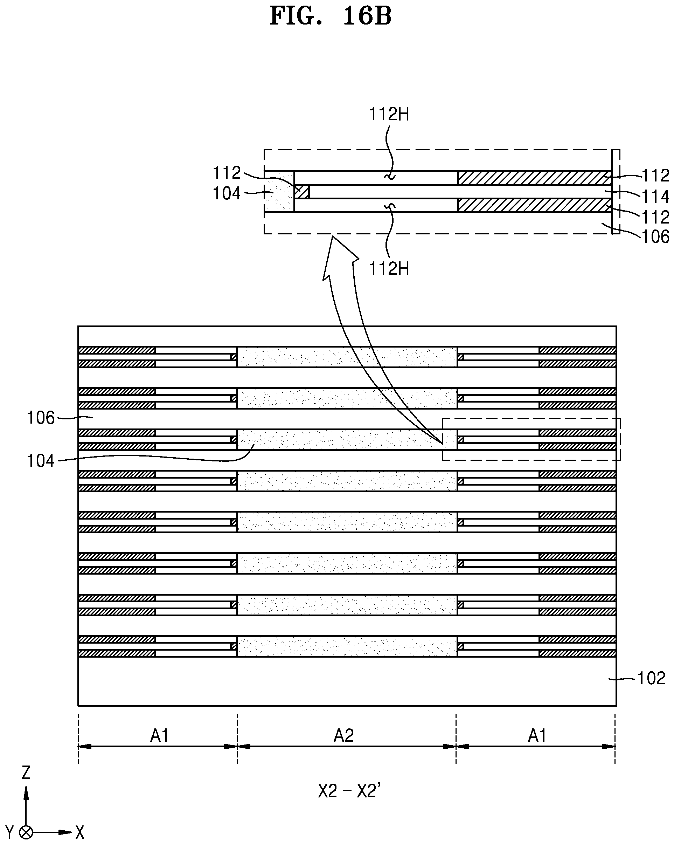

Referring to FIGS. 16A and 16B, a portion of each of the outer insulating films 112 may be removed from the resulting product of FIGS. 15A and 15B through the plurality of first vertical holes VH1, thereby forming a plurality of first spaces 112H. As a result, as shown in FIG. 16B, in each of the pair of first areas A1, two first spaces 112H separated from each other by the inner insulating film 114 may be formed in some regions between two semiconductor layers 106 that are adjacent to each other in the vertical direction (the Z direction). In some embodiments, to remove the portion of each of the outer insulating films 112, a wet-etching process may be used.

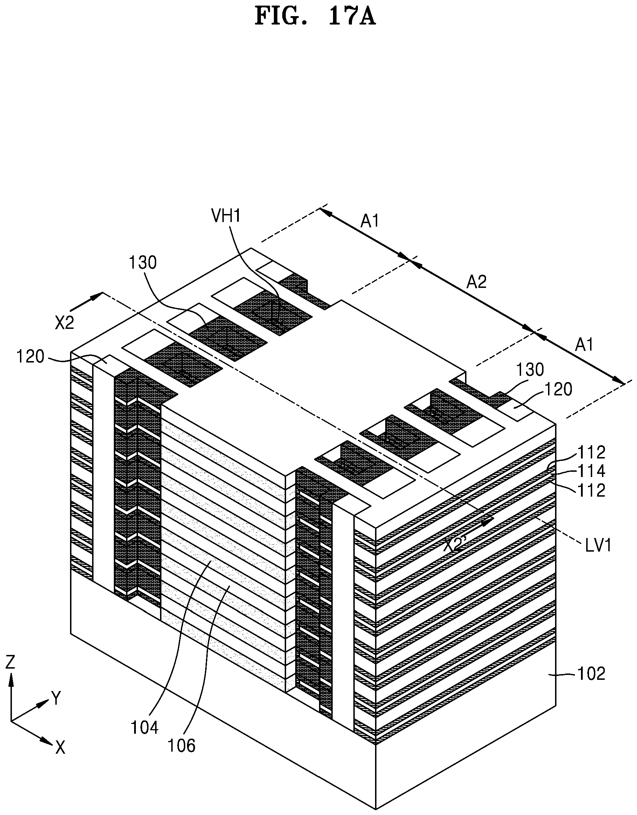

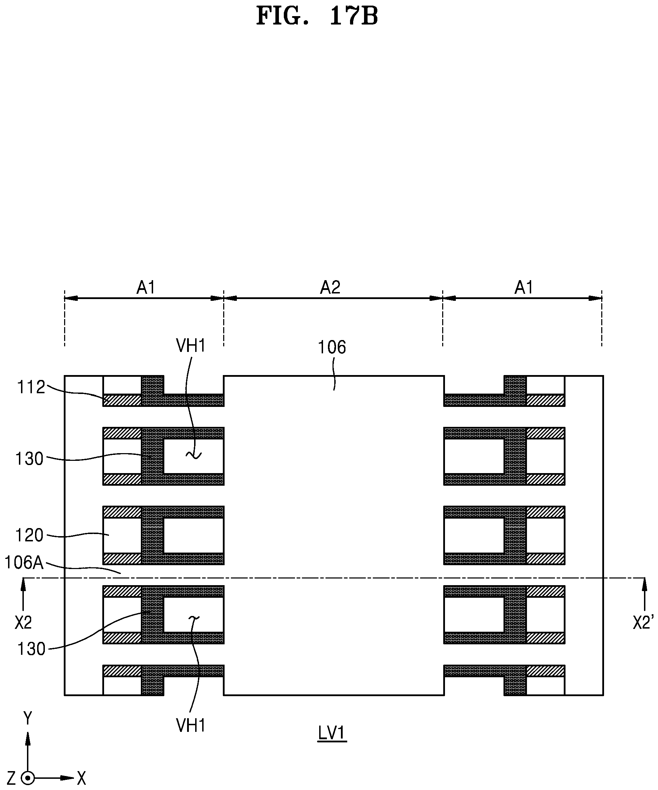

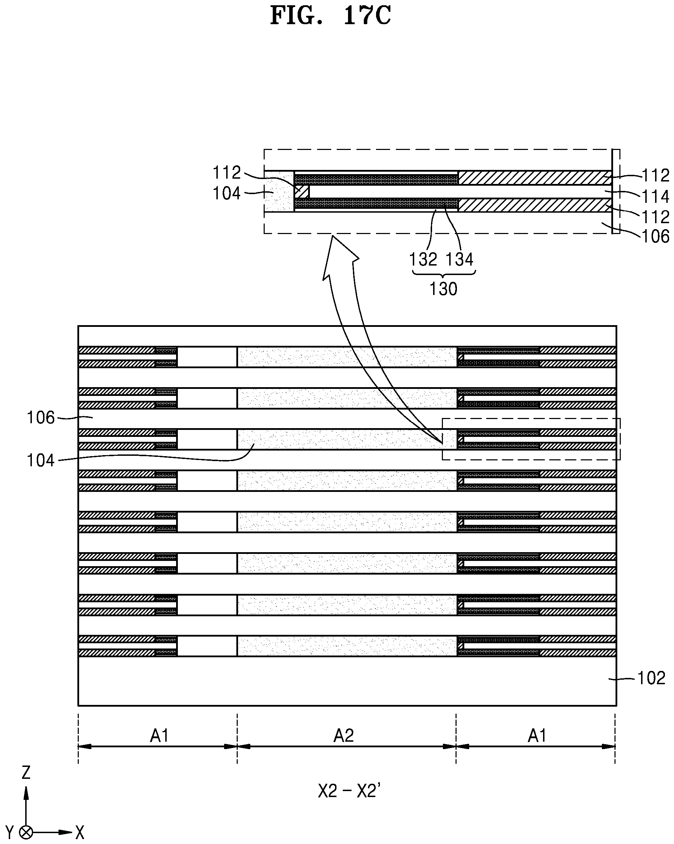

Referring to FIGS. 17A, 17B, and 17C, in the resulting product of FIGS. 16A and 16B, a plurality of preliminary word line structures 130 may be formed to respectively fill the plurality of first spaces 112H. Each of the plurality of preliminary word line structures 130 may include a gate dielectric film 132 contacting a semiconductor layer 106, and a conductive film 134 apart from the semiconductor layer 106 with the gate dielectric film 132 therebetween. A constituent material of the conductive film 134 is the same as the constituent material of the word line WL described with reference to FIGS. 1A and 1B.

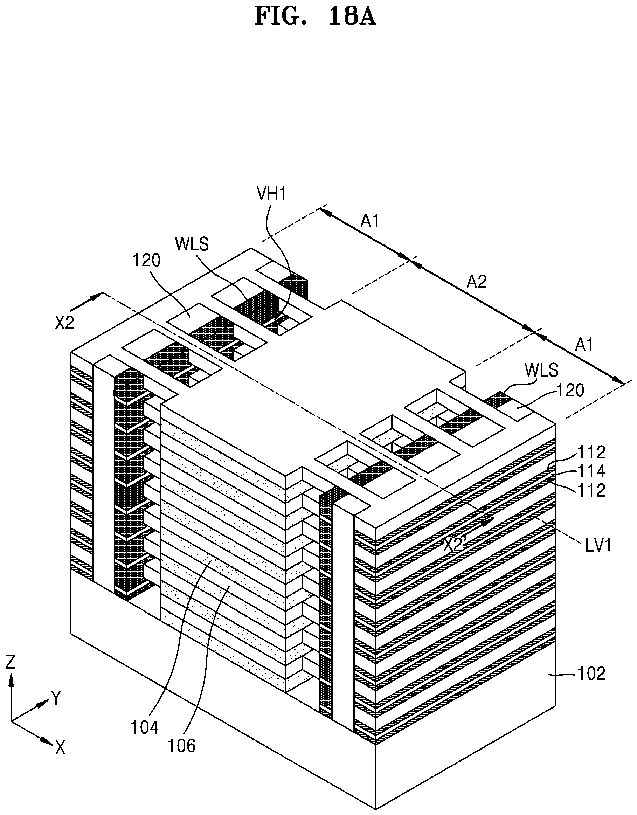

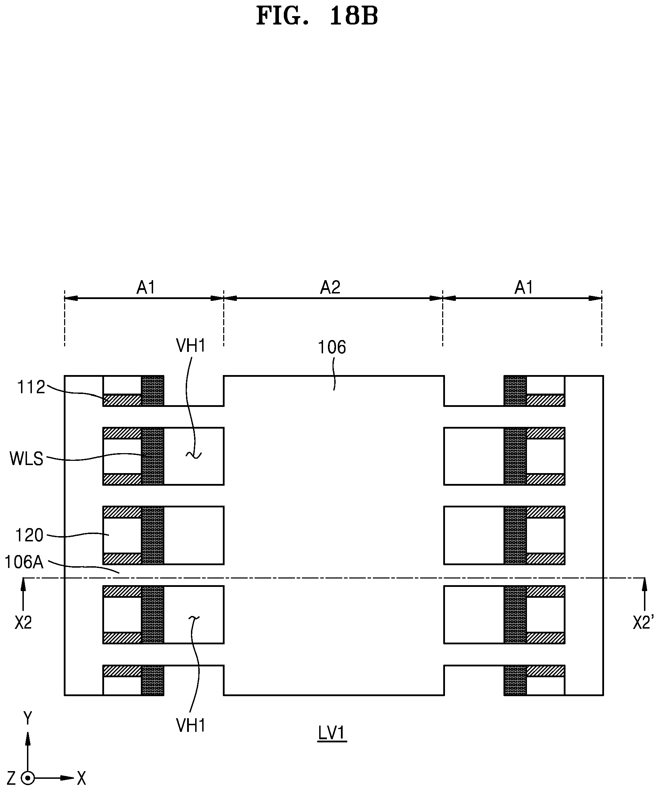

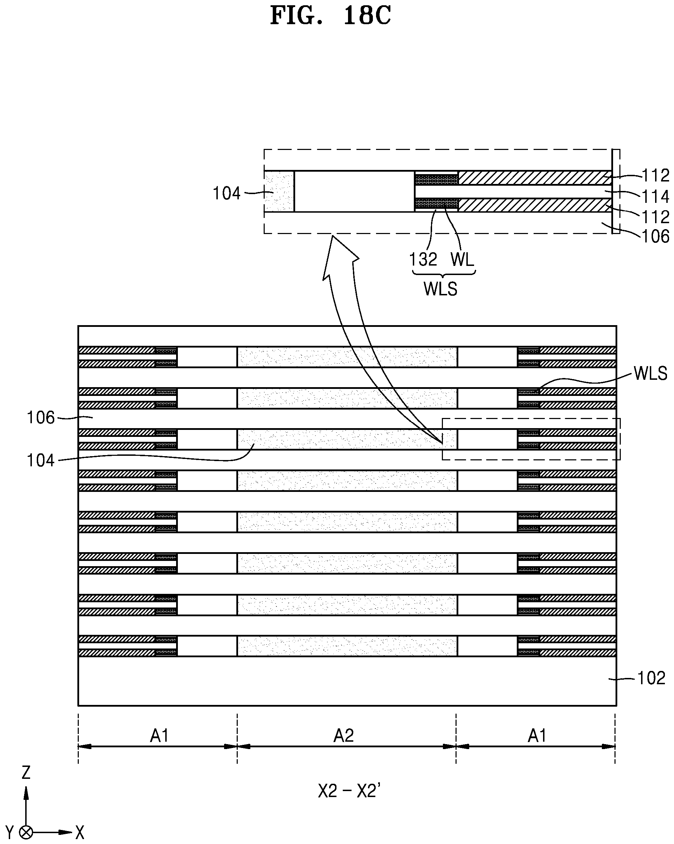

Referring to FIGS. 18A, 18B, and 18C, a portion of each of the plurality of preliminary word line structures 130 and respective portions of the outer insulating film 112 and the inner insulating film 114 adj acent thereto may be removed from the resulting product of FIGS. 17A, 17B, and 17C by a wet-etching process. As a result, a plurality of word line structures WLS may be obtained from the plurality of preliminary word line structures 130. Each of the plurality of word line structures WLS may include a remaining portion of the gate dielectric film 132 and a remaining portion of the conductive film 134. Here, the remaining portion of the conductive film 134 may constitute the word line WL. After the plurality of word line structures WLS are formed, a semiconductor local region 106A, which is a portion of the semiconductor layer 106, may be partially exposed in the vicinity of each of the plurality of word line structures WLS.

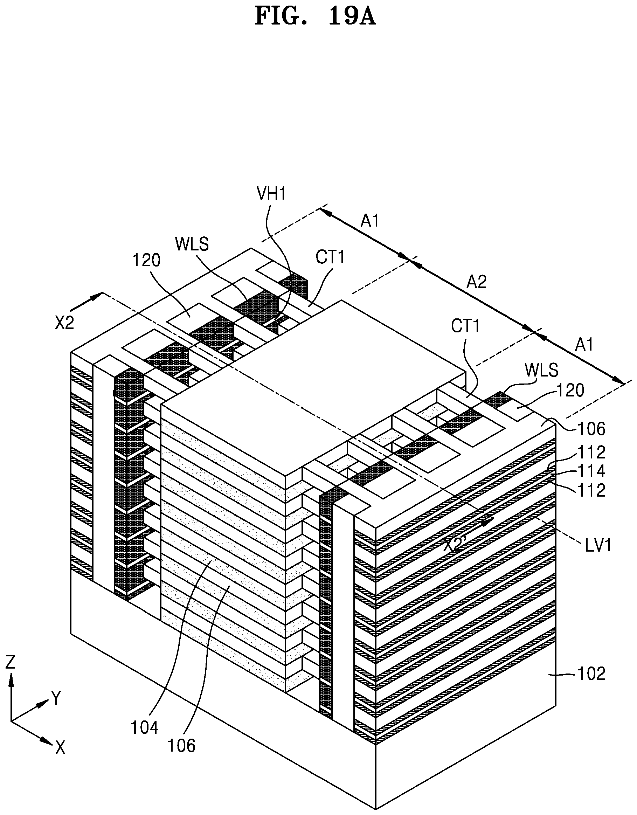

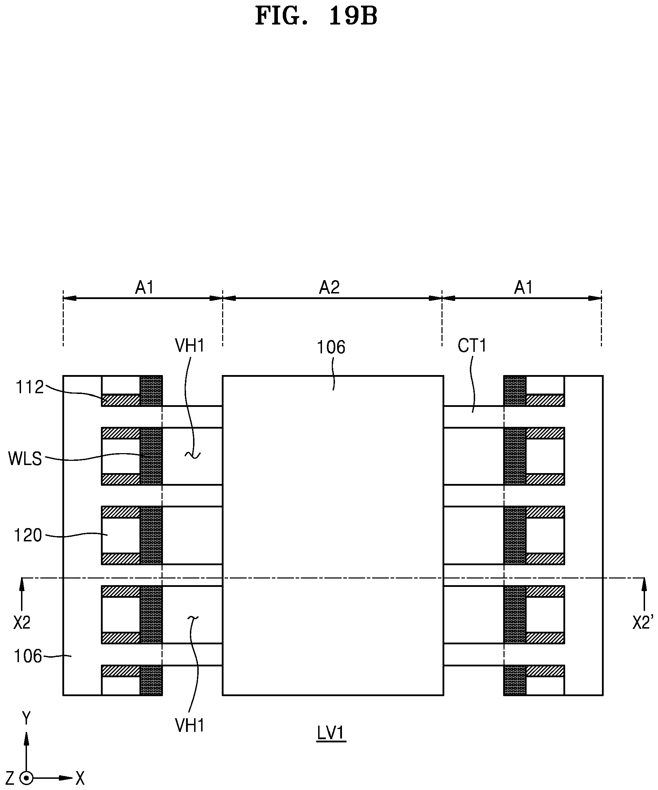

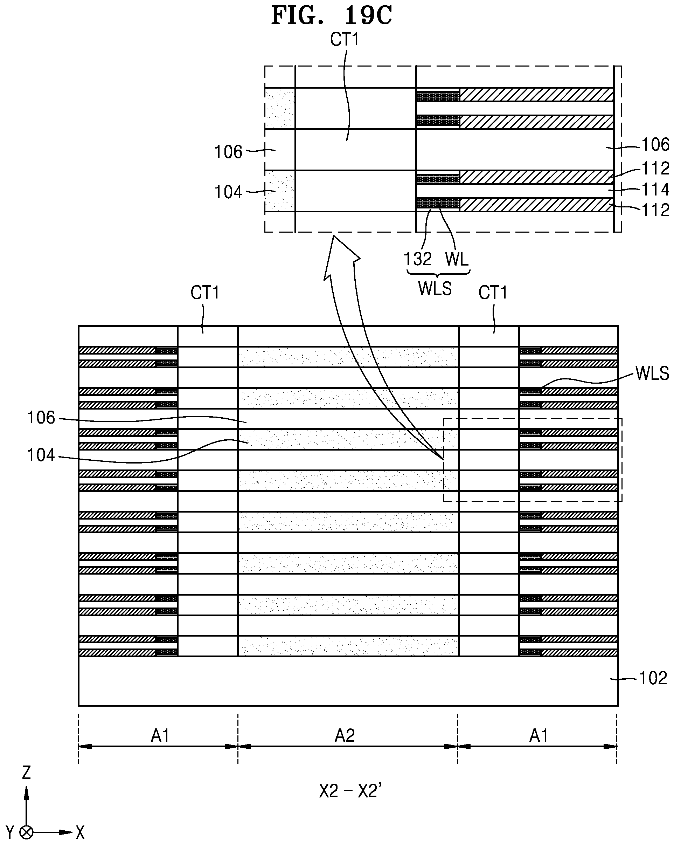

Referring to FIGS. 19A, 19B, and 19C, in the resulting product of FIGS. 18A, 18B, and 18C, the exposed semiconductor local region 106A, which is a portion of each of the plurality of semiconductor layers 106, may be doped with a dopant, thereby forming a plurality of first contact regions CT1. In some embodiments, to form the plurality of first contact regions CT1, the plurality of semiconductor local regions 106A may be doped with an n-type impurity, but the inventive concept is not limited thereto.

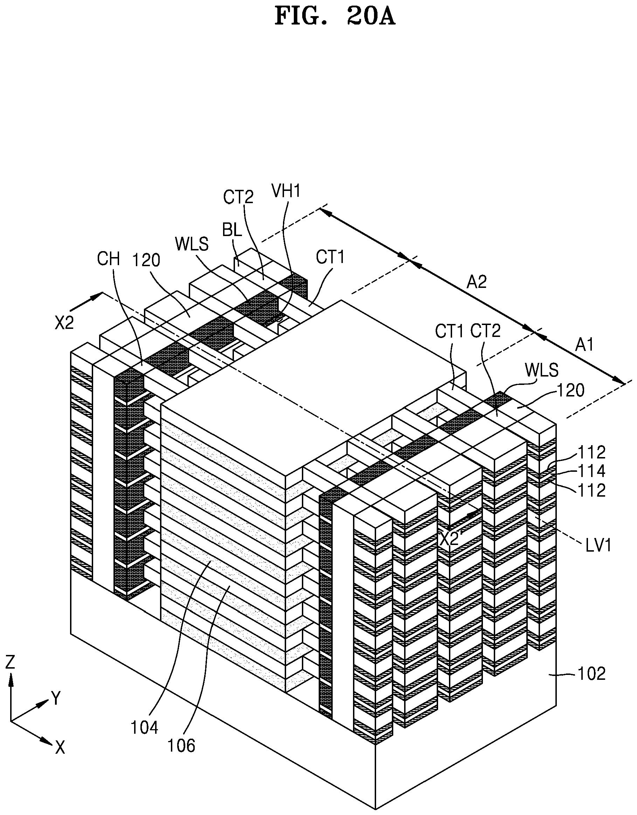

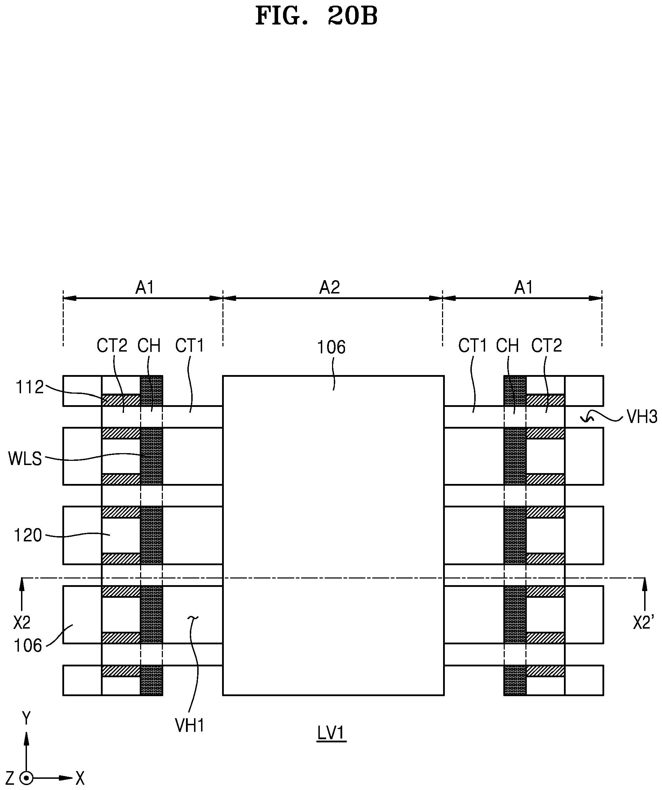

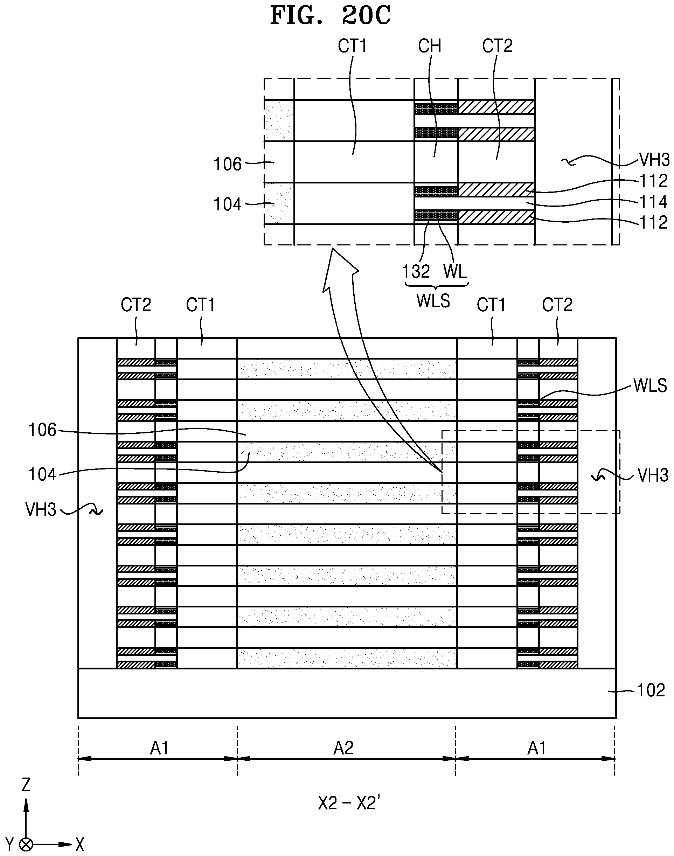

Referring to FIGS. 20A, 20B, and 20C, a portion of a stack structure of the outer insulating films 112, the inner insulating films 114 and the plurality of semiconductor layers 106, which remain in the first area A1, may be removed from the resulting product of FIGS. 19A, 19B, and 19C, thereby forming a plurality of third vertical holes VH3, which extend lengthwise in the vertical direction (the Z direction). The sidewall of the semiconductor local region 106A, which is a portion of each of the plurality of semiconductor layers 106, may be exposed by the plurality of third vertical holes VH3. Each semiconductor local region 106A exposed by the plurality of third vertical holes VH3 may be doped with a dopant, thereby forming a plurality of second contact regions CT2. In some embodiments, to form the plurality of second contact regions CT2, each semiconductor local region 106A exposed by the plurality of third vertical holes VH3 may be doped with an n-type impurity, but the inventive concept is not limited thereto. In some embodiments, after forming the plurality of second contact regions CT2, impurities may be doped into the plurality of semiconductor local regions 106A between the plurality of first contact regions CT1 and the plurality of second contact regions CT2, thereby forming a plurality of channel regions CH.

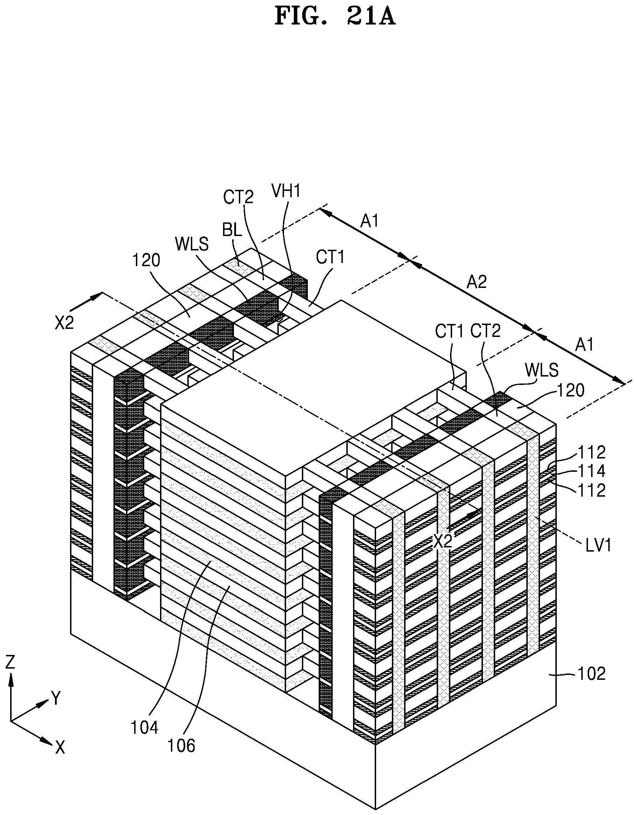

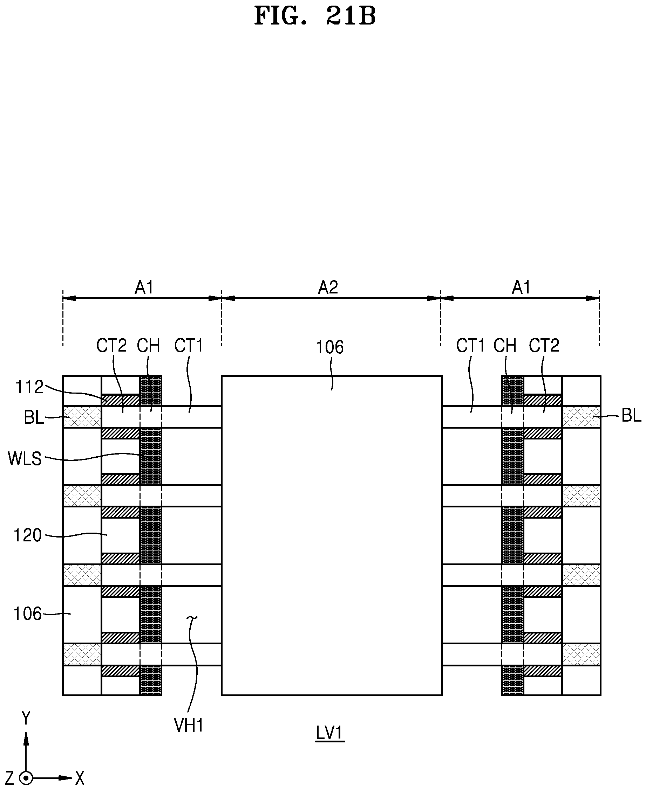

Referring to FIGS. 21A and 21B, in the resulting product of FIGS. 20A, 20B, and 20C, a plurality of bit lines BL may be formed to respectively fill the plurality of third vertical holes VH3 .

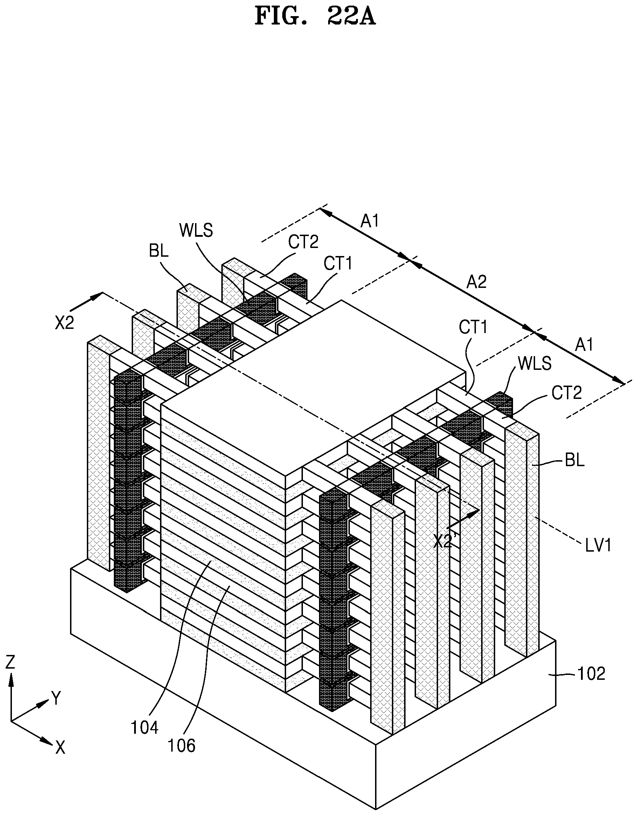

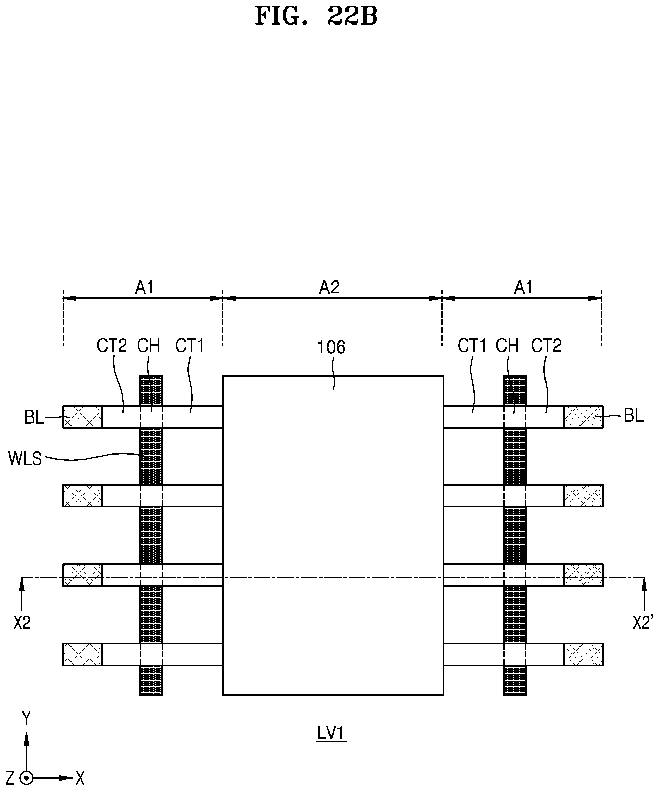

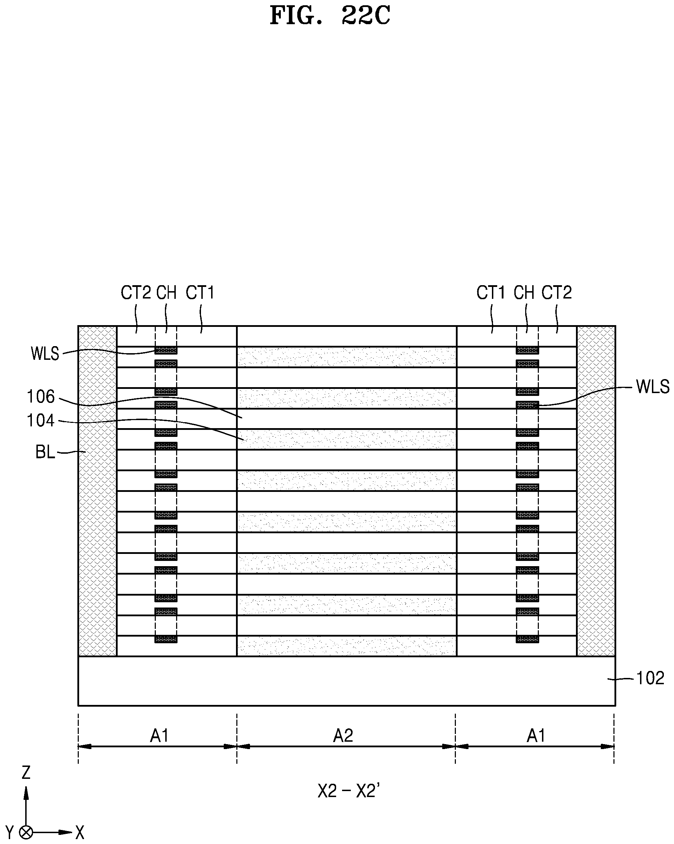

Referring to FIGS. 22A, 22B, and 22C, the plurality of first insulating patterns 120, the plurality of semiconductor layers 106, a plurality of outer insulating films 112, and a plurality of inner insulating films 114, which remain in the first area A1, may be removed from the resulting product of FIGS. 21A and 21B.

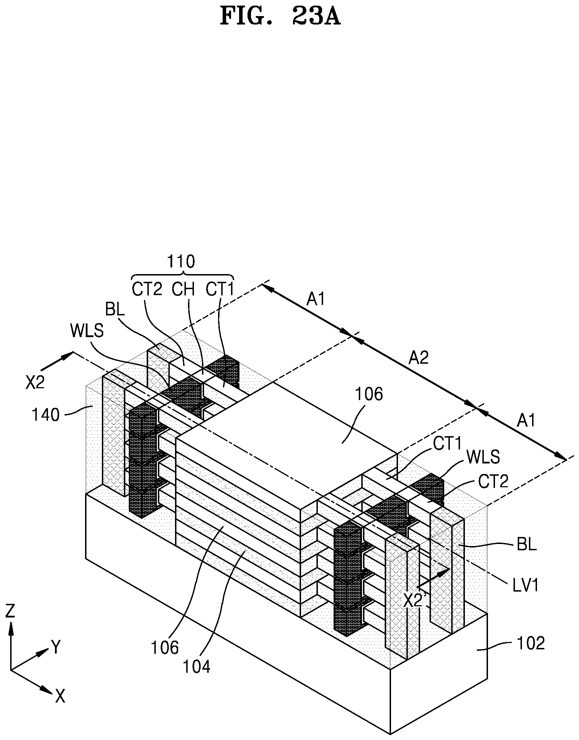

Hereinafter, in FIGS. 23A to 44B, intermediate products according to the sequence of processes are illustrated only regarding a portion of the resulting product of FIGS. 22A, 22B, and 22C to allow main portions in processes described below to be clearly shown, and subsequent processes are described in detail with reference to the intermediate products illustrated as such. However, the processes described below may also be equally applied to other portions omitted from FIGS. 23A to 44B.

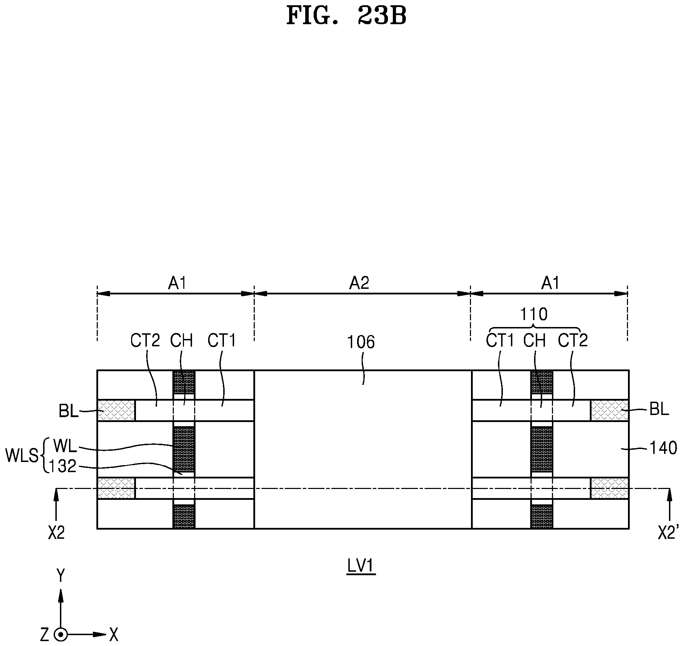

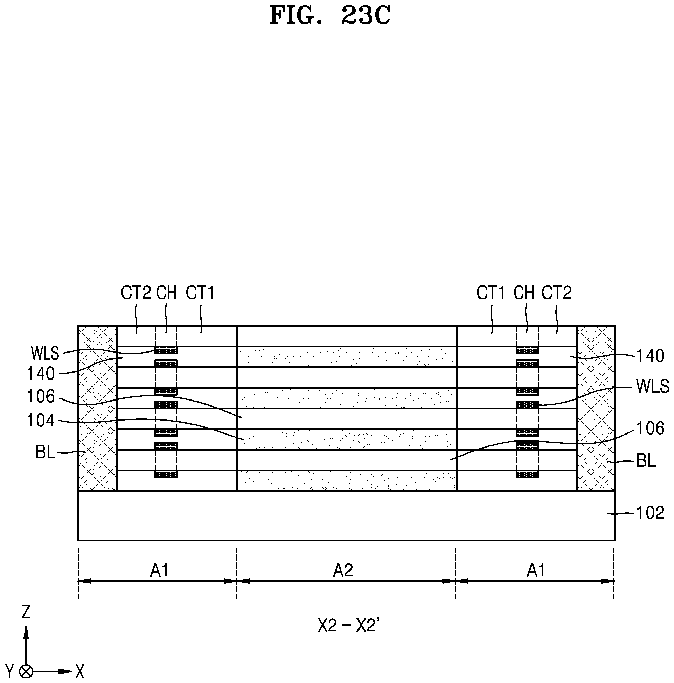

Referring to FIGS. 23A, 23B, and 23C, in the resulting product of FIGS. 22A, 22B, and 22C, a plurality of second insulating patterns 140 may be formed to respectively fill empty spaces in the first area A1. In some embodiments, each of the plurality of second insulating patterns 140 may include an oxide film.

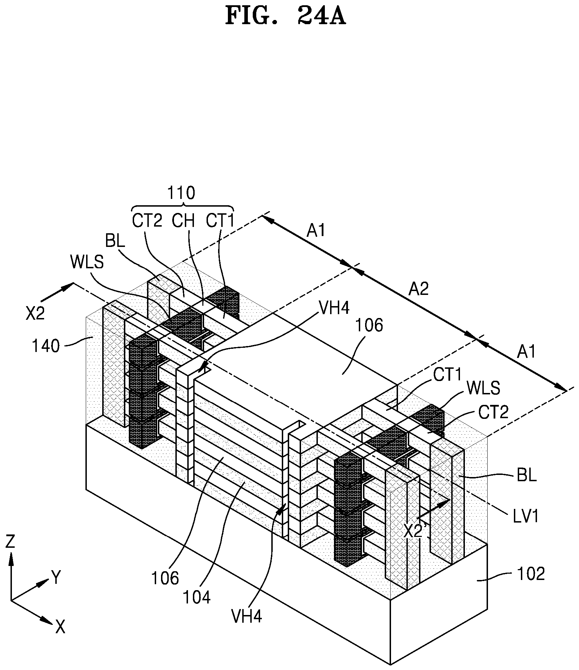

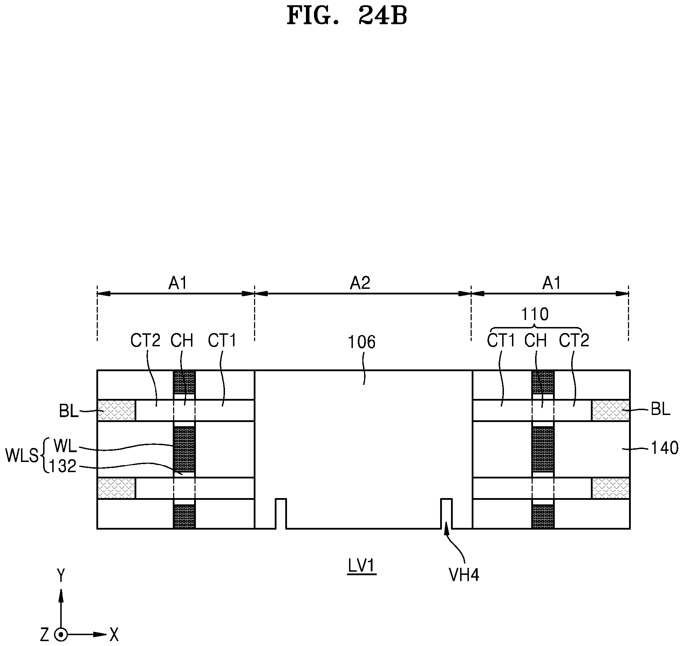

Referring to FIGS. 24A and 24B, a portion of the stack structure of the plurality of sacrificial layers 104 and the plurality of semiconductor layers 106, which remain in the second area A2, may be removed from the resulting product of FIGS. 23A, 23B, and 23C, thereby forming a plurality of fourth vertical holes VH4, which extend lengthwise in the vertical direction (the Z direction). In the second area A2, one fourth vertical hole VH4 may be formed in every region in which one memory cell is formed.

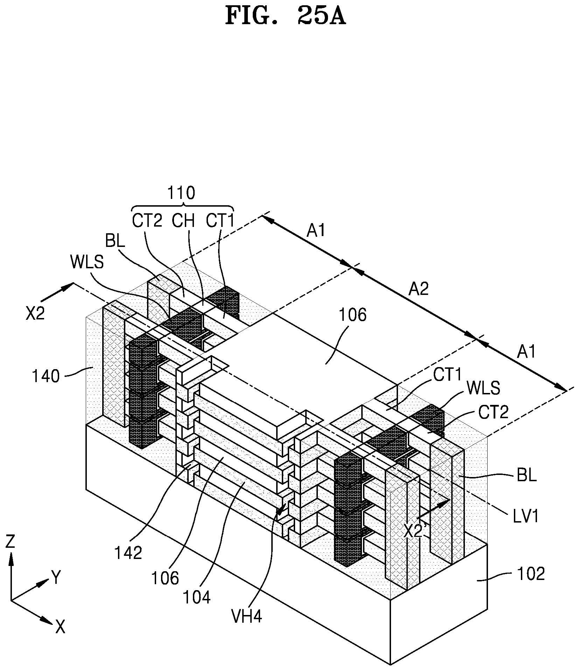

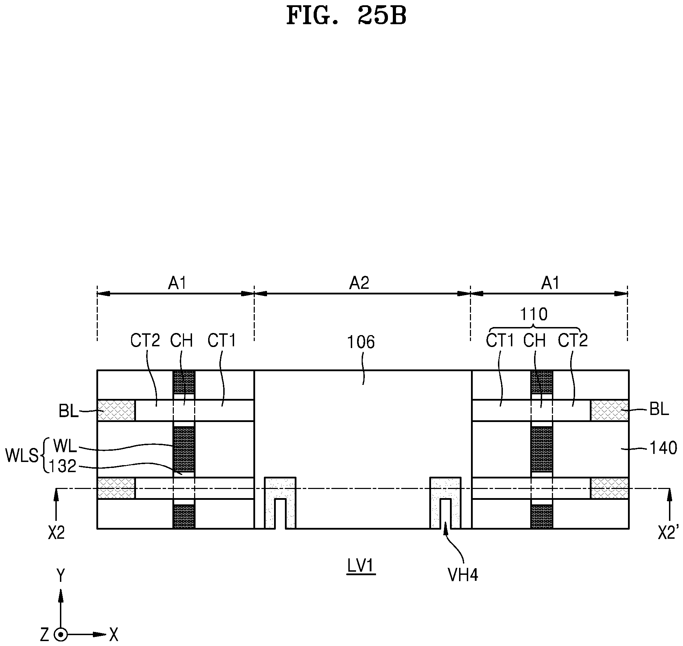

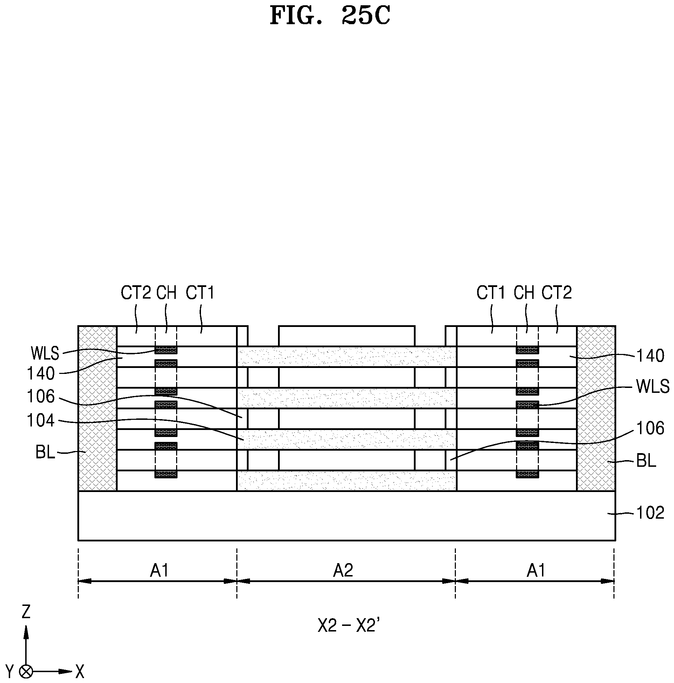

Referring to FIGS. 25A, 25B, and 25C, in the resulting product of FIGS. 24A and 24B, a portion of each of the plurality of semiconductor layers 106 may be wet-etched through the plurality of fourth vertical holes VH4. As a result, the width of each of the plurality of fourth vertical holes VH4 may be expanded in the horizontal direction (for example, the X direction and the Y direction) at vertical levels at which the plurality of semiconductor layers 106 are arranged over the substrate 102.

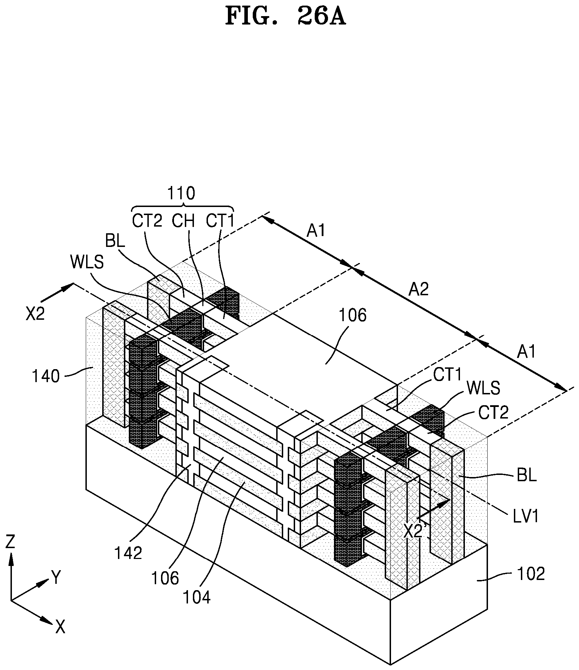

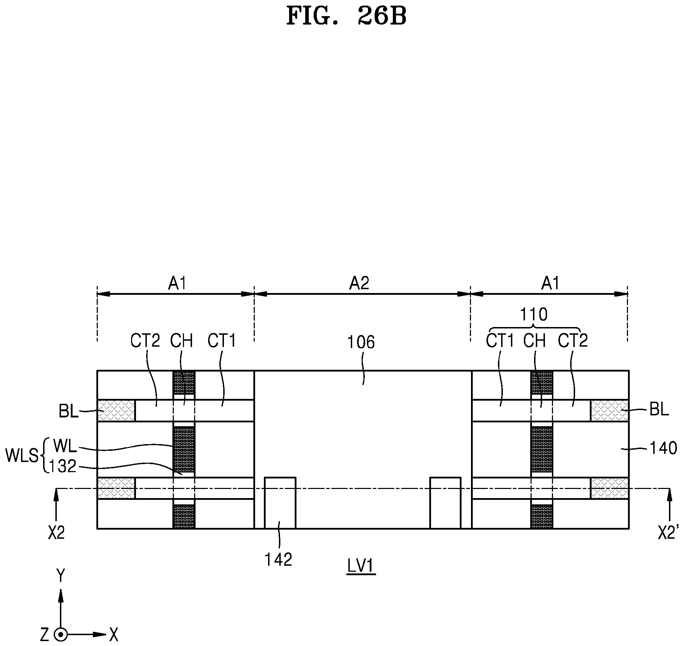

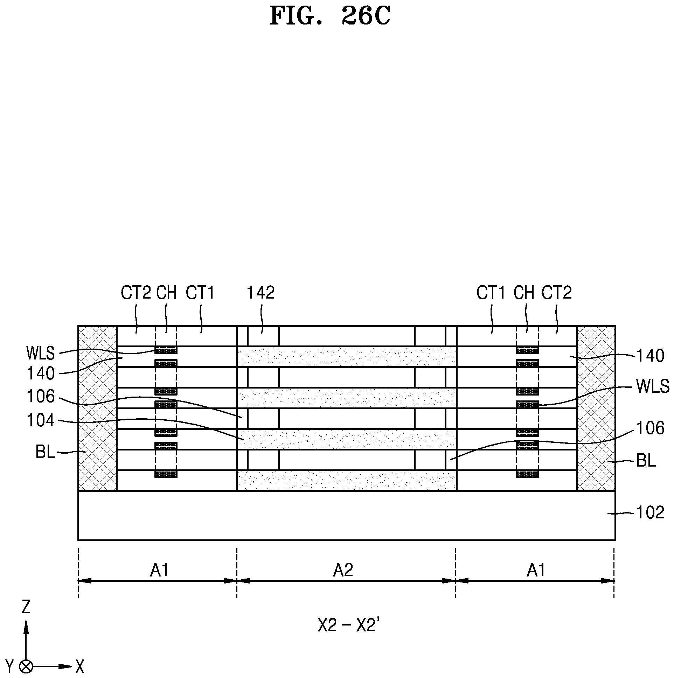

Referring to FIGS. 26A, 26B, and 26C, in the resulting product of FIGS. 25A, 25B, and 25C, a plurality of insulating blocks 142 may be formed to respectively fill the plurality of fourth vertical holes VH4.

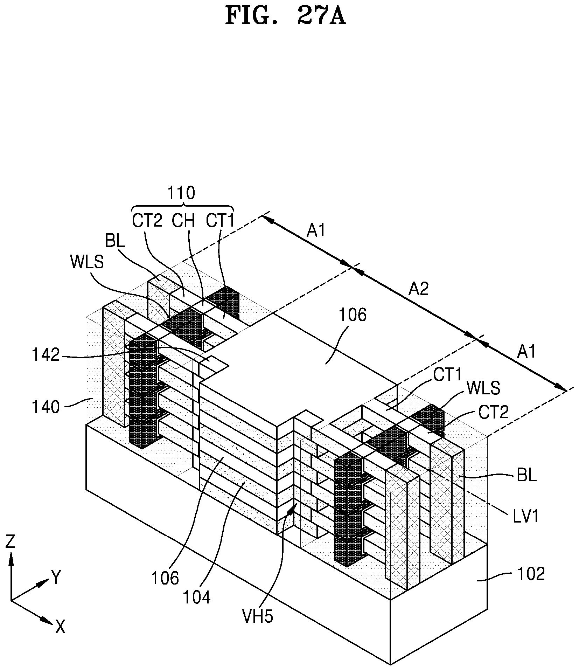

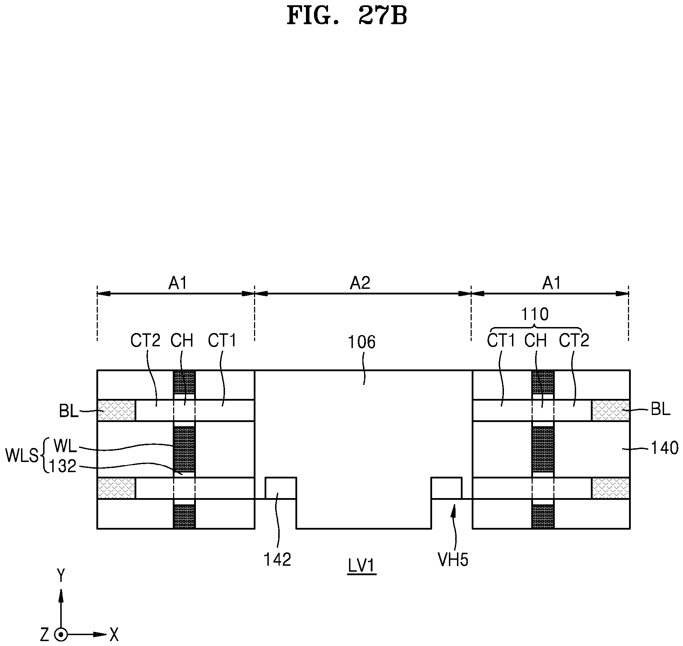

Referring to FIGS. 27A and 27B, a portion, which is between the insulating block 142 and the second insulating pattern 140, of the stack structure of the plurality of sacrificial layers 104 and the plurality of semiconductor layers 106, which remain in the second area A2, and a portion of the insulating block 142 may be removed by a dry-etching process. As a result, the width of each of the plurality of insulating blocks 142 may be equal or similar to the width of the first contact region CT1, in the second horizontal direction (the Y direction), and a plurality of fifth vertical holes VH5 may be formed to respectively expose remaining portions of the plurality of insulating blocks 142.

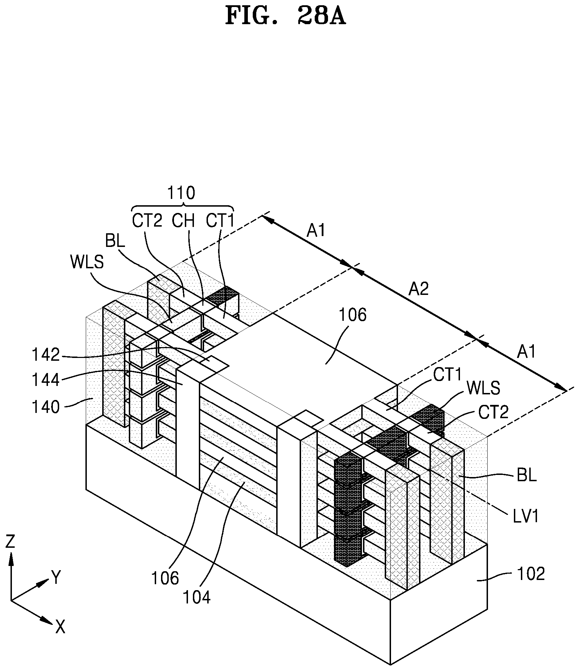

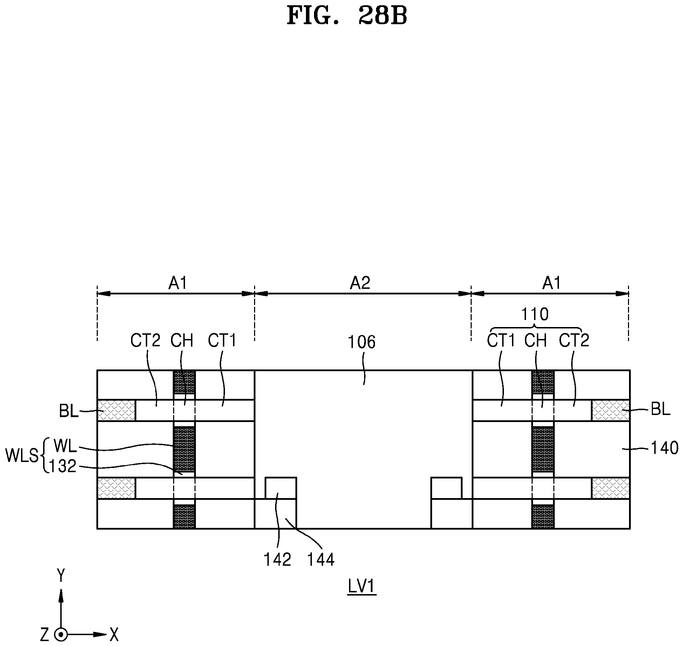

Referring to FIGS. 28A and 28B, in the resulting product of FIGS. 27A and 27B, a plurality of third insulating patterns 144 may be formed to respectively fill the plurality of fifth vertical holes VH5. In some embodiments, each of the plurality of third insulating patterns 144 may include a silicon oxide film.

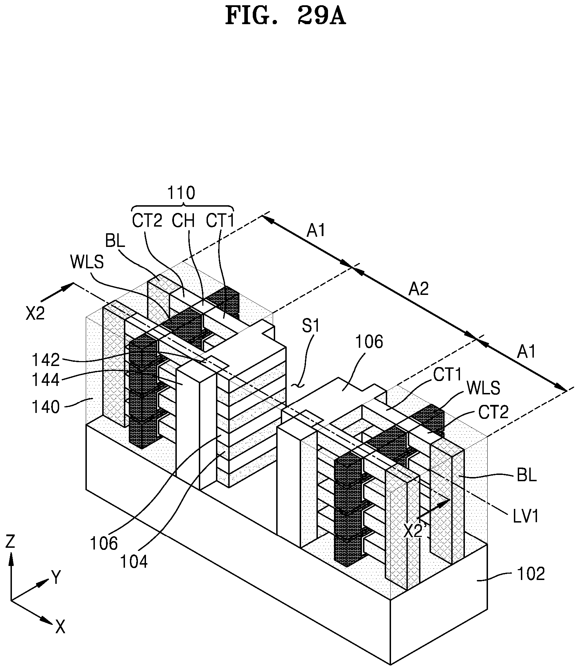

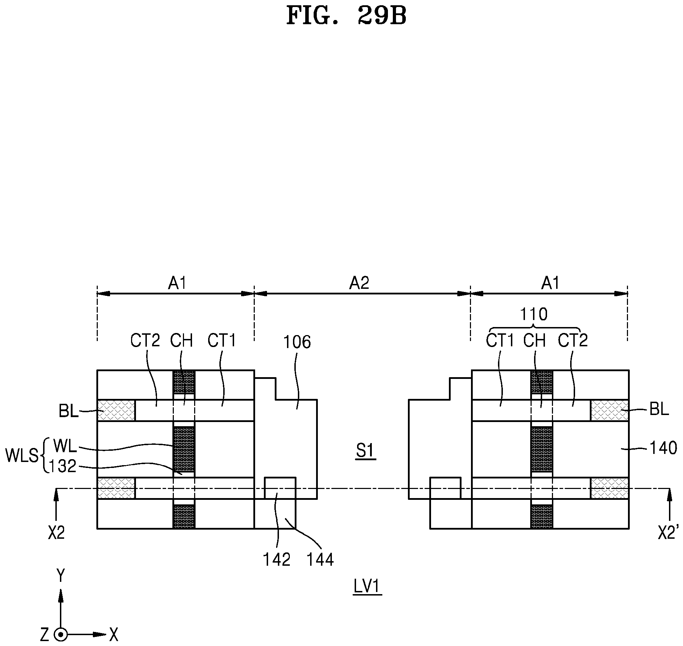

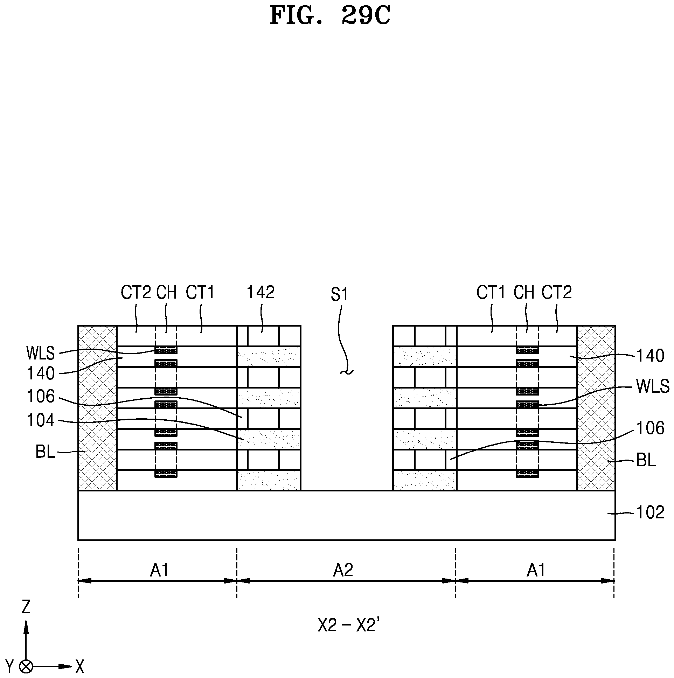

Referring to FIGS. 29A, 29B, and 29C, a portion of the stack structure of the plurality of sacrificial layers 104 and the plurality of semiconductor layers 106, which remain in the second area A2, may be removed from the resulting product of FIGS. 28A and 28B, thereby leaving only portions of the stack structure, which are adj acent to the first areas A1. As a result, the stack structure in the second area A2 may be separated into two stack structures with a separation space S1 therebetween.

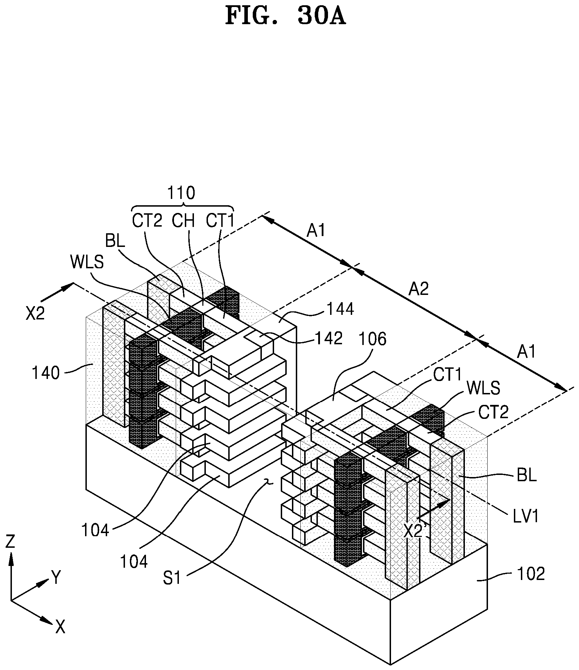

To help the understanding of processes described below with reference to FIGS. 30A to 37C, FIGS. 30A to 37C illustrate results of performing the processes described below while the resulting product of FIGS. 29A and 29B has been rotated by 180 degrees in the viewpoint of the X-Y plane.

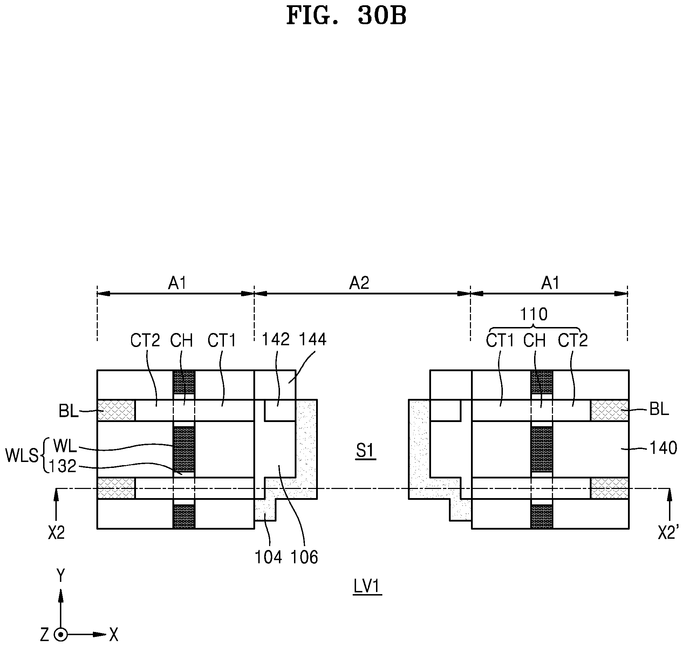

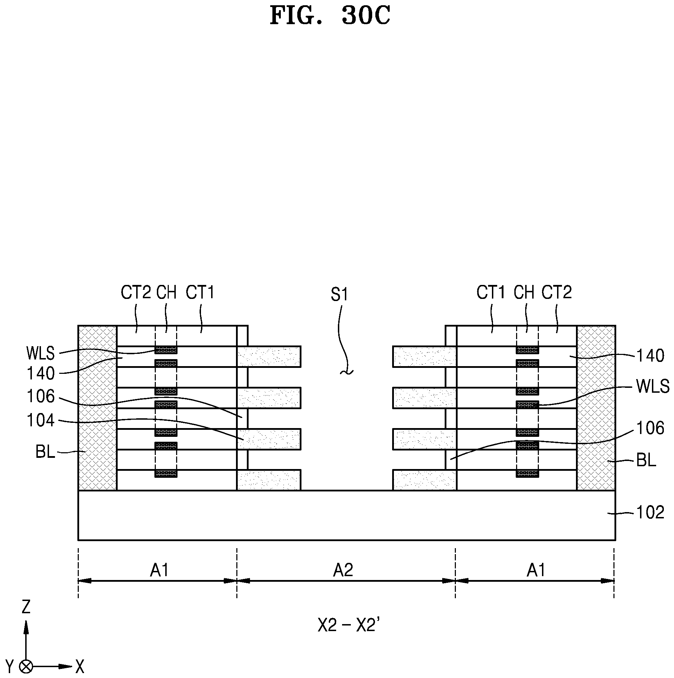

Referring to FIGS. 30A, 30B, and 30C, in the resulting product of FIGS. 29A, 29B, and 29C, a portion of each of the plurality of semiconductor layers 106 may be selectively wet-etched from the stack structures of the plurality of sacrificial layers 104 and the plurality of semiconductor layers 106, which remain in the second area A2, through the separation space S1, thereby reducing the planar size of each of the plurality of semiconductor layers 106. As a result, as shown in FIGS. 30A and 30B, a sacrificial layer 104 may be exposed around each of the plurality of semiconductor layers 106 in the second area A2.

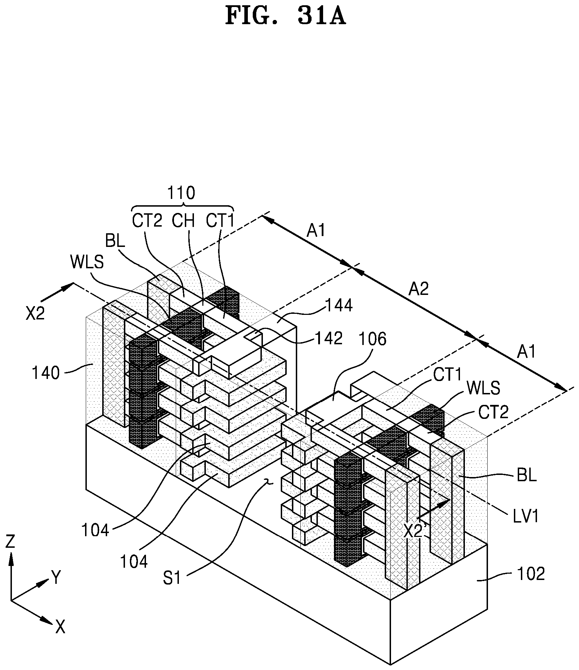

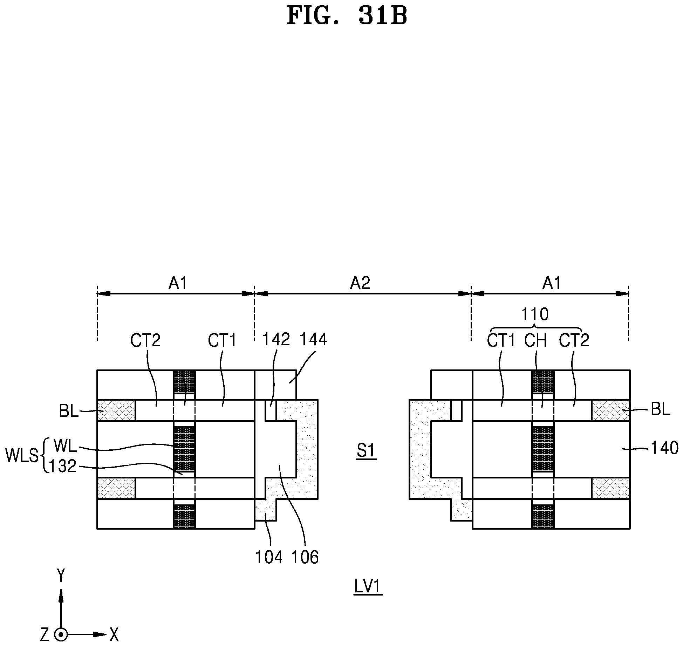

Referring to FIGS. 31A and 31B, a portion of each of the plurality of insulating blocks 142 may be selectively removed from the resulting product of FIGS. 30A, 30B, and 30C, thereby reducing the length of each of the plurality of insulating blocks 142 in the first horizontal direction (the X direction). In some embodiments, to selectively remove the portion of each of the plurality of insulating blocks 142, a wet-etching process may be used.

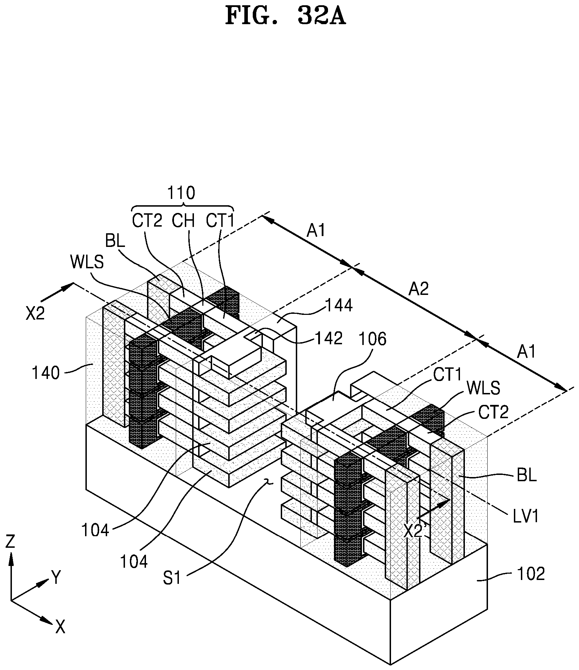

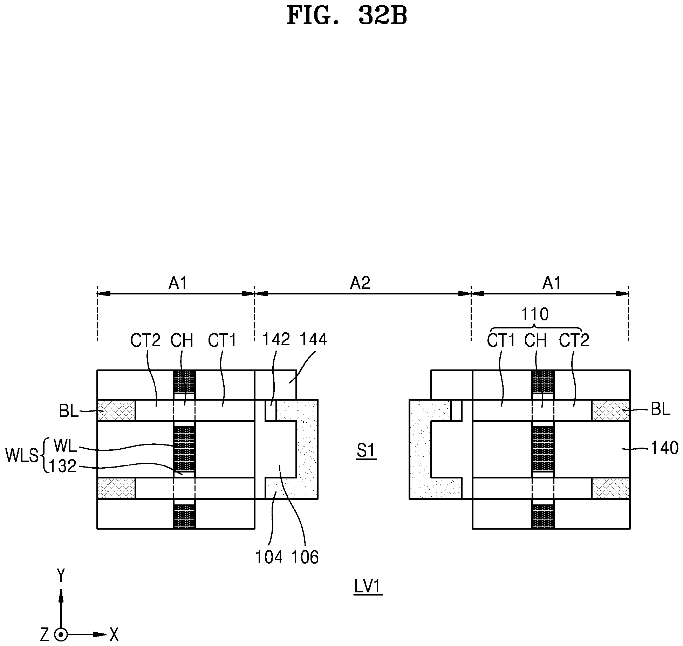

Referring to FIGS. 32A and 32B, a portion of each of the stack structures of the plurality of sacrificial layers 104 and the plurality of semiconductor layers 106 in the second area A2 may be selectively removed from the resulting product of FIGS. 31A and 31B. As a result, sidewalls, which faces the separation space S1, of a pair of second insulating patterns 140 respectively in the pair of first areas A1 may be exposed. In some embodiments, to selectively remove the portion of each of the stack structures of the plurality of sacrificial layers 104 and the plurality of semiconductor layers 106 in the second area A2, an anisotropic dry-etching process may be used.

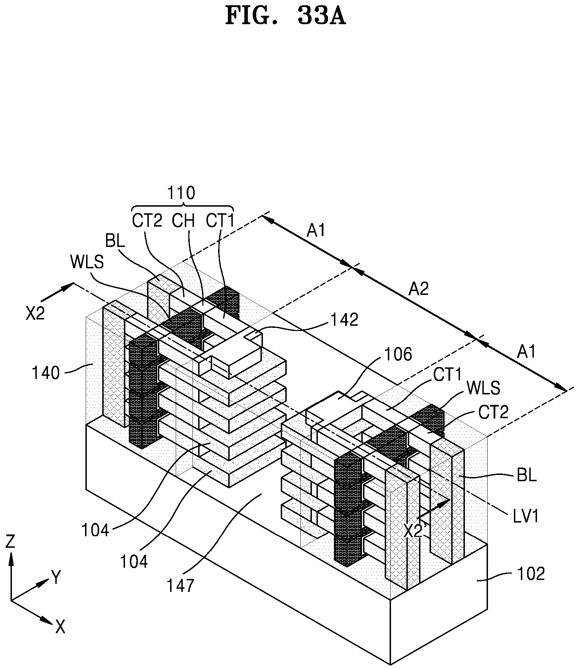

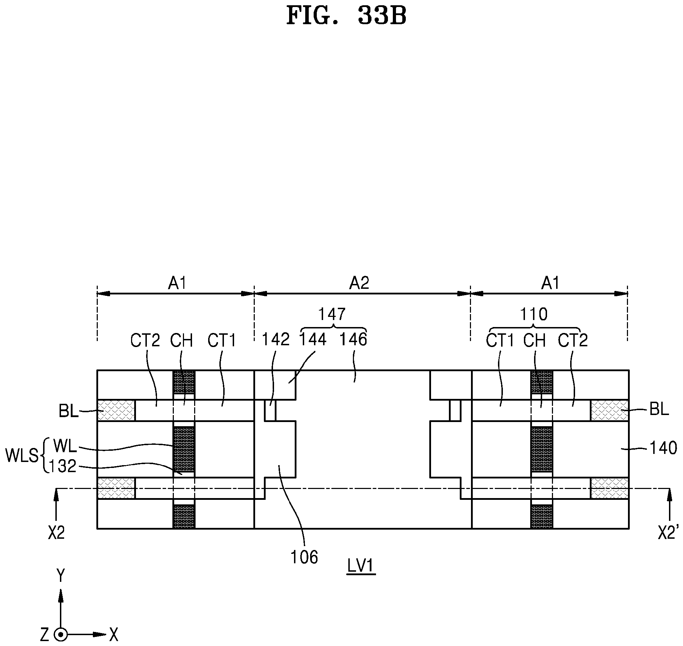

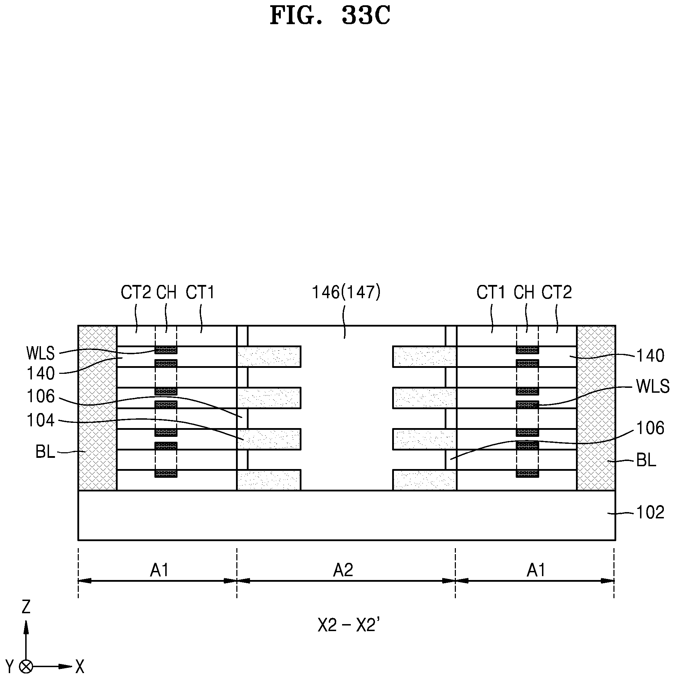

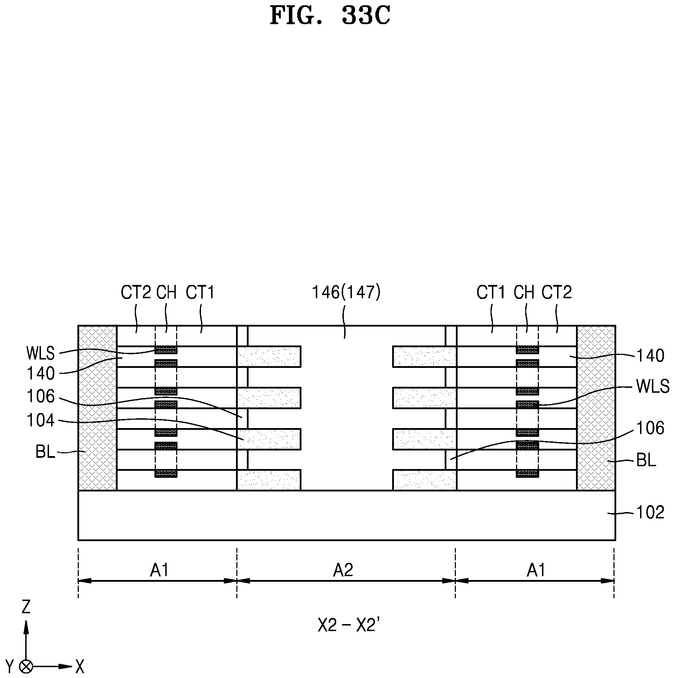

Referring to FIGS. 33A, 33B, and 33C, in the resulting product of FIGS. 32A and 32B, a fourth insulating pattern 146 may be formed to fill the separation space S1 in the second area A2. In some embodiments, the fourth insulating pattern 146 may include a silicon oxide film. In the second area A2, the plurality of third insulating patterns 144 and the fourth insulating pattern 146 may constitute an insulating structure 147 that fills a portion of the second area A2.

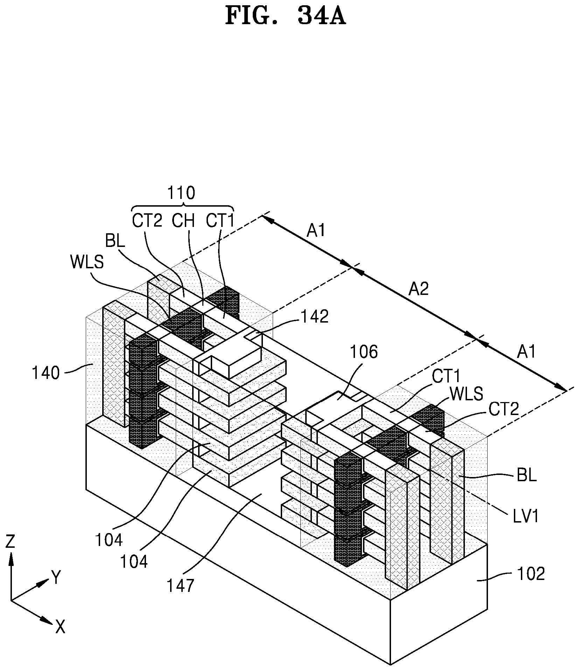

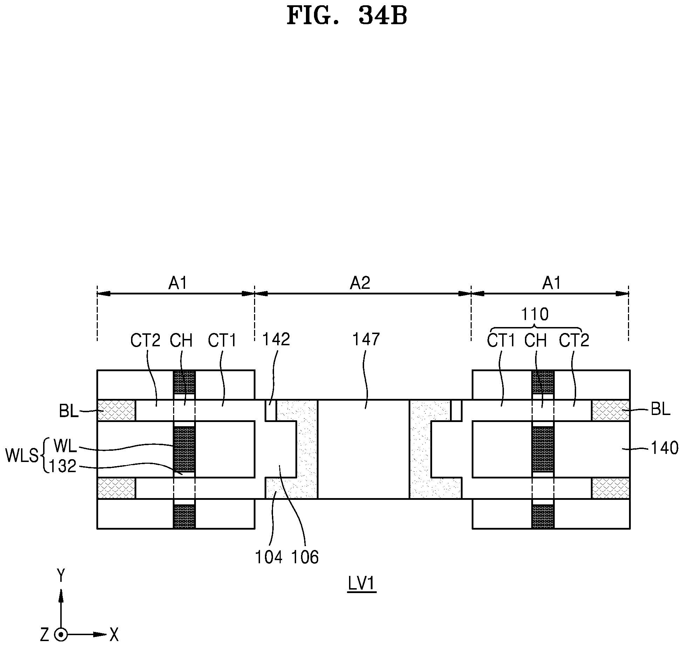

Referring to FIGS. 34A and 34B, in the resulting product of FIGS. 33A, 33B, and 33C, a portion of the insulating structure 147 may be etched, thereby leaving the insulating structure 147 only in a central portion of the second area A2 in terms of the second horizontal direction (the Y direction). The width of the insulating structure 147, which remains in the second area A2, in the second horizontal direction (the Y direction) may be equal or similar to the width of each of the plurality of semiconductor layers 106, which remain in the second area A2, in the second horizontal direction (the Y direction).

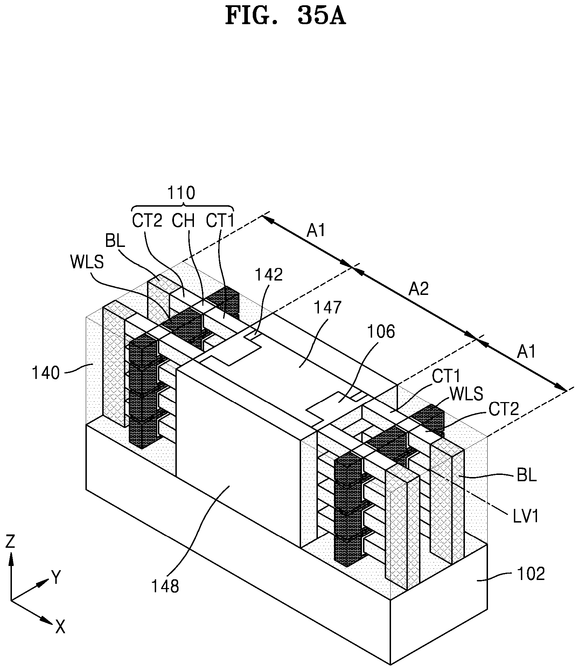

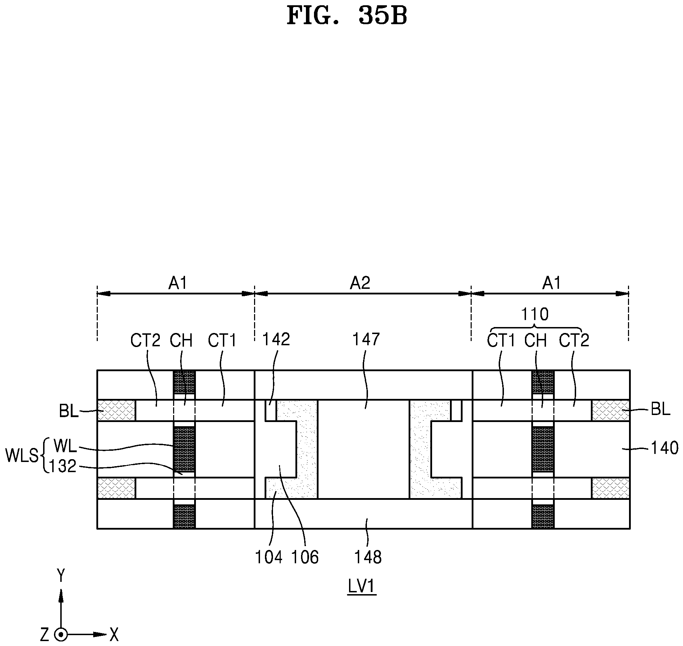

Referring to FIGS. 35A and 35B, in the resulting product of FIGS. 34A and 34B, a pair of blocking insulating patterns 148 may be formed to respectively cover both sidewalls of the insulating structure 147, which remains in the second area A2, and both sidewalls of the stack structures of the plurality of sacrificial layers 104 and the plurality of semiconductor layers 106 in terms of the second horizontal direction (the Y direction). In some embodiments, the pair of blocking insulating patterns 148 may each include a silicon nitride film.

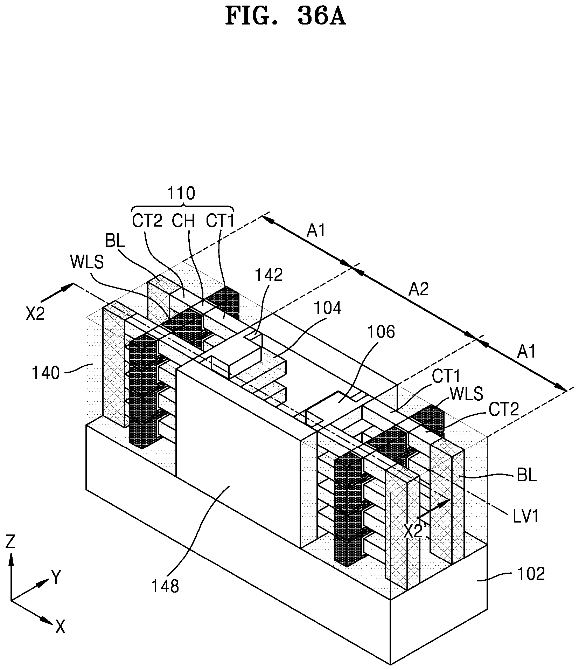

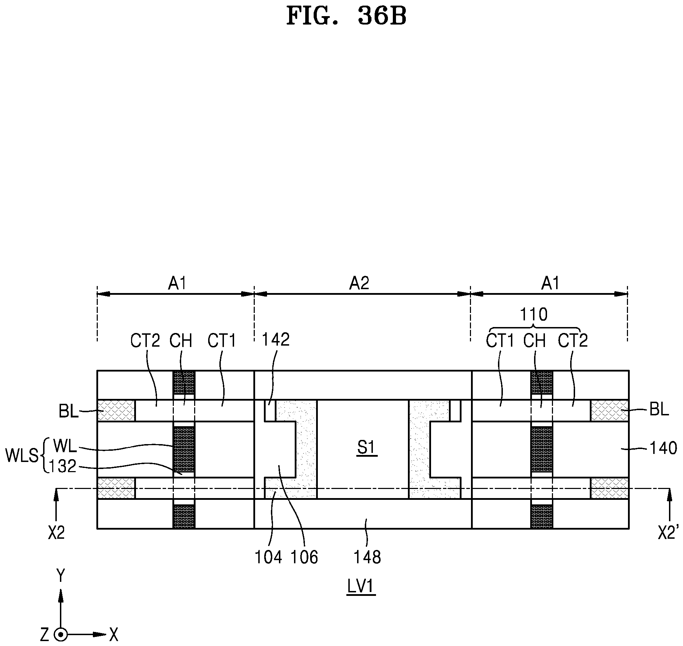

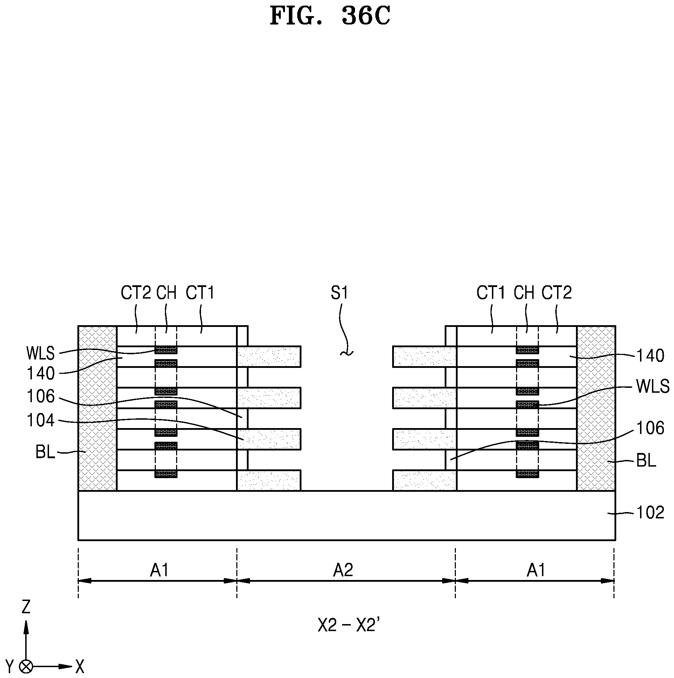

Referring to FIGS. 36A, 36B, and 36C, the insulating structure 147 remaining in the second area A2 may be selectively removed from the resulting product of FIGS. 35A and 35B. In some embodiments, to selectively remove the insulating structure 147, a wet-etching process may be used.

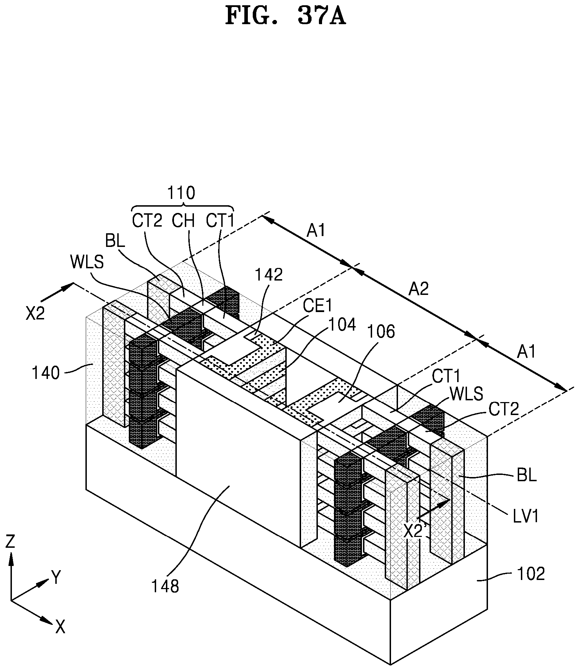

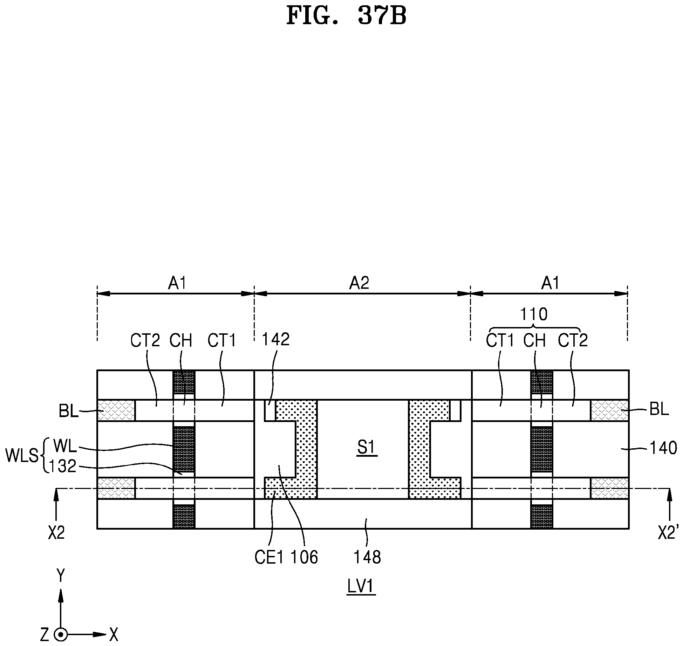

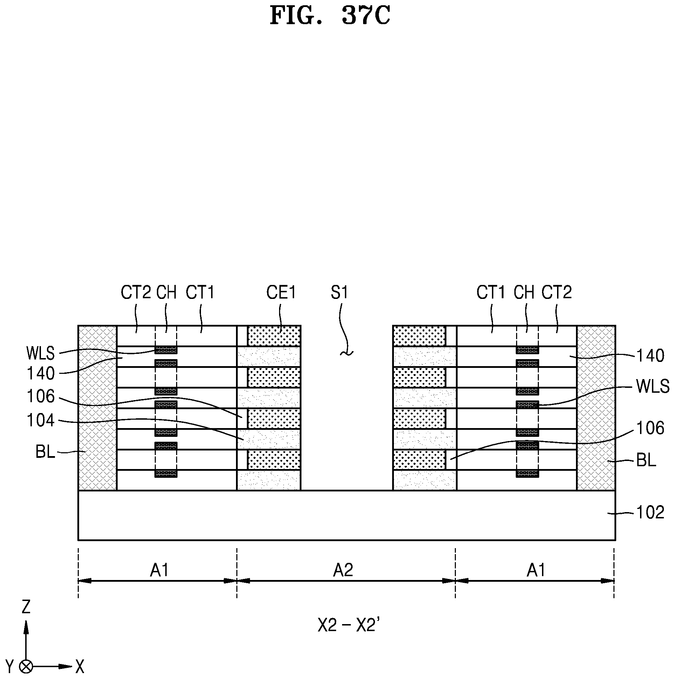

Referring to FIGS. 37A, 37B, and 37C, a plurality of inner electrodes CE1 may be formed to be arranged one-by-one around each of the plurality of semiconductor layers 106 remaining in the second area A2. To form the plurality of inner electrodes CE1, in the resulting product of FIGS. 36A, 36B, and 36C, a conductive layer may be formed to fill the separation space S1 of the second area A2. Next, a portion of the conductive layer may be removed, thereby forming the plurality of inner electrodes CE1 including remaining portions of the conductive layer.

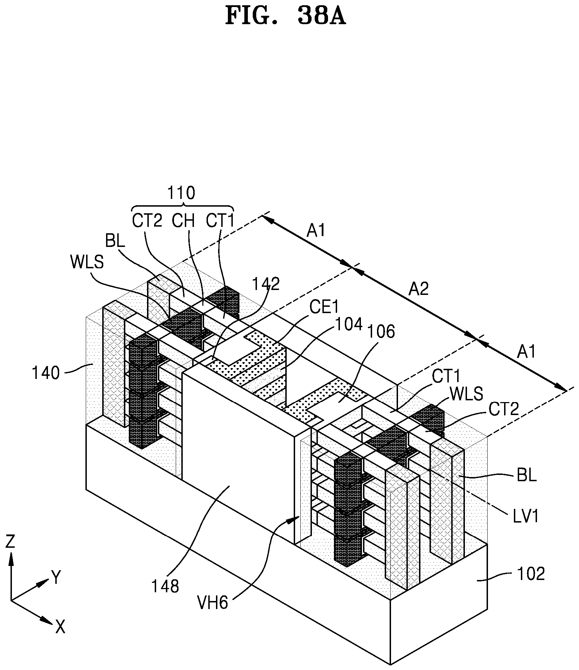

To help the understanding of processes described below with reference to FIGS. 38A to 44A, FIGS. 38A to 44A illustrate results of performing the processes described below while the resulting product of FIGS. 37A, 37B, and 37C has been rotated by 180 degrees in the viewpoint of the X-Y plane.

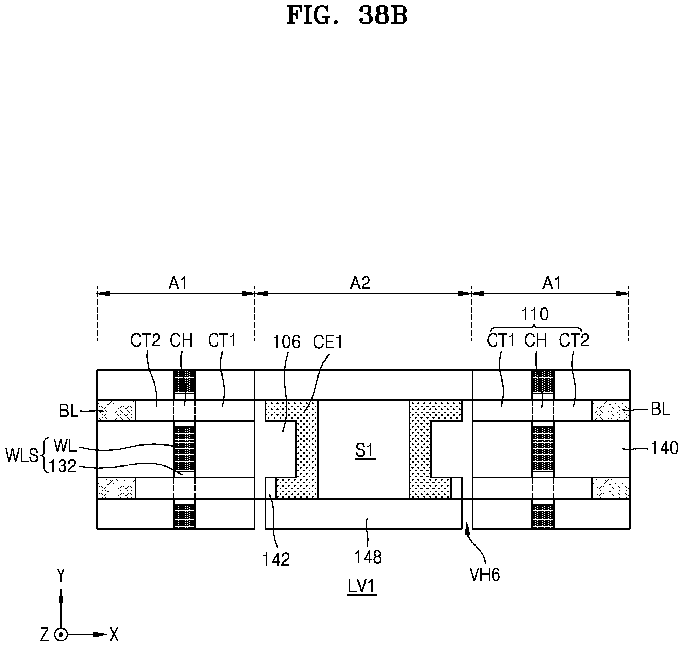

Referring to FIGS. 38A and 38B, both end portions of a blocking insulating pattern 148 adjacent to the insulating block 142, out of the pair of blocking insulating patterns 148 in the second area A2, may be removed, thereby forming a pair of sixth vertical holes VH6. Sidewalls of the stack structures of the plurality of sacrificial layers 104 and the plurality of semiconductor layers 106, which remain in the second area A2, may be exposed by the pair of sixth vertical holes VH6.

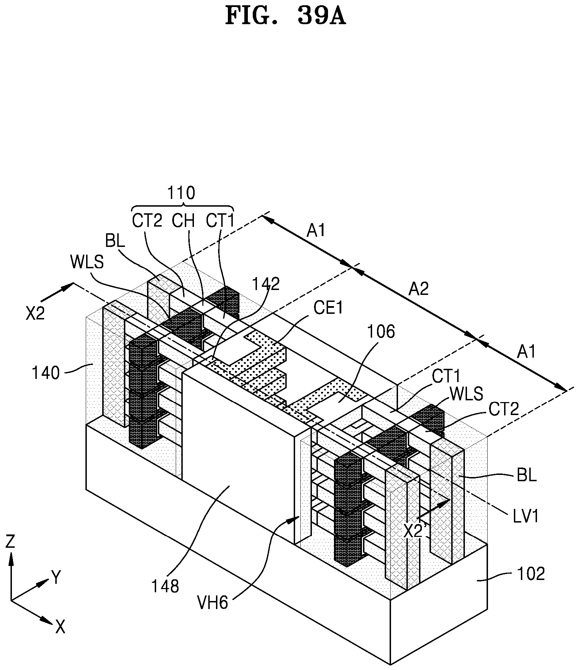

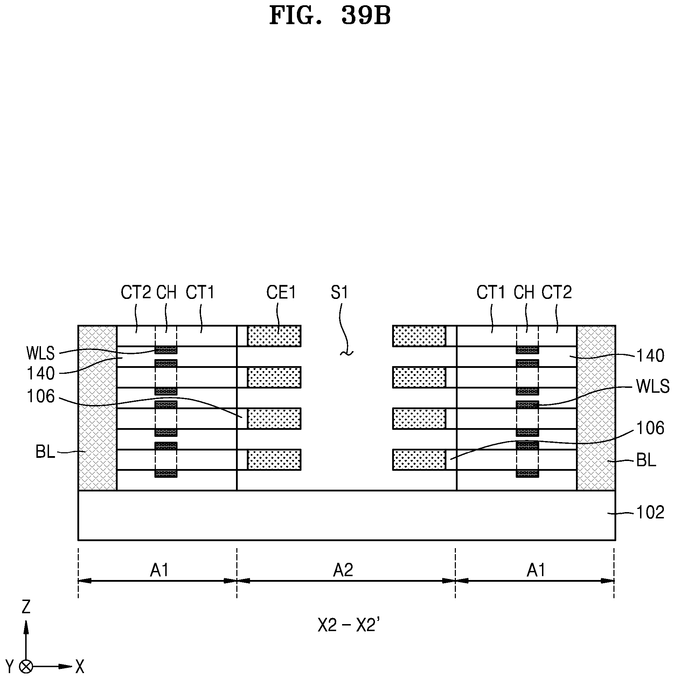

Referring to FIGS. 39A and 39B, at least portions of the plurality of sacrificial layers 104 remaining in the second area A2 may be removed through the pair of sixth vertical holes VH6 and the separation space S1 in a wet manner.

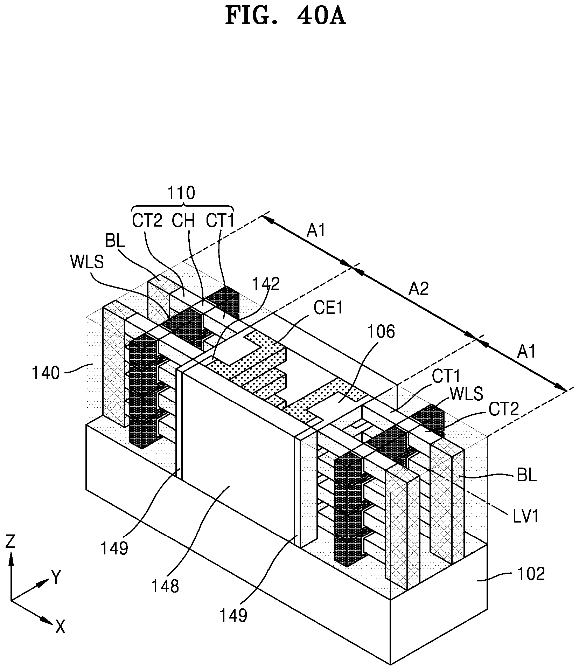

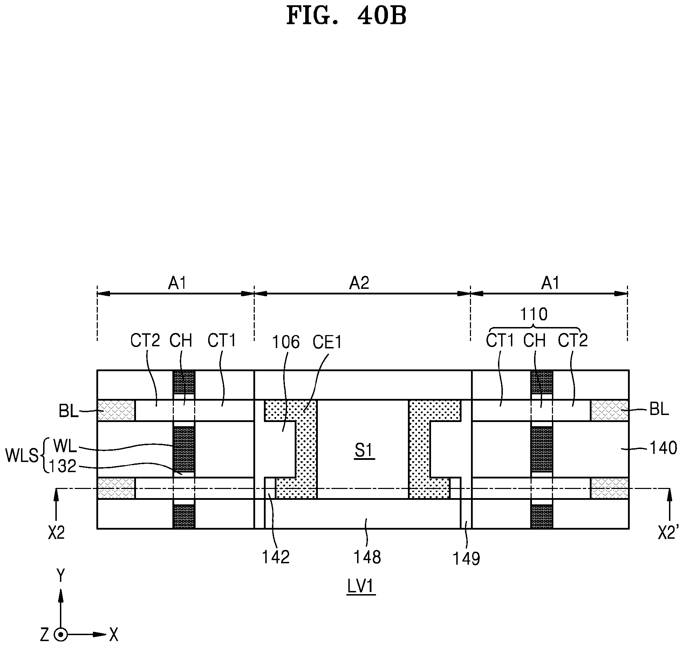

Referring to FIGS. 40A and 40B, in the resulting product of FIGS. 39A and 39B, a pair of fifth insulating patterns 149 may be formed to respectively fill the pair of sixth vertical holes VH6. In some embodiments, the pair of fifth insulating patterns 149 may each include a silicon oxide film.

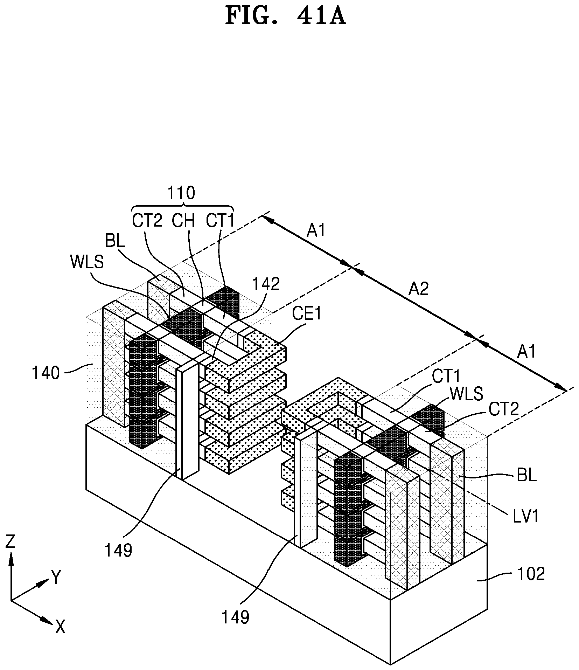

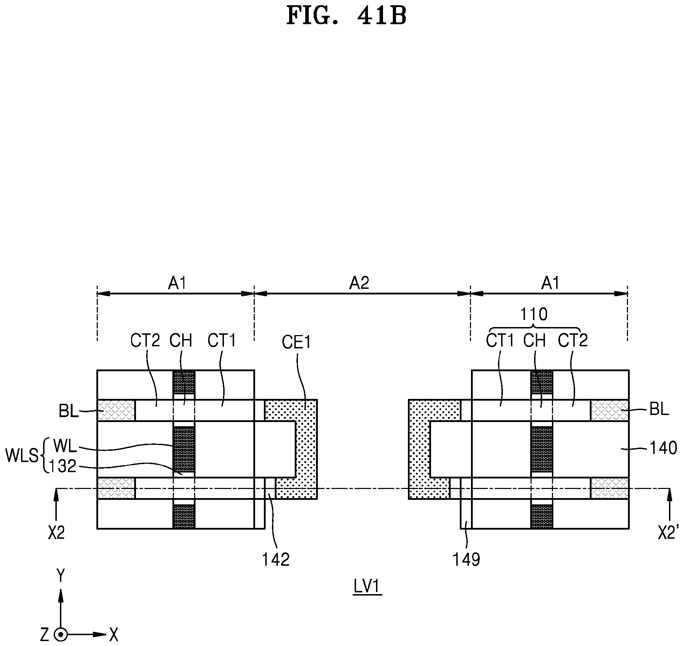

Referring to FIGS. 41A and 41B, the blocking insulating patterns 148 remaining in the resulting product of FIGS. 40A and 40B may be removed, and a portion of each of the plurality of semiconductor layers 106 remaining in the second area A2 may be removed, thereby leaving the plurality of semiconductor layers 106 only between the first contact region CT1 and the inner electrode CE1 and between the first contact region CT1 and the insulating block 142. Next, a selective wet-etching process may be further performed to completely remove the plurality of sacrificial layers 104, which may remain in the second area A2. Portions of the plurality of semiconductor layers 106, which remain between the first contact region CT1 and the inner electrode CE1 and between the first contact region CT1 and the insulating block 142, may each be connected to the first contact region CT1 and may each function as a portion of the first contact region CT1.

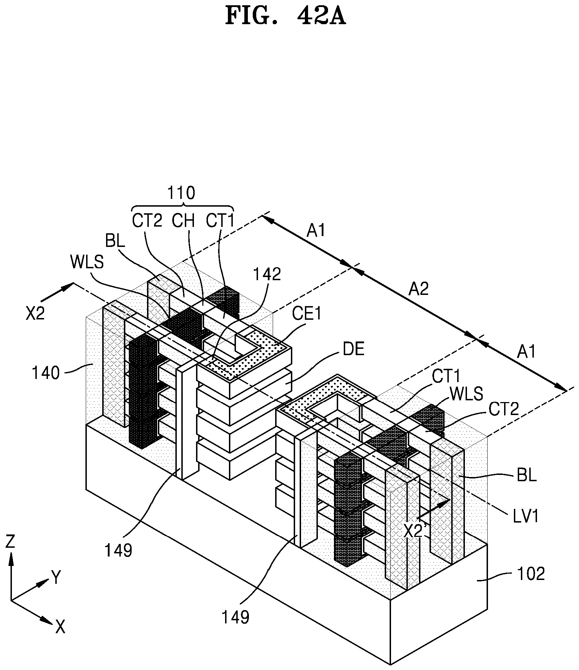

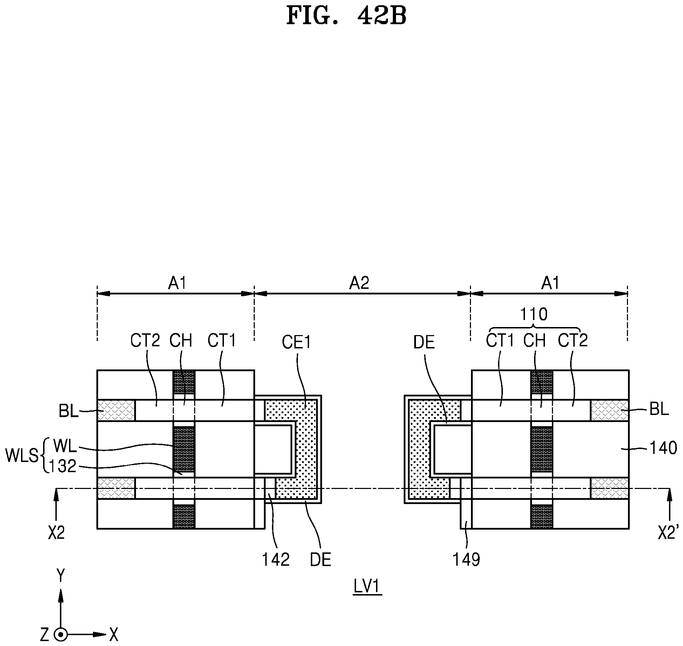

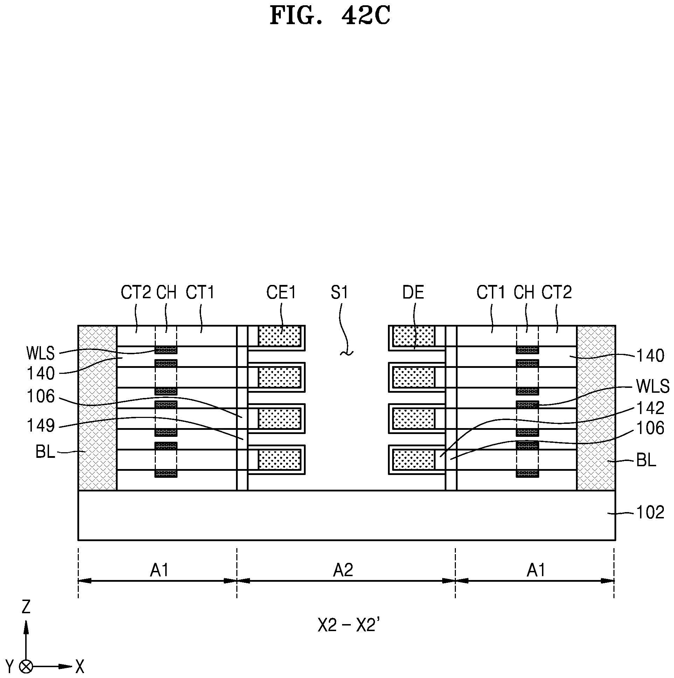

Referring to FIGS. 42A, 42B, and 42C, in the resulting product of FIGS. 41A and 41B, a dielectric film DE may be formed to cover a surface of the inner electrode CE1. Because semiconductor layers 106 contacting the insulating block 142, among the plurality of semiconductor layers 106 in the second area A2, each have a certain surface covered by the fifth insulating pattern 149, the dielectric film DE is not formed on the certain surface of each of the semiconductor layers 106, which is covered by the fifth insulating pattern 149, during the formation of the dielectric film DE.

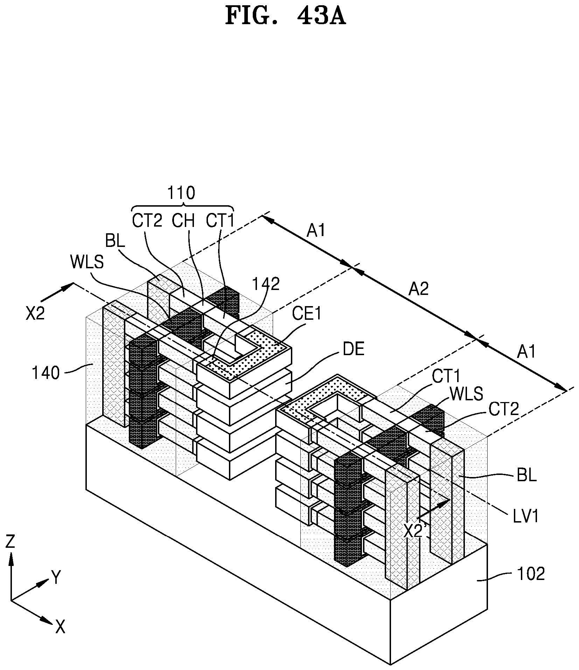

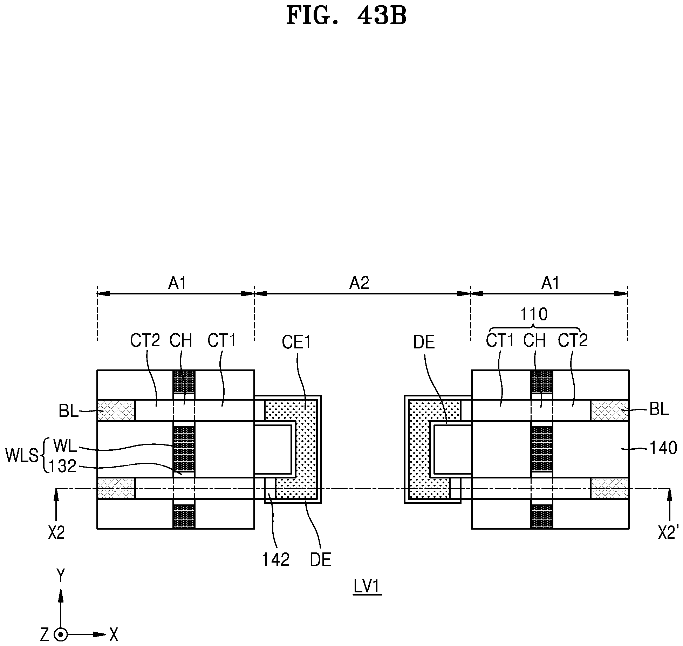

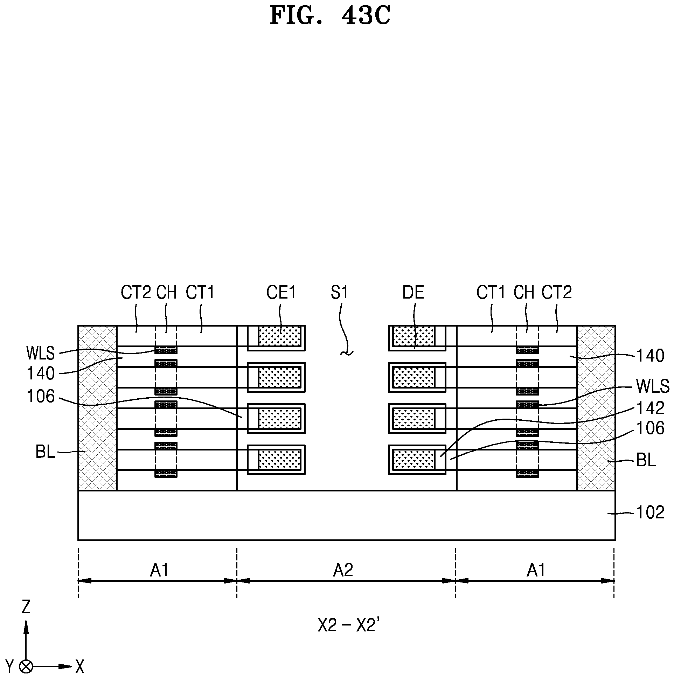

Referring to FIGS. 43A, 43B, and 43C, the plurality of fifth insulating patterns 149 may be removed from the resulting product of FIGS. 42A, 42B, and 42C, thereby exposing the certain surface of each of the semiconductor layers 106 contacting the insulating block 142.

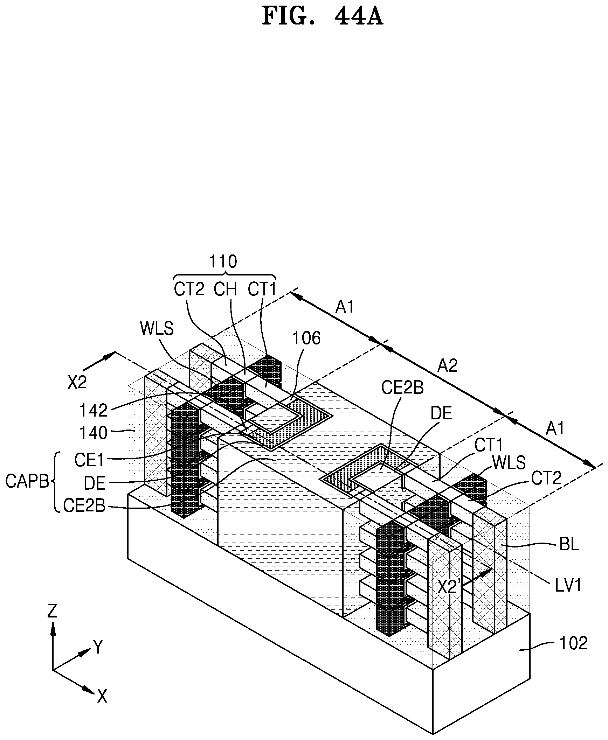

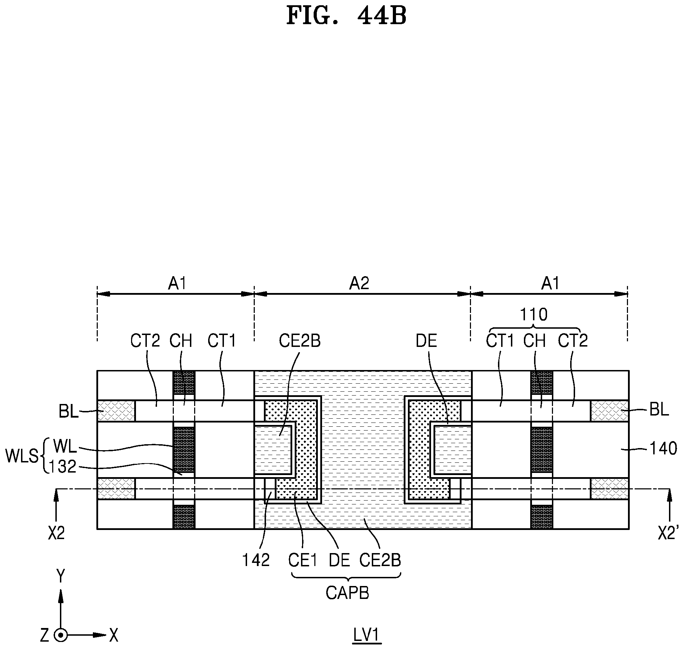

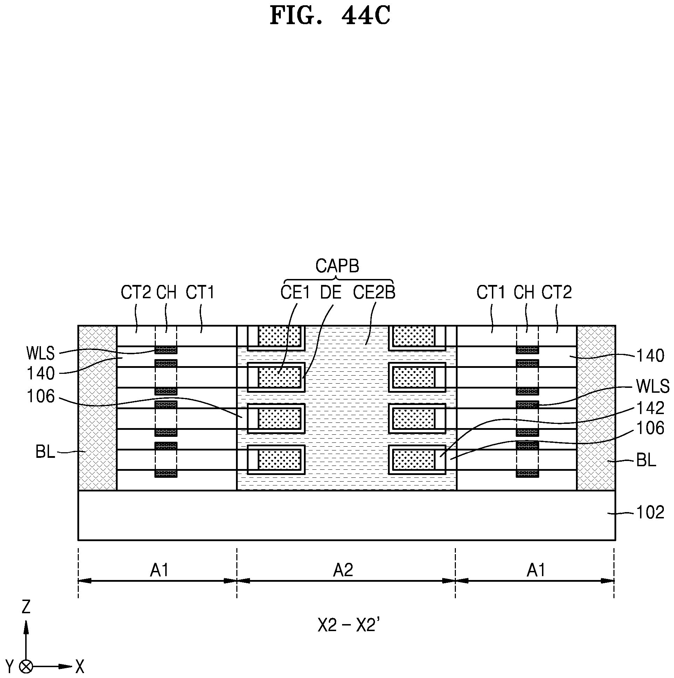

Referring to FIGS. 44A, 44B, and 44C, in the resulting product of FIGS. 43A, 43B, and 43C, an outer electrode CE2B may be formed to fill the remaining space of the second area A2, thereby forming a plurality of capacitors CAPB. In each of the plurality of capacitors CAPB, the outer electrode CE2B may be formed to contact the certain surface of each of the semiconductor layers 106 contacting the insulating block 142.

Heretofore, while the example of the method of fabricating the semiconductor memory device 100B shown in FIGS. 3A, 3B, and 3C has been described with reference to FIGS. 10A to 44C, it will be understood by those of ordinary skill in the art that, by making various modifications and changes to the example described with reference to FIGS. 10A to 44C, semiconductor memory devices having various structures changed and modified without departing from the scope of the inventive concept as defined by the following claims may be fabricated.

While the inventive concept has been particularly shown and described with reference to embodiments thereof, it will be understood that various changes in form and details may be made therein without departing from the scope of the following claims.

## Claims

1. A semiconductor memory device comprising a memory cell array (M1; M1A; M1B; M1C; M1D; M1E; M2A; M3) having a 3-dimensional structure and comprising a plurality of memory cells (MC1; MC1A; MC1B; MC1C; MC1D; MC1E; MC2; MC2A; MC3) that are repeatedly arranged on a main surface (102M) of a substrate (102) and in a horizontal direction (Y) parallel to the main surface (102M) of the substrate (102) and a vertical direction (Z) perpendicular to the main surface (102M) of the substrate (102),
wherein each of the plurality of memory cells (MC1; MC1A; MC1B; MC1C; MC1D; MC1E; MC2; MC2A; MC3) comprises:
a word line (WL; WLC; WLD1, WLD2) extending lengthwise in a first direction corresponding to one of the horizontal direction (Y) and the vertical direction (Z);
a first bit line (BL) and a second bit line (BL), which are parallel to each other and extend lengthwise in a second direction corresponding to the other one of the horizontal direction (Y) and the vertical direction (Z);
a first transistor (TR; TR1A; TR1C; TR1D; TR1E; TR3) and a second transistor (TR; TR1A; TR1C; TR1D; TR1E; TR3), which share the word line (WL; WLC; WLD1, WLD2); and
a capacitor (CAP; CAPB; CAP3) comprising an inner electrode (CE1; CE31) connected to the first transistor (TR; TR1A; TR1C; TR1D; TR1E; TR3), an outer electrode (CE2; CE2B; CE32) connected to the second transistor (TR; TR1A; TR1C; TR1D; TR1E; TR3), and a dielectric film (DE; DE3) between the inner electrode (CE1; CE31) and the outer electrode (CE2; CE2B; CE32), and
wherein each of the first transistor (TR; TR1A; TR1C; TR1D; TR1E; TR3) and the second transistor (TR; TR1A; TR1C; TR1D; TR1E; TR3) comprises an active region (110; 110A; 310), the active region (110; 110A; 310) including a channel region (CH) facing the word line (WL; WLC; WLD1, WLD2), a first contact region (CT1; CT31) extending from one side of the channel region (CH) toward the capacitor (CAP; CAPB; CAP3), and a second contact region (CT2; CT2A) connected from another side of the channel region (CH) to a corresponding one of the first bit line (BL) and the second bit line (BL).

2. The semiconductor memory device of claim 1, wherein each of the plurality of memory cells (MC1; MC1A; MC1B; MC1C; MC1D; MC1E; MC2; MC2A; MC3) comprises a U-shaped portion including the capacitor (CAP; CAPB; CAP3) and the active region (110; 110A; 310) of each of the first transistor (TR; TR1A; TR1C; TR1D; TR1E; TR3) and the second transistor (TR; TR1A; TR1C; TR1D; TR1E; TR3).

3. The semiconductor memory device of claim 1 or 2,
wherein the inner electrode (CE1; CE31) of the capacitor (CAP; CAPB; CAP3) is in contact with the first contact region (CT1; CT31) of the first transistor (TR; TR1A; TR1C; TR1D; TR1E; TR3) and is spaced apart from the first contact region (CT1; CT31) of the second transistor (TR; TR1A; TR1C; TR1D; TR1E; TR3), and
wherein the outer electrode (CE2; CE2B; CE32) of the capacitor (CAP; CAPB; CAP3) is spaced apart from the first contact region (CT1; CT31) of the first transistor (TR; TR1A; TR1C; TR1D; TR1E; TR3) and is in contact with the first contact region (CT1; CT31) of the second transistor (TR; TR1A; TR1C; TR1D; TR1E;TR3).

4. The semiconductor memory device of any one of claims 1 to 3, wherein at least some of the inner electrode (CE1; CE31), the outer electrode (CE2; CE2B; CE32), and the dielectric film (DE; DE3) of the capacitor (CAP; CAPB; CAP3) have a U-like or a ⊂-like planar shape.

5. The semiconductor memory device of any one of claims 1 to 4, wherein the inner electrode (CE31) of the capacitor (CAP3) has a straight planar shape extending lengthwise in the horizontal direction (Y).

6. The semiconductor memory device of any one of claims 1 to 5, wherein the channel region (CH) of each of the first transistor (TR; TR1A; TR1E; TR3) and the second transistor (TR; TR1A; TR1E; TR3) passes through the word line (WL) such that the channel region (CH) is surrounded by the word line (WL).

7. The semiconductor memory device of any one of claims 1 to 5, wherein the word line (WLC) covers one surface of the channel region (CH) of each of the first transistor (TR1C) and the second transistor (TR1C) and overlaps the one surface of the channel region (CH) of each of the first transistor (TR1C) and the second transistor (TR1C) in the vertical direction (Z) or the horizontal direction (Y).

8. The semiconductor memory device of any one of claims 1 to 5, wherein the word line (WLD1, WLD2) comprises:
a first word line (WLD1) covering one surface of the channel region (CH) of each of the first transistor (TR1D) and the second transistor (TR1D); and
a second word line (WLD2) covering another surface of the channel region (CH) of each of the first transistor (TR1D) and the second transistor (TR1D),
wherein the first word line (WLD1) and the second word line (WLD2) are spaced apart from each other in the vertical direction (Z) or the horizontal direction (Y) with the channel region (CH) of each of the first transistor (TR1D) and the second transistor (TR1D) therebetween, and
wherein each of the first word line (WLD1) and the second word line (WLD2) overlaps the channel region (CH) of each of the first transistor (TR1D) and the second transistor (TR1D) in the vertical direction (Z) or the horizontal direction (Y).

9. The semiconductor memory device of any one of claims 1 to 8, further comprising:
an insulating block (142; 342) between the inner electrode (CE1; CE31) of the capacitor (CAP; CAPB; CAP3) and the first contact region (CT1; CT31) of the second transistor (TR; TR1A; TR1C; TR1D; TR1E; TR3),
wherein the outer electrode (CE2; CE2B; CE32) of the capacitor (CAP; CAPB; CAP3) surrounds the insulating block (142; 342).

10. The semiconductor memory device of any one of claims 1 to 9, further comprising a peripheral circuit structure (PCS; PCS4) overlapping the memory cell array (M1; M1A; M1B; M1C; M1D; M1E; M2A; M3) in the vertical direction (Z).

11. The semiconductor memory device of any one of claims 1 to 10, wherein each of the first bit line (BL) and the second bit line (BL) is in contact with an end portion of the second contact region (CT2A) of one transistor selected from the first transistor (TR; TR1A; TR1C; TR1D; TR1E; TR3) and the second transistor (TR; TR1A; TR1C; TR1D; TR1E; TR3).

12. The semiconductor memory device of any one of claims 1 to 11, wherein each of the first bit line (BL) and the second bit line (BL) passes through the second contact region (CT2A) of one transistor selected from the first transistor (TR1A) and the second transistor (TR1A) such that each of the first bit line (BL) and the second bit line (BL) is surrounded by the second contact region (CT2A) of the one transistor.

13. A semiconductor memory device comprising a memory cell array (M1; M1A; M1B; M1C; M1D; M1E; M2A; M3) having a 3-dimensional structure and comprising a plurality of memory cells (MC1; MC1A; MC1B; MC1C; MC1D; MC1E; MC2; MC2A; MC3) that are repeatedly arranged on a main surface (102M) of a substrate (102) and in a horizontal direction (Y) parallel to the main surface (102M) of the substrate (102) and a vertical direction (Z) perpendicular to the main surface (102M) of the substrate (102),
wherein the memory cell array (M1; M1A; M1B; M1C; M1D; M1E; M2A; M3) comprises:
a plurality of word lines (WL; WLC; WLD1, WLD2) parallel to each other and extending lengthwise in a first direction corresponding to one of the horizontal direction (Y) and the vertical direction (Z);
a plurality of bit lines (BL) parallel to each other and extending lengthwise in a second direction corresponding to the other one of the horizontal direction (Y) and the vertical direction (Z);
a plurality of capacitors (CAP; CAPB; CAP3) apart from the plurality of bit lines (BL) with the plurality of word lines (WL; WLC; WLD1, WLD2) therebetween; and
a plurality of active regions (110; 110A; 310) each comprising a channel region (CH), a first contact region (CT1; CT31), and a second contact region (CT2; CT2A), the channel region (CH) facing a word line selected from the plurality of word lines (WL; WLC; WLD1, WLD2), the first contact region (CT1; CT31) being connected between the channel region (CH) and a capacitor selected from the plurality of capacitors (CAP; CAPB; CAP3), and the second contact region (CT2; CT2A) being connected between the channel region (CH) and a bit line selected from the plurality of bit lines (BL),
wherein each of the plurality of memory cells (MC1; MC1A; MC1B; MC1C; MC1D; MC1E; MC2; MC2A; MC3) comprises two bit lines selected from the plurality of bit lines (BL), a word line selected from the plurality of word lines (WL; WLC; WLD1, WLD2), two active regions selected from the plurality of active regions (110; 110A; 310), and a capacitor (CAP; CAPB; CAP3) selected from the plurality of capacitors (CAP; CAPB; CAP3), and
wherein the capacitor (CAP; CAPB; CAP3) of each of the plurality of memory cells (MC1; MC1A; MC1B; MC1C; MC1D; MC1E; MC2; MC2A; MC3) comprises an inner electrode (CE1; CE31) connected to a first active region selected from the two active regions (110; 110A; 310), an outer electrode (CE2; CE2B; CE32) connected to a second active region (110; 110A; 310) selected from the two active regions (110; 110A; 310), and a dielectric film (DE; DE3) between the inner electrode (CE1; CE31) and the outer electrode (CE2; CE2B; CE32).

14. The semiconductor memory device of any one of claims 1 to 13,
wherein the first direction is the horizontal direction (Y), and
wherein each of the plurality of memory cells (MC1; MC1A; MC1B; MC1C; MC1D; MC1E; MC3) comprises, when viewed in a plane parallel to the main surface (102M) of the substrate (102), a U-shaped portion including the capacitor (CAP; CAPB; CAP3) and the two active regions (110; 110A; 310) of the each of the plurality of memory cells (MC1; MC1A; MC1B; MC1C; MC1D; MC1E; MC3).

15. The semiconductor memory device of any one of claims 1 to 13,
wherein the first direction is the vertical direction (Z), and
wherein each of the plurality of memory cells (MC2; MC2A) comprises, when viewed in a plane perpendicular to the main surface (102M) of the substrate (102), a U-shaped portion including the capacitor (CAP) and the two active regions (110; 110A) of the each of the plurality of memory cells (MC2; MC2A).
